(19) Europäisches Patentamt
European Patent Office
Office européen des brevets

(11) **EP 4 518 320 A1**

(12) **EUROPEAN PATENT APPLICATION**
published in accordance with Art. 153(4) EPC

(43) Date of publication:
05.03.2025 Bulletin 2025/10

(21) Application number: 23796743.5

(22) Date of filing: 24.04.2023

(51) International Patent Classification (IPC):
*H04N 19/597* (2014.01)  *H04N 19/70* (2014.01)
*H04N 19/96* (2014.01)  *H04N 19/20* (2014.01)
*G06T 9/40* (2006.01)

(52) Cooperative Patent Classification (CPC):
G06T 9/40; H04N 19/20; H04N 19/597;
H04N 19/70; H04N 19/96

(86) International application number:
PCT/KR2023/005561

(87) International publication number:
WO 2023/211097 (02.11.2023 Gazette 2023/44)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 24.04.2022  US 202263334179 P

(71) Applicant: **LG Electronics Inc.**
**Yeongdeungpo-gu**
**Seoul 07336 (KR)**

(72) Inventor: **HUR, Hyejung**
**Seoul 06772 (KR)**

(74) Representative: **Mooser, Sebastian Thomas**
**Wuesthoff & Wuesthoff**
**Patentanwälte und Rechtsanwalt PartG mbB**
**Schweigerstraße 2**
**81541 München (DE)**

(54) **POINT CLOUD DATA TRANSMISSION DEVICE, POINT CLOUD DATA TRANSMISSION METHOD, POINT CLOUD DATA RECEPTION DEVICE, AND POINT CLOUD DATA RECEPTION METHOD**

(57)    Disclosed according to embodiments are a point cloud data transmission method, a point cloud data transmission device, a point cloud data reception method, and a point cloud data reception device. The point cloud data transmission method according to embodiments may comprise the steps of: acquiring point cloud data including points through LiDAR equipment provided with laser sensors; encoding the point cloud data; and transmitting signaling data and the encoded point cloud data.

FIG. 13

**Description**

[Technical Field]

Embodiments relate to a method and device for processing point cloud content.

[Background Art]

Point cloud content is content represented by a point cloud, which is a set of points belonging to a coordinate system representing a three-dimensional space (or volume). The point cloud content may express media configured in three dimensions, and is used to provide various services such as virtual reality (VR), augmented reality (AR), mixed reality (MR), XR (Extended Reality), and self-driving services. However, tens of thousands to hundreds of thousands of point data are required to represent point cloud content. Therefore, there is a need for a method for efficiently processing a large amount of point data.

[Disclosure]

[Technical Problem]

An object of the present disclosure devised to solve the above-described problems is to provide a point cloud data transmission device, a point cloud data transmission method, a point cloud data reception device, and a point cloud data reception method for efficiently transmitting and receiving a point cloud.

Another object of the present disclosure is to provide a point cloud data transmission device, a point cloud data transmission method, a point cloud data reception device, and a point cloud data reception method for addressing latency and encoding/decoding complexity.

Another object of the present disclosure is to provide a point cloud data transmission device, a point cloud data transmission method, a point cloud data reception device, and a point cloud data reception method for improving the compression performance of the point cloud by improving the technique of encoding attribute information of geometry-based point cloud compression (G-PCC).

Another object of the present disclosure is to provide a point cloud data transmission device, a point cloud data transmission method, a point cloud data reception device, and a point cloud data reception method for efficiently compressing and transmitting point cloud data captured by LiDAR equipment and receiving the same.

Another object of the present disclosure is to provide a point cloud data transmission device, a point cloud data transmission method, a point cloud data reception device, and a point cloud data reception method for efficient compression of point cloud data captured by LiDAR equipment.

Another object of the present disclosure is to provide a point cloud data transmission device, a point cloud data transmission method, a point cloud data reception device, and a point cloud data reception method for classifying point cloud data into roads and objects for efficient compression of point cloud data captured by LiDAR equipment.

Another object of the present disclosure is to provide a point cloud data transmission device, a point cloud data transmission method, a point cloud data reception device, and a point cloud data reception method for classifying point cloud data into roads and objects and applying the classification to a predictive tree for efficient compression of point cloud data captured by LiDAR equipment.

Embodiments are not limited to the above-described objects, and the scope of the embodiments may be extended to other objects that can be inferred by those skilled in the art based on the entire contents of the present disclosure.

[Technical Solution]

To achieve these objects and other advantages and in accordance with the purpose of the disclosure, as embodied and broadly described herein, a method of transmitting point cloud data according to embodiments may include acquiring point cloud data containing points by LiDAR equipment having laser sensors, encoding the point cloud data, and transmitting the encoded point cloud data and signaling data.

According to embodiments, the encoding may include separating the points in the point cloud data into a road and an object, constructing a first predictive tree based on the points separated as the road and a second predictive tree based on the points separated as the object, and compressing the point cloud data based on prediction by applying the first predictive tree and the second predictive tree,

According to embodiments, the signaling data may include information related to separation of the road and the object.

According to embodiments, the separating the points into the road and the object may include separating the points in the point cloud data into the road and the object based on a base height corresponding to a distance from the road to a center of the laser sensors.

According to embodiments, the base height may be estimated based on angle information, radius information, and height information related to a laser sensor having a greatest negative angle among the laser sensors.

According to embodiments, the separating the points into the road and the object may include separating points present at a position equal to the base height or lower than the base height among the points in the point cloud data as the road, and separating points present at a position higher than the base height among the points in the point cloud data as the object.

According to embodiments, the separating the points into the road and the object may include removing points present within a minimum radius among points acquired by a current laser sensor, wherein the separating may be performed after the removing.

According to embodiments, the compressing may include compressing the point cloud data based on intra-prediction by applying the first predictive tree and the second predictive tree.

According to embodiments, the compressing may include compressing the point cloud data based on inter-prediction by applying the first predictive tree, the second predictive tree, and at least one reference frame.

According to embodiments, the compression may include, based on a current point in a current frame belonging to the road, selecting, as a reference point, a point having a same laser ID and similar azimuth as the current point from among points in a region separated as the road in the at least one reference frame and setting the reference point as a predicted value of the current point, and based on the current point in the current frame belonging to the object, selecting, as a reference point, a point having the same laser ID and similar azimuth as the current point from among points in a region separated as the object in the at least one reference frame and setting the reference point as a predicted value of the current point.

According to embodiments, a device for transmitting point cloud data may include an acquirer configured to acquire point cloud data containing points by LiDAR equipment having laser sensors, an encoder configured to encode the point cloud data, and a transmitter configured to transmit the encoded point cloud data and signaling data.

According to embodiments, the encoder may be configured to separate the points in the point cloud data into a road and an object, construct a first predictive tree based on the points separated as the road and a second predictive tree based on the points separated as the object, and compress the point cloud data based on prediction by applying the first predictive tree and the second predictive tree.

According to embodiments, the signaling data may include information related to separation of the road and the object.

According to embodiments, the encoder may separate the points in the point cloud data into the road and the object based on a base height corresponding to a distance from the road to a center of the laser sensors.

According to embodiments, the base height may be estimated based on angle information, radius information, and height information related to a laser sensor having a greatest negative angle among the laser sensors.

According to embodiments, the encoder may separate points present at a position equal to the base height or lower than the base height among the points in the point cloud data as the road, and separate points present at a position higher than the base height among the points in the point cloud data as the object.

According to embodiments, the encoder may separate the points into the road and the object after removing points present within a minimum radius among points acquired by a current laser sensor.

According to embodiments, the encoder may compress the point cloud data based on intra-prediction by applying the first predictive tree and the second predictive tree.

According to embodiments, the encoder may compress the point cloud data based on inter-prediction by applying the first predictive tree, the second predictive tree, and at least one reference frame.

According to embodiments, the encoder may be configured to, based on a current point in a current frame belonging to the road, select, as a reference point, a point having a same laser ID and similar azimuth as the current point from among points in a region separated as the road in the at least one reference frame and set the reference point as a predicted value of the current point, and to, based on the current point in the current frame belonging to the object, select, as a reference point, a point having the same laser ID and similar azimuth as the current point from among points in a region separated as the object in the at least one reference frame and set the reference point as a predicted value of the current point.

[Advantageous Effects]

The point cloud data transmission method, the point cloud data transmission device, the point cloud data reception method, and the reception device according to embodiments may provide a quality point cloud service.

The point cloud data transmission method, point cloud data transmission device, point cloud data reception method, and point cloud data reception device according to embodiments may achieve various video codec methods.

The point cloud data transmission method, point cloud data transmission device, point cloud data reception method, and point cloud data reception device according to embodiments may provide universal point cloud content such as an autonomous driving service.

The point cloud data transmission method, point cloud data transmission device, point cloud data reception method, and point cloud data reception device according to embodiments may perform space-adaptive partition of point cloud data for independent encoding and decoding of the point cloud data, thereby improving parallel processing and providing scalability.

The point cloud data transmission method, point cloud data transmission device, point cloud data reception method, and point cloud data reception device according to embodiments may perform encoding and decoding by partitioning the point cloud data in units of tiles and/or slices, and signal necessary data therefor, thereby improving encoding and decoding performance of the point cloud.

The point cloud data transmission method, point cloud data transmission device, point cloud data reception method, and point cloud data reception device according to embodiments may support efficient geometry compression of point cloud content captured by LiDAR equipment on a moving vehicle by estimating (or predicting) a base height value, which is a distance from a road to a center of laser sensors, classifying points in the point cloud data into a road or an object, respectively, based on the estimated (or predicted) height value, constructing a predictive tree for the road and object parts distinguished from each other, and performing compression.

[Description of Drawings]

The accompanying drawings, which are included to provide a further understanding of the disclosure and are incorporated in and constitute a part of this application, illustrate embodiment(s) of the disclosure and together with the description serve to explain the principle of the disclosure. In the drawings:

FIG. 1 shows an exemplary point cloud content providing system according to embodiments;
FIG. 2 is a block diagram illustrating a point cloud content providing operation according to embodiments;
FIG. 3 illustrates an exemplary point cloud encoder according to embodiments;
FIG. 4 shows an example of an octree and occupancy code according to embodiments;
FIG. 5 illustrates an example of point configuration in each LOD according to embodiments;
FIG. 6 illustrates an example of point configuration in each LOD according to embodiments;
FIG. 7 illustrates a point cloud decoder according to embodiments;
FIG. 8 illustrates an exemplary transmission device according to embodiments;
FIG. 9 illustrates an exemplary reception device according to embodiments;
FIG. 10 illustrates an exemplary structure operable in connection with point cloud data transmission/reception methods/devices according to embodiments;
FIG. 11 is a diagram illustrating an example of point cloud data acquired using LiDAR equipment according to embodiments;
FIG. 12 is a diagram illustrating an example of points constituting a road captured by LiDAR equipment according to embodiments;
FIG. 13-(a) is a diagram illustrating an exemplary predictive tree when there are no objects in the point cloud data acquired using multiple lasers according to embodiments;

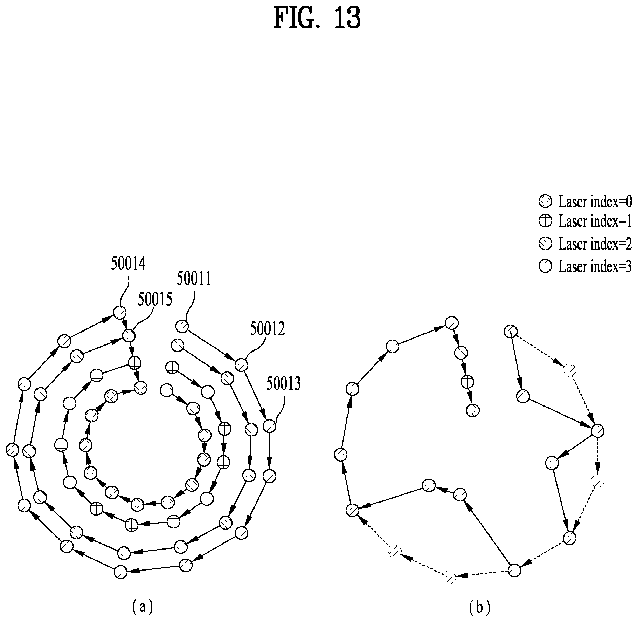

FIG. 13-(b) is a diagram illustrating an exemplary predictive tree when there are objects in the point cloud data acquired using multiple lasers according to embodiments;

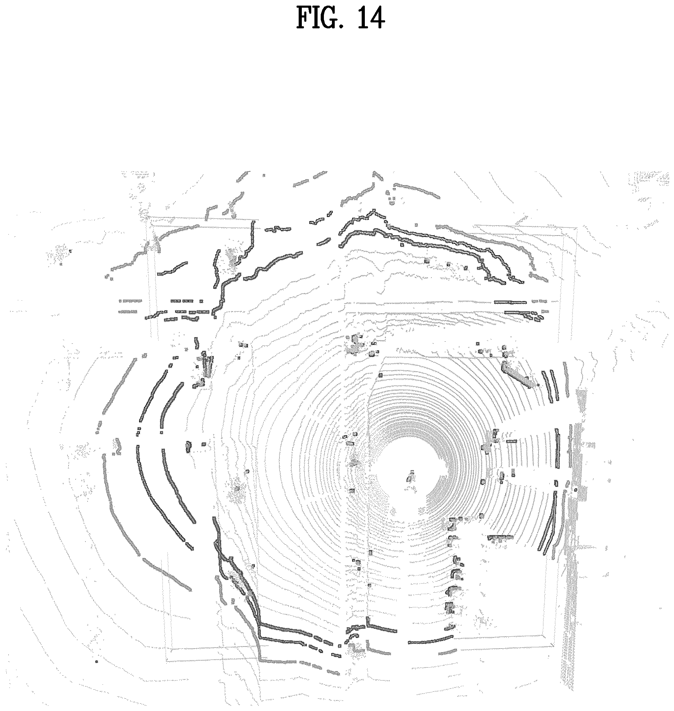

FIG. 14 is a diagram illustrating an example of points for each laser sensor according to embodiments;

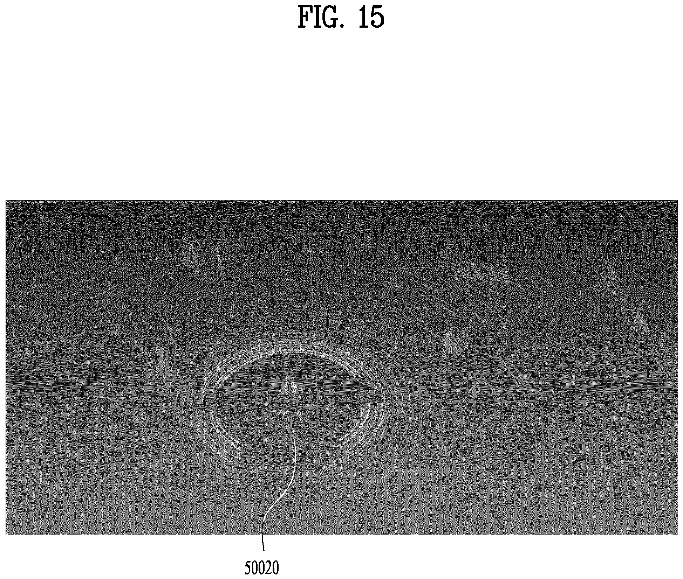

FIG. 15 is a diagram illustrating an example of point cloud data captured by LiDAR equipment according to embodiments;

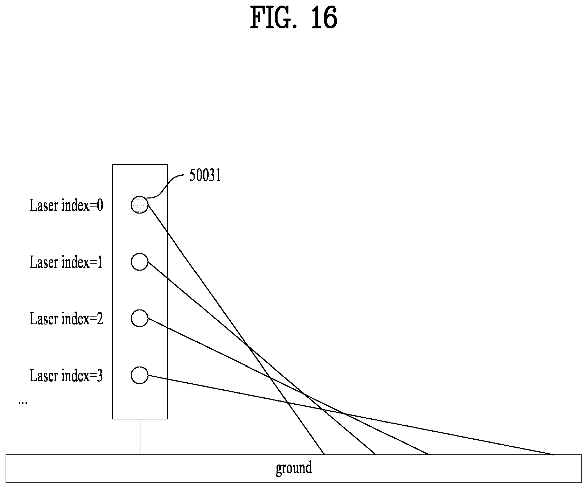

FIG. 16 is a diagram illustrating an example of laser sensors and angle $\theta$ according to embodiments;

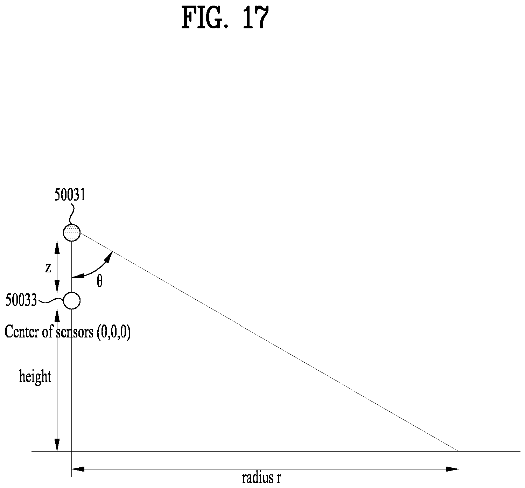

FIG. 17 is a diagram illustrating an exemplary position estimation method according to embodiments;

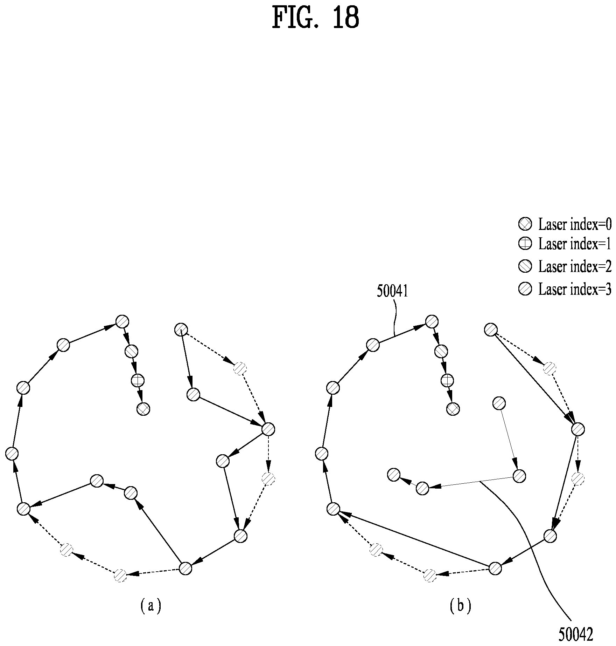

FIG. 18-(a) is a diagram illustrating an exemplary predictive tree using point cloud data that is not separated into a road and an object according to embodiments;
FIG. 18-(b) is a diagram illustrating an exemplary case where predictive trees are constructed with points belonging to a road and points belonging to an object, respectively, according to embodiments;

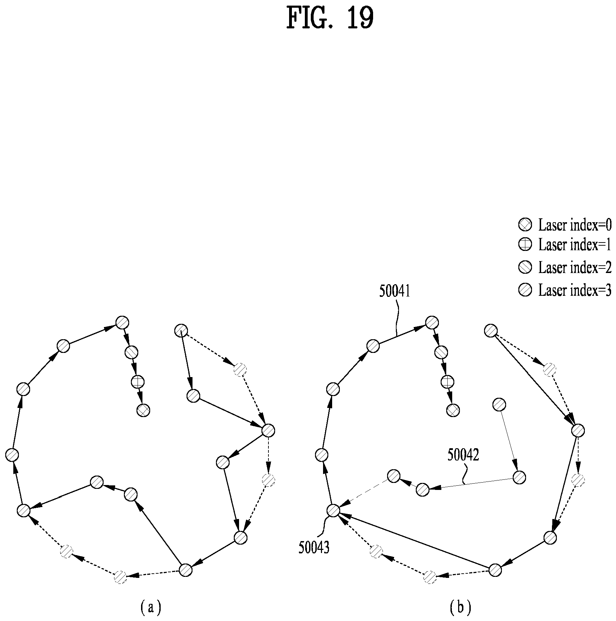

FIG. 19-(a) is a diagram illustrating an exemplary predictive tree using point cloud data that is not separated into a road and an object according to embodiments;
FIG. 19-(b) is a diagram illustrating an exemplary case where predictive trees are constructed with points belonging to a road and points belonging to an object, respectively, and are then connected to each other according to embodiments and then connecting the two predictive trees;

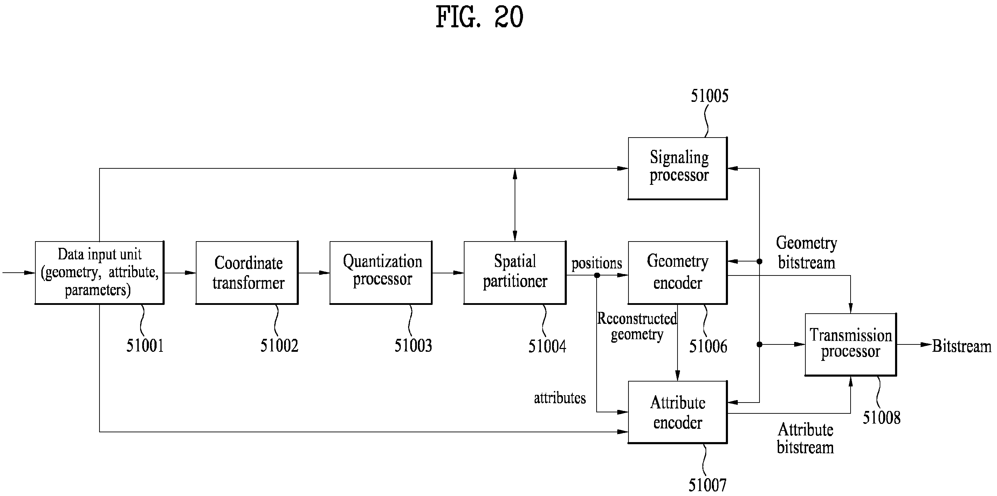

FIG. 20 is a diagram illustrating another exemplary point cloud transmission device according to embodiments;

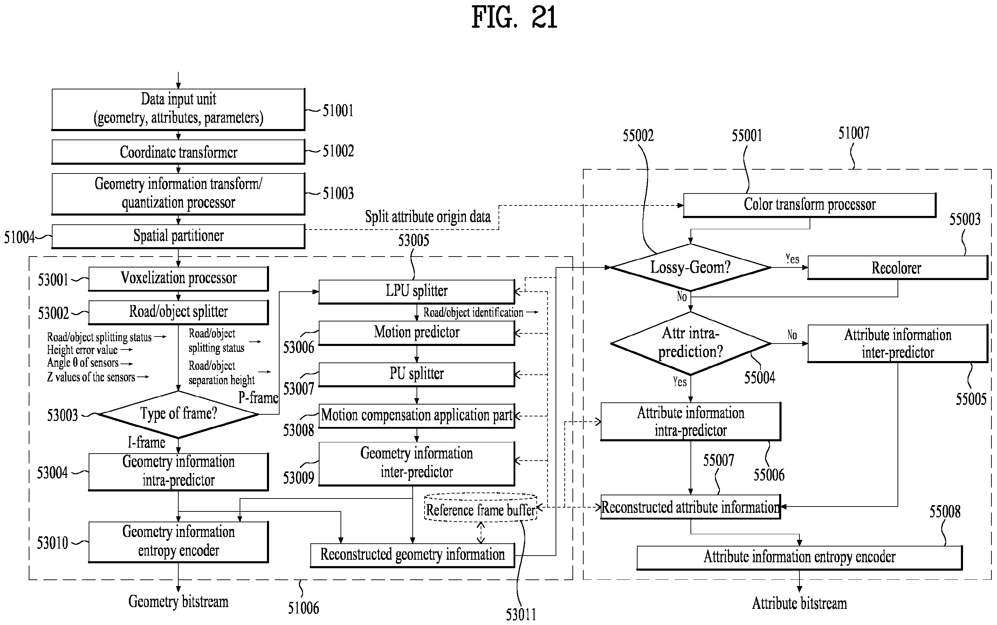

FIG. 21 is a diagram illustrating exemplary operations of a geometry encoder and an attribute encoder according to embodiments;

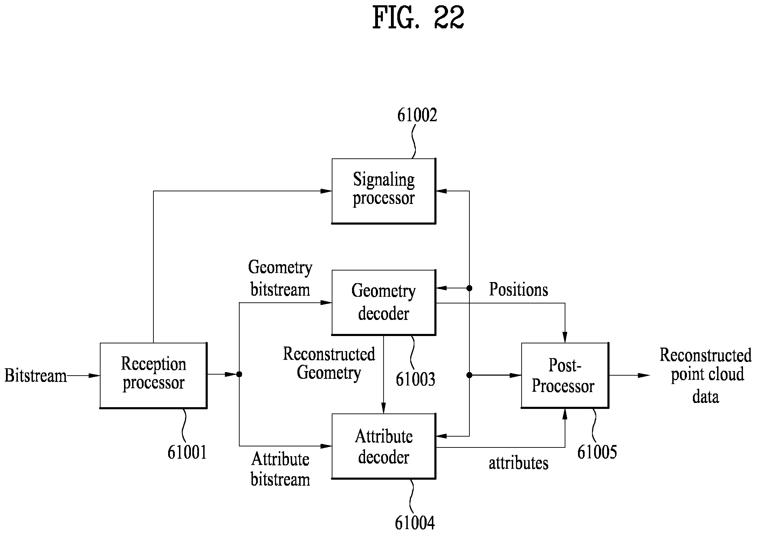

FIG. 22 is a diagram illustrating another exemplary point cloud reception device according to embodiments;

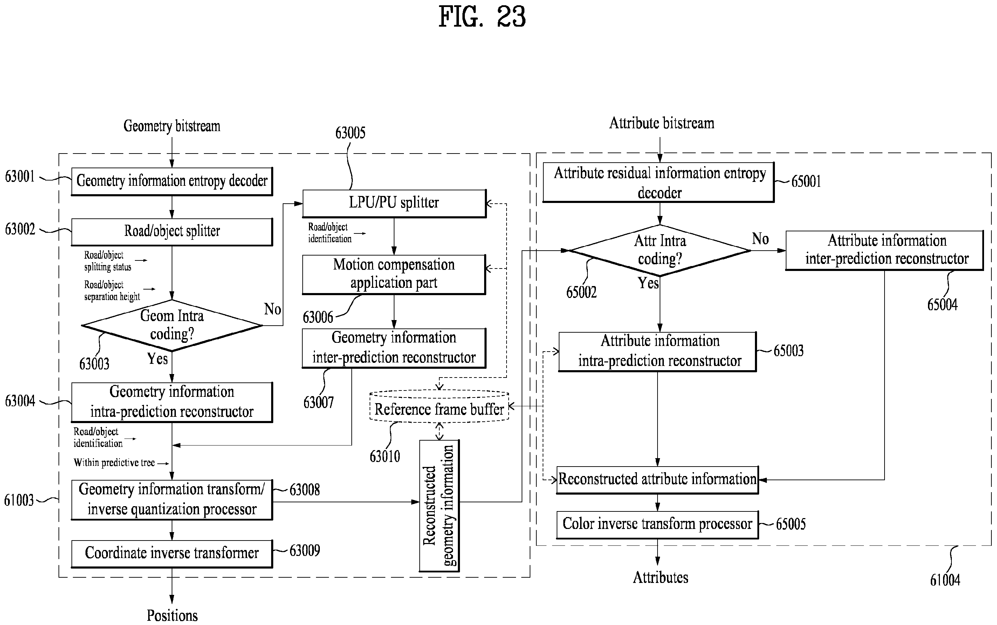

FIG. 23 is a diagram illustrating exemplary operations of a geometry decoder and an attribute decoder according to embodiments;

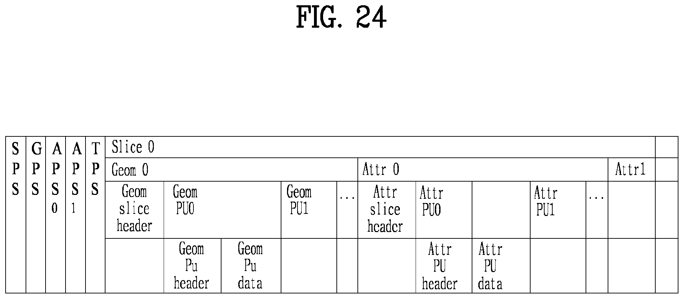

FIG. 24 illustrates an exemplary bitstream structure of point cloud data for transmission/reception according to embodiments;

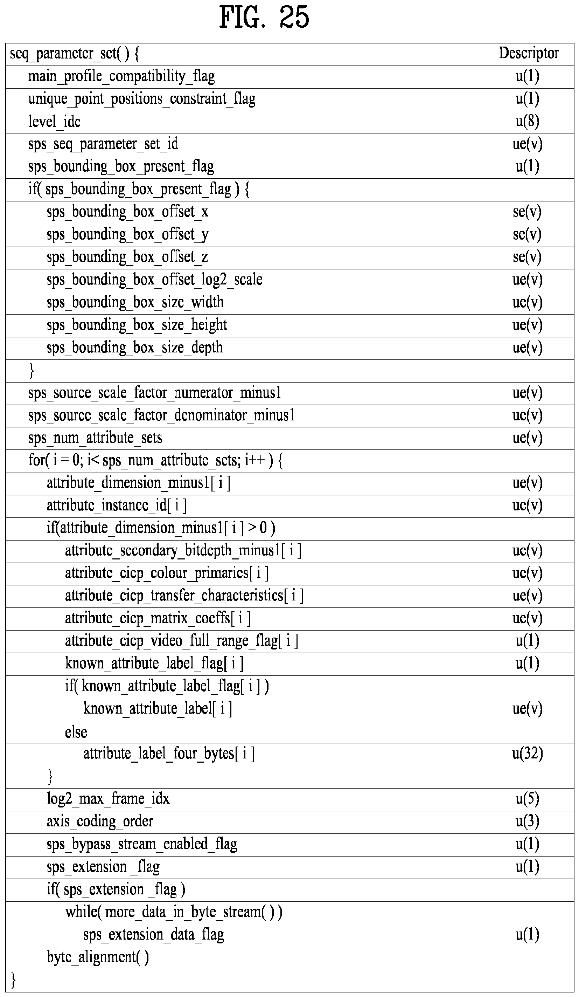

FIG. 25 illustrates an exemplary syntax structure of a sequence parameter set according to embodiments;

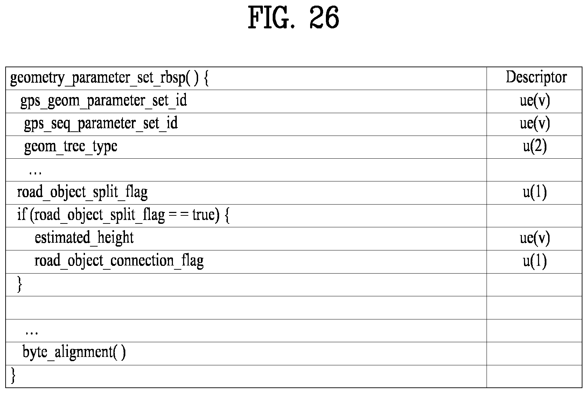

FIG. 26 illustrates an exemplary syntax structure of a geometry parameter set according to embodiments;

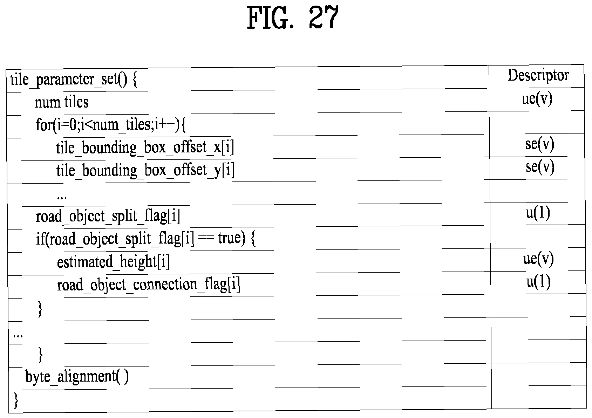

FIG. 27 illustrates an exemplary syntax structure of a tile parameter set according to embodiments;

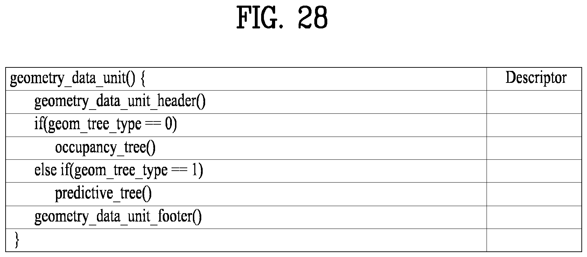

FIG. 28 illustrates an exemplary syntax structure of a geometry data unit according to embodiments;

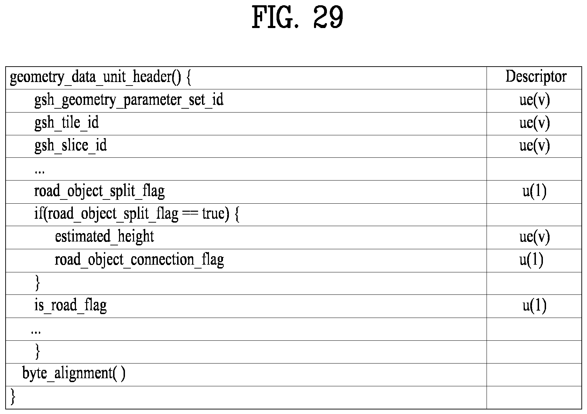

FIG. 29 illustrates an exemplary syntax structure of a geometry data unit header according to embodiments;

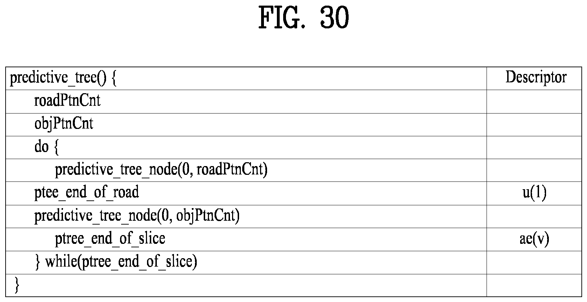

FIG. 30 illustrates an exemplary syntax structure of predictive_tree() according to embodiments;

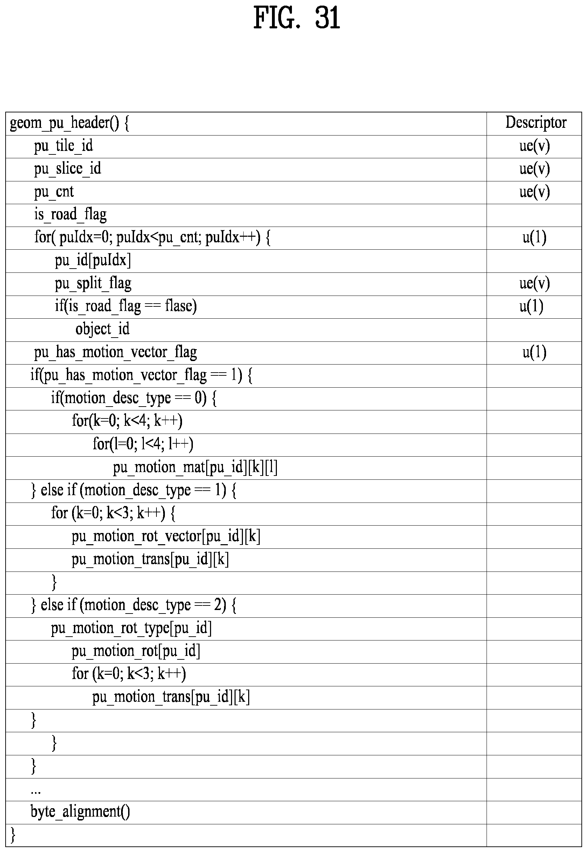

FIG. 31 illustrates an exemplary syntax structure of a geometry PU header according to embodiments;

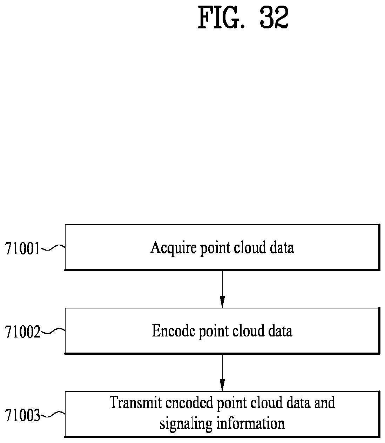

FIG. 32 is a flowchart illustrating an exemplary method of transmitting point cloud data according to embodiments; and

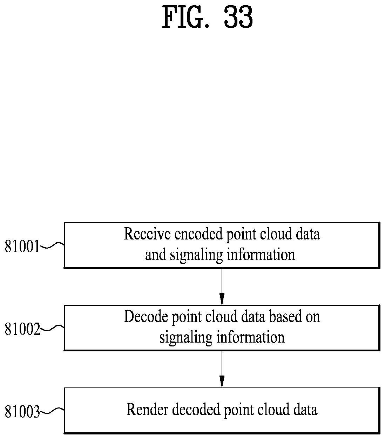

FIG. 33 is a flowchart illustrating an exemplary method of receiving point cloud data according to embodiments.

[Best Mode]

Reference will now be made in detail to the preferred embodiments of the present disclosure, examples of which are illustrated in the accompanying drawings. The detailed description, which will be given below with reference to the accompanying drawings, is intended to explain exemplary embodiments of the present disclosure, rather than to show the only embodiments that can be implemented according to the present disclosure. The following detailed description includes specific details in order to provide a thorough understanding of the present disclosure. However, it will be apparent to those skilled in the art that the present disclosure may be practiced without such specific details.

Although most terms used in the present disclosure have been selected from general ones widely used in the art, some terms have been arbitrarily selected by the applicant and their meanings are explained in detail in the following description as needed. Thus, the present disclosure should be understood based upon the intended meanings of the terms rather than their simple names or meanings.

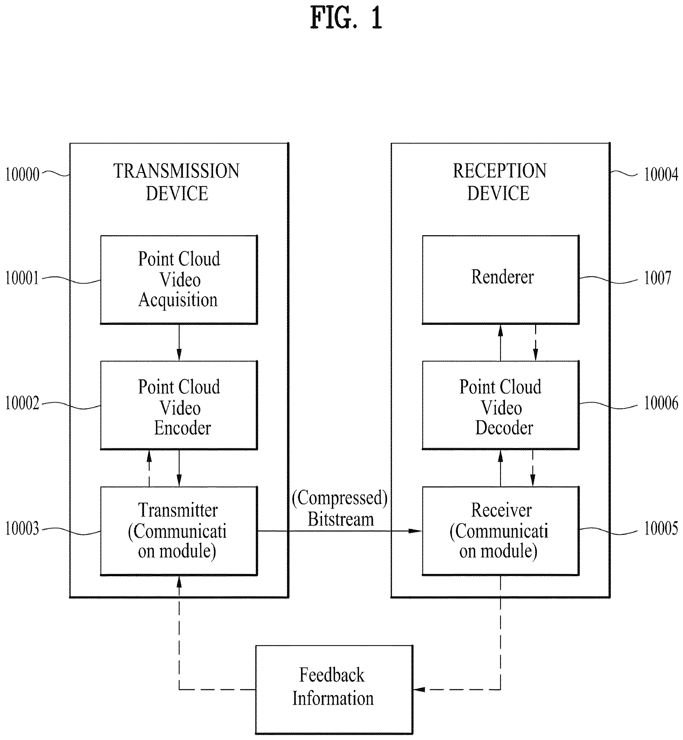

FIG. 1 shows an exemplary point cloud content providing system according to embodiments.

The point cloud content providing system illustrated in FIG. 1 may include a transmission device 10000 and a reception device 10004. The transmission device 10000 and the reception device 10004 are capable of wired or wireless communication to transmit and receive point cloud data.

The point cloud data transmission device 10000 according to the embodiments may secure and process point cloud video (or point cloud content) and transmit the same. According to embodiments, the transmission device 10000 may include a fixed station, a base transceiver system (BTS), a network, an artificial intelligence (AI) device and/or system, a robot, an AR/VR/XR device and/or server. According to embodiments, the transmission device 10000 may include a device, a robot, a vehicle, an AR/VR/XR device, a portable device, a home appliance, an Internet of Thing (IoT) device, and an AI device/server which are configured to perform communication with a base station and/or other wireless devices using a radio access technology (e.g., 5G New RAT (NR), Long Term Evolution (LTE)).

The transmission device 10000 according to the embodiments includes a point cloud video acquisition unit 10001, a point cloud video encoder 10002, and/or a transmitter (or communication module) 10003.

The point cloud video acquisition unit 10001 according to the embodiments acquires a point cloud video through a processing process such as capture, synthesis, or generation. The point cloud video is point cloud content represented by a point cloud, which is a set of points positioned in a 3D space, and may be referred to as point cloud video data, point cloud data, or the like. The point cloud video according to the embodiments may include one or more frames. One frame represents a still image/picture. Therefore, the point cloud video may include a point cloud image/frame/picture, and may be referred to as a point cloud image, frame, or picture.

The point cloud video encoder 10002 according to the embodiments encodes the acquired point cloud video data. The point cloud video encoder 10002 may encode the point cloud video data based on point cloud compression coding. The point cloud compression coding according to the embodiments may include geometry-based point cloud compression (G-PCC) coding and/or video-based point cloud compression (V-PCC) coding or next-generation coding. The point cloud compression coding according to the embodiments is not limited to the above-described embodiment. The point cloud video encoder 10002 may output a bitstream containing the encoded point cloud video data. The bitstream may contain not only the encoded point cloud video data, but also signaling information related to encoding of the point cloud video data.

The transmitter 10003 according to the embodiments transmits the bitstream containing the encoded point cloud video data. The bitstream according to the embodiments is encapsulated in a file or segment (e.g., a streaming segment), and is transmitted over various networks such as a broadcasting network and/or a broadband network. Although not shown in the figure, the transmission device 10000 may include an encapsulator (or an encapsulation module) configured to perform an encapsulation operation. According to embodiments, the encapsulator may be included in the transmitter 10003. According to embodiments, the file or segment may be transmitted to the reception device 10004 over a network, or stored in a digital storage medium (e.g., USB, SD, CD, DVD, Blu-ray, HDD, SSD, etc.). The transmitter 10003 according to the embodiments is capable of wired/wireless communication with the reception device 10004 (or the receiver 10005) over a network of 4G, 5G, 6G, etc. In addition, the transmitter may perform a necessary data processing operation according to the network system (e.g., a 4G, 5G or 6G communication network system). The transmission device 10000 may transmit the encapsulated data in an on-demand manner.

The reception device 10004 according to the embodiments includes a receiver 10005, a point cloud video decoder 10006, and/or a renderer 10007. According to embodiments, the reception device 10004 may include a device, a robot, a vehicle, an AR/VR/XR device, a portable device, a home appliance, an Internet of Things (IoT) device, and an AI device/server which are configured to perform communication with a base station and/or other wireless devices using a radio access technology (e.g., 5G New RAT (NR), Long Term Evolution (LTE)).

The receiver 10005 according to the embodiments receives the bitstream containing the point cloud video data or the file/segment in which the bitstream is encapsulated from the network or storage medium. The receiver 10005 may perform necessary data processing according to the network system (e.g., a communication network system of 4G, 5G, 6G, etc.). The receiver 10005 according to the embodiments may decapsulate the received file/segment and output a bitstream. According to embodiments, the receiver 10005 may include a decapsulator (or a decapsulation module) configured to perform a decapsulation operation. The decapsulator may be implemented as an element (or component) separate from the receiver 10005.

The point cloud video decoder 10006 decodes the bitstream containing the point cloud video data. The point cloud video decoder 10006 may decode the point cloud video data according to the method by which the point cloud video data is encoded (e.g., in a reverse process of the operation of the point cloud video encoder 10002). Accordingly, the point cloud video decoder 10006 may decode the point cloud video data by performing point cloud decompression coding, which is the reverse process to the point cloud compression. The point cloud decompression coding includes G-PCC coding.

The renderer 10007 renders the decoded point cloud video data. In one embodiment, the renderer 10007 may render the decoded point cloud video data according to a viewport or the like. The renderer 10007 may render not only the point cloud video data but also audio data to output point cloud content. According to embodiments, the renderer 10007 may include a display configured to display the point cloud content. According to embodiments, the display may be implemented as a separate device or component rather than being included in the renderer 10007.

The arrows indicated by dotted lines in the drawing represent a transmission path of feedback information acquired by the reception device 10004. The feedback information is information for reflecting interactivity with a user who consumes the point cloud content, and includes information about the user (e.g., head orientation information, viewport information, and the like). In particular, when the point cloud content is content for a service (e.g., self-driving service, etc.) that requires interaction with the user, the feedback information may be provided to the content transmitting side (e.g., the transmission device 10000) and/or the service provider. According to embodiments, the feedback information may be used in the reception device 10004 as well as the transmission device 10000, or may not be provided.

The head orientation information according to the embodiments may represent information about a position, orientation, angle, and motion of a user's head. The reception device 10004 according to the embodiments may calculate viewport information based on the head orientation information. The viewport information is information about a region of a point cloud video that the user is viewing (that is, a region that the user is currently viewing). That is, the viewport information is information about a region that the user is currently viewing in the point cloud video. In other words, the viewport or viewport region may represent a region that the user is viewing in the point cloud video. A viewpoint is a point that the user is viewing in the point cloud video, and may represent a center point of the viewport region. That is, the viewport is a region centered on a viewpoint, and the size and shape of the region may be determined by a field of view (FOV). Accordingly, the reception device 10004 may extract the viewport information based on a vertical or horizontal FOV supported by the device as well as the head orientation information. In addition, the reception device 10004 may perform gaze analysis or the like based on the head orientation information and/or the viewport information to determine the way the user consumes a point cloud video, a region at which the user gazes in the point cloud video, and the gaze time. According to embodiments, the reception device 10004 may transmit feedback information including the result of the gaze analysis to the transmission device 10000. According to embodiments, a device such as a VR/XR/AR/MR display may extract a viewport region based on the position/orientation of a user's head and a vertical or horizontal FOV supported by the device. According to embodiments, the head orientation information and the viewport information may be referred to as feedback information, signaling information, or metadata.

The feedback information according to the embodiments may be acquired in the rendering and/or display process. The feedback information may be secured by one or more sensors included in the reception device 10004. According to embodiments, the feedback information may be secured by the renderer 10007 or a separate external element (or device, component, or the like). The dotted lines in FIG. 1 represent a process of transmitting the feedback information secured by the renderer 10007. The feedback information may not only be transmitted to the transmitting side, but also be consumed at the receiving side. That is, the point cloud content providing system may process (encode/-decode/render) point cloud data based on the feedback information. For example, the point cloud video decoder 10006 and the renderer 10007 may preferentially decode and render only the point cloud video for a region currently viewed by the user, based on the feedback information, namely, the head orientation information and/or the viewport information.

Furthermore, the reception device 10004 may transmit the feedback information to the transmission device 10000. The transmission device 10000 (or the point cloud video encoder 10002) may perform an encoding operation based on the feedback information. Accordingly, the point cloud content providing system may efficiently process necessary data (e.g., point cloud data corresponding to the user's head position) based on the feedback information rather than processing (encoding/decoding) the entire point cloud data, and provide point cloud content to the user.

According to embodiments, the transmission device 10000 may be called an encoder, a transmission device, a transmitter, transmission system or the like, and the reception device 10004 may be called a decoder, a receiving device, a receiver, receiving system or the like.

The point cloud data processed in the point cloud content providing system of FIG. 1 according to embodiments (through a series of processes of acquisition/encoding/transmission/decoding/rendering) may be referred to as point cloud content data or point cloud video data. According to embodiments, the point cloud content data may be used as a concept covering metadata or signaling information related to the point cloud data.

The elements of the point cloud content providing system illustrated in FIG. 1 may be implemented by hardware, software, a processor, and/or a combination thereof.

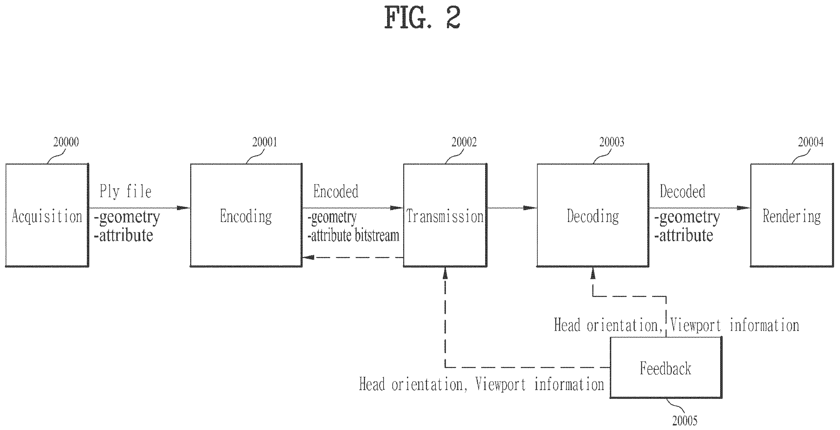

FIG. 2 is a block diagram illustrating a point cloud content providing operation according to embodiments.

The block diagram of FIG. 2 shows the operation of the point cloud content providing system described in FIG. 1. As described above, the point cloud content providing system may process point cloud data based on point cloud compression coding (e.g., G-PCC).

The point cloud content providing system according to the embodiments (e.g., the point cloud transmission device 10000 or the point cloud video acquisition unit 10001) may acquire a point cloud video (20000). The point cloud video is represented by a point cloud belonging to a coordinate system for expressing a 3D space. The point cloud video according to the embodiments may include a Ply (Polygon File format or the Stanford Triangle format) file. When the point cloud video has one or more frames, the acquired point cloud video may include one or more Ply files. The Ply files contain point cloud data, such as point geometry and/or attributes. The geometry includes positions of points. The position of each point may be represented by parameters (e.g., values of the X, Y, and Z axes) representing a three-dimensional coordinate system (e.g., a coordinate system composed of X, Y and Z axes). The attributes include attributes of points (e.g., information about texture, color (in YCbCr or RGB), reflectance r, transparency, etc. of each point). A point has one or more attributes. For example, a point may have an attribute that is a color, or two attributes that are color and reflectance. According to embodiments, the geometry may be called positions, geometry information, geometry data, position information, position data, or the like, and the attribute may be called attributes, attribute information, attribute data, or the like. The point cloud content providing system (e.g., the point cloud transmission device 10000 or the point cloud video acquisition unit 10001) may secure point cloud data from information (e.g., depth information, color information, etc.) related to the acquisition process of the point cloud video.

The point cloud content providing system (e.g., the transmission device 10000 or the point cloud video encoder 10002) according to the embodiments may encode the point cloud data (20001). The point cloud content providing system may encode the point cloud data based on point cloud compression coding. As described above, the point cloud data may include the geometry information and attribute information about a point. Accordingly, the point cloud content providing system may perform geometry encoding of encoding the geometry and output a geometry bitstream. The point cloud content providing system may perform attribute encoding of encoding attributes and output an attribute bitstream. According to embodiments, the point cloud content providing system may perform the attribute encoding based on the geometry encoding. The geometry bitstream and the attribute bitstream according to the embodiments may be multiplexed and output as one bitstream. The bitstream according to the embodiments may further contain signaling information related to the geometry encoding and attribute encoding.

The point cloud content providing system (e.g., the transmission device 10000 or the transmitter 10003) according to the embodiments may transmit the encoded point cloud data (20002). As illustrated in FIG. 1, the encoded point cloud data may be represented by a geometry bitstream and an attribute bitstream. In addition, the encoded point cloud data may be transmitted in the form of a bitstream together with signaling information related to encoding of the point cloud data (e.g., signaling information related to the geometry encoding and the attribute encoding). The point cloud content providing system may encapsulate a bitstream that carries the encoded point cloud data and transmit the same in the form of a file or segment.

The point cloud content providing system (e.g., the reception device 10004 or the receiver 10005) according to the embodiments may receive the bitstream containing the encoded point cloud data. In addition, the point cloud content providing system (e.g., the reception device 10004 or the receiver 10005) may demultiplex the bitstream.

The point cloud content providing system (e.g., the reception device 10004 or the point cloud video decoder 10005) may decode the encoded point cloud data (e.g., the geometry bitstream, the attribute bitstream) transmitted in the bitstream. The point cloud content providing system (e.g., the reception device 10004 or the point cloud video decoder 10005) may decode the point cloud video data based on the signaling information related to encoding of the point cloud video data contained in the bitstream. The point cloud content providing system (e.g., the reception device 10004 or the point cloud video decoder 10005) may decode the geometry bitstream to reconstruct the positions (geometry) of points. The point cloud content providing system may reconstruct the attributes of the points by decoding the attribute bitstream based on the reconstructed geometry. The point cloud content providing system (e.g., the reception device 10004 or the point cloud video decoder 10005) may reconstruct the point cloud video based on the positions according to the reconstructed geometry and the decoded attributes.

The point cloud content providing system according to the embodiments (e.g., the reception device 10004 or the renderer 10007) may render the decoded point cloud data (20004). The point cloud content providing system (e.g., the reception device 10004 or the renderer 10007) may render the geometry and attributes decoded through the decoding process, using various rendering methods. Points in the point cloud content may be rendered to a vertex having a certain thickness, a cube having a specific minimum size centered on the corresponding vertex position, or a circle centered on the corresponding vertex position. All or part of the rendered point cloud content is provided to the user through a display (e.g., a VR/AR display, a general display, etc.).

The point cloud content providing system (e.g., the reception device 10004) according to the embodiments may secure feedback information (20005). The point cloud content providing system may encode and/or decode point cloud data based on the feedback information. The feedback information and the operation of the point cloud content providing system according to the embodiments are the same as the feedback information and the operation described with reference to FIG. 1, and thus a detailed description thereof is omitted.

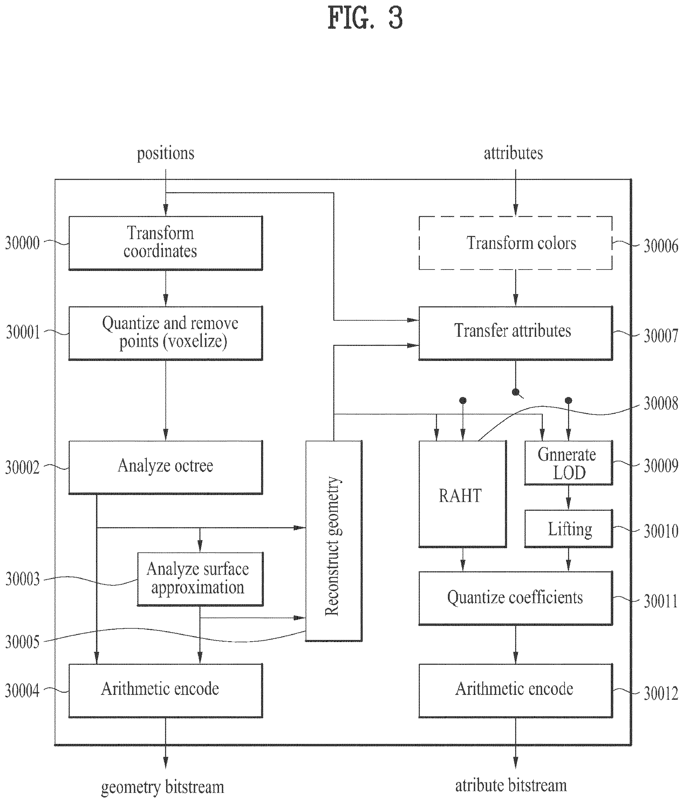

FIG. 3 illustrates an exemplary point cloud encoder according to embodiments.

FIG. 3 shows an example of the point cloud video encoder 10002 of FIG. 1. The point cloud encoder reconstructs and encodes point cloud data (e.g., positions and/or attributes of the points) to adjust the quality of the point cloud content (to, for example, lossless, lossy, or near-lossless) according to the network condition or applications. When the overall size of the point cloud content is large (e.g., point cloud content of 60 Gbps is given for 30 fps), the point cloud content providing system may fail to stream the content in real time. Accordingly, the point cloud content providing system may reconstruct the point cloud content based on the maximum target bitrate to provide the same in accordance with the network environment or the like.

As described with reference to FIGS. 1 and 2, the point cloud encoder may perform geometry encoding and attribute encoding. The geometry encoding is performed before the attribute encoding.

The point cloud video encoder according to the embodiments includes a coordinate transformer (Transform coordinates) 30000, a quantizer (Quantize and remove points (voxelize)) 30001, an octree analyzer (Analyze octree) 30002, a surface approximation analyzer (Analyze surface approximation) 30003, an arithmetic encoder (Arithmetic encode) 30004, a geometry reconstructor (Reconstruct geometry) 30005, a color transformer (Transform colors) 30006, an attribute transformer (Transfer attributes) 30007, a RAHT transformer 30008, an LOD generator (Generated LOD) 30009, a lifting transformer (Lifting) 30010, a coefficient quantizer (Quantize coefficients) 30011, and/or an arithmetic encoder (Arithmetic encode) 30012. In the point cloud encoder of FIG. 3, the coordinate transformer 30000, the quantizer 30001, the octree analyzer 30002, the surface approximation analyzer 30003, the arithmetic encoder 30004, and the geometry reconstructor 30005 may be grouped together and referred to as a geometry encoder. The color transformer 30006, the attribute transformer 30007, the RAHT transformer 30008, the LOD generator 30009, the lifting transformer 30010, the coefficient quantizer 30011, and/or the arithmetic encoder 30012 may be grouped together and referred to as an attribute encoder.

The coordinate transformer 30000, the quantizer 30001, the octree analyzer 30002, the surface approximation analyzer 30003, the arithmetic encoder 30004, and the geometry reconstructor 30005 may perform geometry encoding. The geometry encoding according to the embodiments may include octree geometry coding, predictive tree geometry coding, direct coding, trisoup geometry encoding, and entropy encoding. The direct coding and trisoup geometry encoding are applied selectively or in combination. The geometry encoding is not limited to the above-described example.

As shown in the figure, the coordinate transformer 30000 according to the embodiments receives positions and transforms the same into coordinates. For example, the positions may be transformed into position information in a three-dimensional space (e.g., a three-dimensional space represented by an XYZ coordinate system). The position information in the three-dimensional space according to the embodiments may be referred to as geometry information.

The quantizer 30001 according to the embodiments quantizes the geometry. For example, the quantizer 30001 may quantize the points based on a minimum position value of all points (e.g., a minimum value on each of the X, Y, and Z axes). The quantizer 30001 performs a quantization operation of multiplying the difference between the minimum position value and the position value of each point by a preset quantization scale value and then finding the nearest integer value by rounding the value obtained through the multiplication. Thus, one or more points may have the same quantized position (or position value). The quantizer 30001 according to the embodiments performs voxelization based on the quantized positions to reconstruct quantized points. As in the case of a pixel, which is the minimum unit containing 2D image/video information, points of point cloud content (or 3D point cloud video) according to the embodiments may be included in one or more voxels. The term voxel, which is a compound of volume and pixel, refers to a 3D cubic space generated when a 3D space is divided into units (unit=1.0) based on the axes representing the 3D space (e.g., X-axis, Y-axis, and Z-axis). The quantizer 30001 may match groups of points in the 3D space with voxels. According to embodiments, one voxel may include only one point. According to embodiments, one voxel may include one or more points. In order to express one voxel as one point, the position of the center of a voxel may be set based on the positions of one or more points included in the voxel. In this case, attributes of all positions included in one voxel may be combined and assigned to the voxel.

The octree analyzer 30002 according to the embodiments performs octree geometry coding (or octree coding) to present voxels in an octree structure. The octree structure represents points matched with voxels, based on the octal tree structure.

The surface approximation analyzer 30003 according to the embodiments may analyze and approximate the octree. The octree analysis and approximation according to the embodiments is a process of analyzing a region containing a plurality of points to efficiently provide octree and voxelization.

The arithmetic encoder 30004 according to the embodiments performs entropy encoding on the octree and/or the approximated octree. For example, the encoding scheme includes arithmetic encoding. As a result of the encoding, a geometry bitstream is generated.

The color transformer 30006, the attribute transformer 30007, the RAHT transformer 30008, the LOD generator 30009, the lifting transformer 30010, the coefficient quantizer 30011, and/or the arithmetic encoder 30012 perform attribute encoding. As described above, one point may have one or more attributes. The attribute encoding according to the embodiments is equally applied to the attributes that one point has. However, when an attribute (e.g., color) includes one or more elements, attribute encoding is independently applied to each element. The attribute encoding according to the embodiments includes color transform coding, attribute transform coding, region adaptive hierarchical transform (RAHT) coding, interpolation-based hierarchical nearest-neighbor prediction (prediction transform) coding, and interpolation-based hierarchical nearest-neighbor prediction with an update/lifting step (lifting transform) coding. Depending on the point cloud content, the RAHT coding, the prediction transform coding and the lifting transform coding described above may be selectively used, or a combination of one or more of the coding schemes may be used. The attribute encoding according to the embodiments is not limited to the above-described example.

The color transformer 30006 according to the embodiments performs color transform coding of transforming color values (or textures) included in the attributes. For example, the color transformer 30006 may transform the format of color information (for example, from RGB to YCbCr). The operation of the color transformer 30006 according to embodiments may be optionally applied according to the color values included in the attributes.

The geometry reconstructor 30005 according to the embodiments reconstructs (decompresses) the octree and/or the approximated octree. The geometry reconstructor 30005 reconstructs the octree/voxels based on the result of analyzing the distribution of points. The reconstructed octree/voxels may be referred to as reconstructed geometry (restored geometry).

The attribute transformer 30007 according to the embodiments performs attribute transformation to transform the attributes based on the reconstructed geometry and/or the positions on which geometry encoding is not performed. As described above, since the attributes are dependent on the geometry, the attribute transformer 30007 may transform the attributes based on the reconstructed geometry information. For example, based on the position value of a point included in a voxel, the attribute transformer 30007 may transform the attribute of the point at the position. As described above, when the position of the center of a voxel is set based on the positions of one or more points included in the voxel, the attribute transformer 30007 transforms the attributes of the one or more points. When the trisoup geometry encoding is performed, the attribute transformer 30007 may transform the attributes based on the trisoup geometry encoding.

The attribute transformer 30007 may perform the attribute transformation by calculating the average of attributes or attribute values of neighboring points (e.g., color or reflectance of each point) within a specific position/radius from the position (or position value) of the center of each voxel. The attribute transformer 30007 may apply a weight according to the distance from the center to each point in calculating the average. Accordingly, each voxel has a position and a calculated attribute (or attribute value).

The attribute transformer 30007 may search for neighboring points existing within a specific position/radius from the position of the center of each voxel based on the K-D tree or the Morton code. The K-D tree is a binary search tree and supports a data structure capable of managing points based on the positions such that nearest neighbor search (NNS) can be performed quickly. The Morton code is generated by presenting coordinates (e.g., (x, y, z)) representing 3D positions of all points as bit values and mixing the bits. For example, when the coordinates representing the position of a point are (5, 9, 1), the bit values for the coordinates are (0101, 1001, 0001). Mixing the bit values according to the bit index in order of z, y, and x yields 010001000111. This value is expressed as a decimal number of 1095. That is, the Morton code value of the point having coordinates (5, 9, 1) is 1095. The attribute transformer 30007 may order the points based on the Morton code values and perform NNS through a depth-first traversal process. After the attribute transformation operation, the K-D tree or the Morton code is used when the NNS is needed in another transformation process for attribute coding.

As shown in the figure, the transformed attributes are input to the RAHT transformer 40008 and/or the LOD generator 30009.

The RAHT transformer 30008 according to the embodiments performs RAHT coding for predicting attribute information based on the reconstructed geometry information. For example, the RAHT transformer 30008 may predict attribute information of a node at a higher level in the octree based on the attribute information associated with a node at a lower level in the octree.

The LOD generator 30009 according to the embodiments generates a level of detail (LOD) to perform prediction transform coding. The LOD according to the embodiments is a degree of detail of point cloud content. As the LOD value decrease, it indicates that the detail of the point cloud content is degraded. As the LOD value increases, it indicates that the detail of the point cloud content is enhanced. Points may be classified by the LOD.

The lifting transformer 30010 according to the embodiments performs lifting transform coding of transforming the attributes a point cloud based on weights. As described above, lifting transform coding may be optionally applied.

The coefficient quantizer 30011 according to the embodiments quantizes the attribute-coded attributes based on coefficients.

The arithmetic encoder 30012 according to the embodiments encodes the quantized attributes based on arithmetic coding.

Although not shown in the figure, the elements of the point cloud encoder of FIG. 3 may be implemented by hardware including one or more processors or integrated circuits configured to communicate with one or more memories included in the point cloud providing device, software, firmware, or a combination thereof. The one or more processors may perform at least one of the operations and/or functions of the elements of the point cloud encoder of FIG. 3 described above. Additionally, the one or more processors may operate or execute a set of software programs and/or instructions for performing the operations and/or functions of the elements of the point cloud encoder of FIG. 3. The one or more memories according to the embodiments may include a high speed random access memory, or include a non-volatile memory (e.g., one or more magnetic disk storage devices, flash memory devices, or other non-volatile solid-state memory devices).

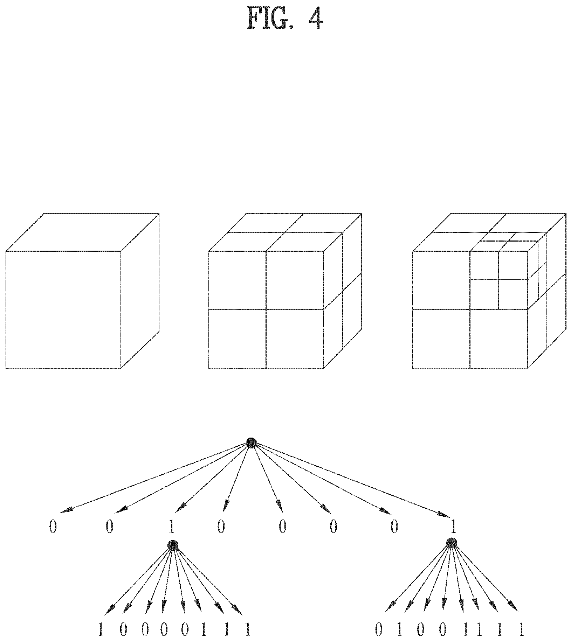

FIG. 4 shows an example of an octree and occupancy code according to embodiments.

As described with reference to FIGS. 1 to 3, the point cloud content providing system (point cloud video encoder 10002) or the point cloud encoder (e.g., the octree analyzer 30002) performs octree geometry coding (or octree coding) based on an octree structure to efficiently manage the region and/or position of the voxel.

The upper part of FIG. 4 shows an octree structure. The 3D space of the point cloud content according to the embodiments is represented by axes (e.g., X-axis, Y-axis, and Z-axis) of the coordinate system. The octree structure is created by recursive subdividing of a cubical axis-aligned bounding box defined by two poles (0, 0, 0) and ($2^d$, $2^d$, $2^d$). Here, 2d may be set to a value constituting the smallest bounding box surrounding all points of the point cloud content (or point cloud video). Here, d denotes the depth of the octree. The value of d is determined in the following equation. In the following equation, ($x^{int}_n$, $y^{int}_n$, $z^{int}_n$) denotes the positions (or position values) of quantized points.

$$d = Ceil\left(Log2\left(Max\left(x_n^{int}, y_n^{int}, z_n^{int}, n = 1, ..., N\right) + 1\right)\right)$$

As shown in the middle of the upper part of FIG. 4, the entire 3D space may be divided into eight spaces according to partition. Each divided space is represented by a cube with six faces. As shown in the upper right of FIG. 4, each of the eight spaces is divided again based on the axes of the coordinate system (e.g., X-axis, Y-axis, and Z-axis). Accordingly, each space is divided into eight smaller spaces. The divided smaller space is also represented by a cube with six faces. This partitioning scheme is applied until the leaf node of the octree becomes a voxel.

The lower part of FIG. 4 shows an octree occupancy code. The occupancy code of the octree is generated to indicate whether each of the eight divided spaces generated by dividing one space contains at least one point. Accordingly, a single occupancy code is represented by eight child nodes. Each child node represents the occupancy of a divided space, and the child node has a value in 1 bit. Accordingly, the occupancy code is represented as an 8-bit code. That is, when at least one point is contained in the space corresponding to a child node, the node is assigned a value of 1. When no point is contained in the space corresponding to the child node (the space is empty), the node is assigned a value of 0. Since the occupancy code shown in FIG. 4 is 00100001, it indicates that the spaces corresponding to the third child node and the eighth child node among the eight child nodes each contain at least one point. As shown in the figure, each of the third child node and the eighth child node has eight child nodes, and the child nodes are represented by an 8-bit occupancy code. The figure shows that the occupancy code of the third child node is 10000111, and the occupancy code of the eighth child node is 01001111. The point cloud encoder (e.g., the arithmetic encoder 30004) according to the embodiments may perform entropy encoding on the occupancy codes. In order to increase the compression efficiency, the point cloud encoder may perform intra/inter-coding on the occupancy codes. The reception device (e.g., the reception device 10004 or the point cloud video decoder 10006) according to the embodiments reconstructs the octree based on the occupancy codes.

The point cloud encoder (e.g., the point cloud encoder of FIG. 4 or the octree analyzer 30002) according to the embodiments may perform voxelization and octree coding to store the positions of points. However, points are not always evenly distributed in the 3D space, and accordingly there may be a specific region in which fewer points are present. Accordingly, it is inefficient to perform voxelization for the entire 3D space. For example, when a specific region contains few points, voxelization does not need to be performed in the specific region.

Accordingly, for the above-described specific region (or a node other than the leaf node of the octree), the point cloud encoder according to the embodiments may skip voxelization and perform direct coding to directly code the positions of points included in the specific region. The coordinates of a direct coding point according to the embodiments are referred to as direct coding mode (DCM). The point cloud encoder according to the embodiments may also perform trisoup geometry encoding, which is to reconstruct the positions of the points in the specific region (or node) based on voxels, based on a surface model. The trisoup geometry encoding is geometry encoding that represents an object as a series of triangular meshes. Accordingly, the point cloud decoder may generate a point cloud from the mesh surface. The direct coding and trisoup geometry encoding according to the embodiments may be selectively performed. In addition, the direct coding and trisoup geometry encoding according to the embodiments may be performed in combination with octree geometry coding (or octree coding).

To perform direct coding, the option to use the direct mode for applying direct coding should be activated. A node to which direct coding is to be applied is not a leaf node, and points less than a threshold should be present within a specific node. In addition, the total number of points to which direct coding is to be applied should not exceed a preset threshold. When the conditions above are satisfied, the point cloud encoder (or the arithmetic encoder 30004) according to the embodiments may perform entropy coding on the positions (or position values) of the points.

The point cloud encoder (e.g., the surface approximation analyzer 30003) according to the embodiments may determine a specific level of the octree (a level less than the depth d of the octree), and the surface model may be used staring with that level to perform trisoup geometry encoding to reconstruct the positions of points in the region of the node based on voxels (Trisoup mode). The point cloud encoder according to the embodiments may specify a level at which trisoup geometry encoding is to be applied. For example, when the specific level is equal to the depth of the octree, the point cloud encoder does not operate in the trisoup mode. In other words, the point cloud encoder according to the embodiments may operate in the trisoup mode only when the specified level is less than the value of depth of the octree. The 3D cube region of the nodes at the specified level according to the embodiments is called a block. One block may include one or more voxels. The block or voxel may correspond to a brick. Geometry is represented as a surface within each block. The surface according to embodiments may intersect with each edge of a block at most once.

One block has 12 edges, and accordingly there are at least 12 intersections in one block. Each intersection is called a vertex (or apex). A vertex present along an edge is detected when there is at least one occupied voxel adjacent to the edge among all blocks sharing the edge. The occupied voxel according to the embodiments refers to a voxel containing a point. The position of the vertex detected along the edge is the average position along the edge of all voxels adjacent to the edge among all blocks sharing the edge.

Once the vertex is detected, the point cloud encoder according to the embodiments may perform entropy encoding on the starting point (x, y, z) of the edge, the direction vector ($\Delta$x, $\Delta$y, $\Delta$z) of the edge, and the vertex position value (relative position value within the edge). When the trisoup geometry encoding is applied, the point cloud encoder according to the embodiments (e.g., the geometry reconstructor 30005) may generate restored geometry (reconstructed geometry) by performing the triangle reconstruction, up-sampling, and voxelization processes.

The vertices positioned at the edge of the block determine a surface that passes through the block. The surface according to the embodiments is a non-planar polygon. In the triangle reconstruction process, a surface represented by a triangle is reconstructed based on the starting point of the edge, the direction vector of the edge, and the position values of the vertices. The triangle reconstruction process is performed by: i) calculating the centroid value of each vertex, ii) subtracting the center value from each vertex value, and iii) estimating the sum of the squares of the values obtained by the subtraction.

$$\text{①} \begin{bmatrix} \mu_x \\ \mu_y \\ \mu_z \end{bmatrix} = \frac{1}{n}\sum_{i=1}^{n} \begin{bmatrix} x_i \\ y_i \\ z_i \end{bmatrix} \quad \text{②} \begin{bmatrix} \bar{x}_i \\ \bar{y}_i \\ \bar{z}_i \end{bmatrix} = \begin{bmatrix} x_i \\ y_i \\ z_i \end{bmatrix} - \begin{bmatrix} \mu_x \\ \mu_y \\ \mu_z \end{bmatrix} \quad \text{③} \begin{bmatrix} \sigma_x^2 \\ \sigma_y^2 \\ \sigma_z^2 \end{bmatrix} = \sum_{i=1}^{n} \begin{bmatrix} \bar{x}_i^2 \\ \bar{y}_i^2 \\ \bar{z}_i^2 \end{bmatrix}$$

The minimum value of the sum is estimated, and the projection process is performed according to the axis with the minimum value. For 'example, when the element x is the minimum, each vertex is projected on the x-axis with respect to the center of the block, and projected on the (y, z) plane. When the values obtained through projection on the (y, z) plane are (ai, bi), the value of $\theta$ is estimated through atan2(bi, ai), and the vertices are ordered based on the value of $\theta$. The table 1 below shows a combination of vertices for creating a triangle according to the number of the vertices. The vertices are ordered from 1 to n. The table 1 below shows that for four vertices, two triangles may be constructed according to combinations of vertices. The first triangle may consist of vertices 1, 2, and 3 among the ordered vertices, and the second triangle may consist of vertices 3, 4, and 1 among the ordered vertices.

[Table 1] Triangles formed from vertices ordered 1,...,n

| [Table 1] | |
|---|---|
| *n* | **Triangles** |
| | (1,2,3) |
| | (1,2,3), (3,4,1) |
| | (1,2,3), (3,4,5), (5,1,3) |
| | (1,2,3), (3,4,5), (5,6,1), (1,3,5) |
| | (1,2,3), (3,4,5), (5,6,7), (7,1,3), (3,5,7) |
| | (1,2,3), (3,4,5), (5,6,7), (7,8,1), (1,3,5), (5,7,1) |
| | (1,2,3), (3,4,5), (5,6,7), (7,8,9), (9,1,3), (3,5,7), (7,9,3) |
| 0 | (1,2,3), (3,4,5), (5,6,7), (7,8,9), (9,10,1), (1,3,5), (5,7,9), (9,1,5) |
| 1 | (1,2,3), (3,4,5), (5,6,7), (7,8,9), (9,10,11), (11,1,3), (3,5,7), (7,9,11), (11,3,7) |
| 2 | (1,2,3), (3,4,5), (5,6,7), (7,8,9), (9,10,11), (11,12,1), (1,3,5), (5,7,9), (9,11,1), (1,5,9) |

The upsampling process is performed to add points in the middle along the edge of the triangle and perform voxelization. The added points are generated based on the upsampling factor and the width of the block. The added points are called refined vertices. The point cloud encoder according to the embodiments may voxelize the refined vertices. In addition, the point cloud encoder may perform attribute encoding based on the voxelized positions (or position values).

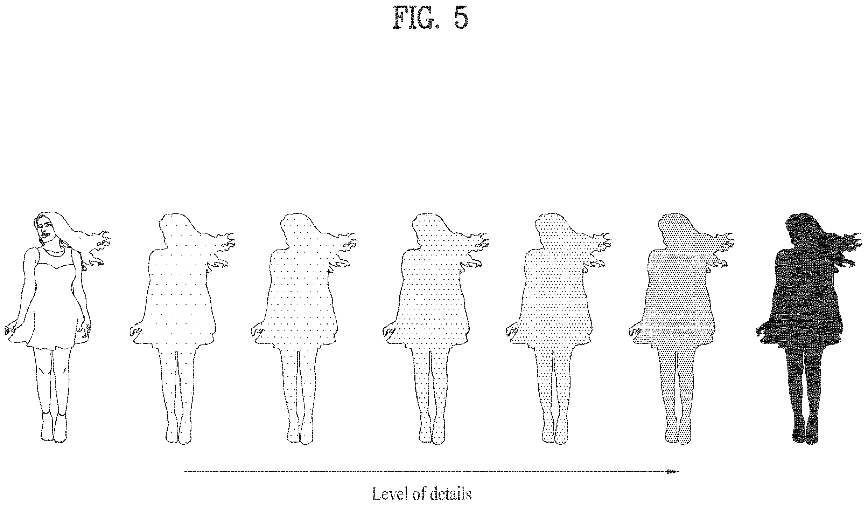

FIG. 5 illustrates an example of point configuration in each LOD according to embodiments.

As described with reference to FIGS. 1 to 4, encoded geometry is reconstructed (decompressed) before attribute encoding is performed. When direct coding is applied, the geometry reconstruction operation may include changing the placement of direct coded points (e.g., placing the direct coded points in front of the point cloud data). When trisoup geometry encoding is applied, the geometry reconstruction process is performed through triangle reconstruction, up-sampling, and voxelization. Since the attribute depends on the geometry, attribute encoding is performed based on the reconstructed geometry.

The point cloud encoder (e.g., the LOD generator 30009) may classify (or reorganize) points by LOD. The figure shows the point cloud content corresponding to LODs. The leftmost picture in the figure represents original point cloud content. The second picture from the left of the figure represents distribution of the points in the lowest LOD, and the rightmost picture in the figure represents distribution of the points in the highest LOD. That is, the points in the lowest LOD are sparsely distributed, and the points in the highest LOD are densely distributed. That is, as the LOD rises in the direction pointed by the arrow indicated at the bottom of the figure, the space (or distance) between points is narrowed.

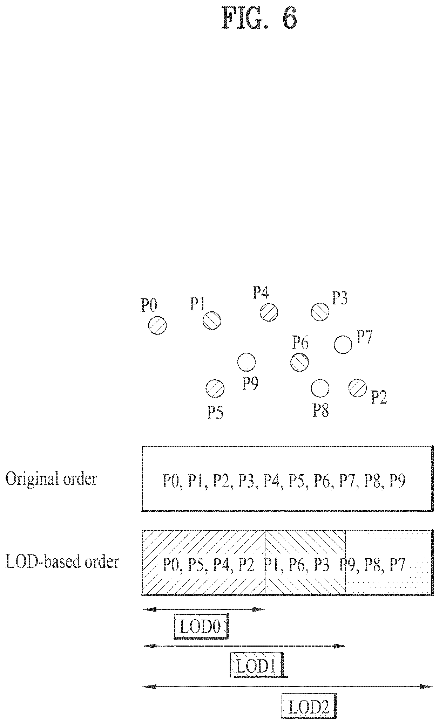

FIG. 6 illustrates an example of point configuration for each LOD according to embodiments.

As described with reference to FIGS. 1 to 5, the point cloud content providing system, or the point cloud encoder (e.g., the point cloud video encoder 10002, the point cloud encoder of FIG. 3, or the LOD generator 30009) may generates an LOD. The LOD is generated by reorganizing the points into a set of refinement levels according to a set LOD distance value (or a set of Euclidean distances). The LOD generation process is performed not only by the point cloud encoder, but also by the point cloud decoder.

The upper part of FIG. 6 shows examples (P0 to P9) of points of the point cloud content distributed in a 3D space. In FIG. 6, the original order represents the order of points P0 to P9 before LOD generation. In FIG. 6, the LOD based order represents the order of points according to the LOD generation. Points are reorganized by LOD. Also, a high LOD contains the points belonging to lower LODs. As shown in FIG. 6, LOD0 contains P0, P5, P4 and P2. LOD1 contains the points of LOD0, P1, P6 and P3. LOD2 contains the points of LOD0, the points of LOD1, P9, P8 and P7.

As described with reference to FIG. 3, the point cloud encoder according to the embodiments may perform prediction transform coding, lifting transform coding, and RAHT transform coding selectively or in combination.

The point cloud encoder according to the embodiments may generate a predictor for points to perform prediction transform coding for setting a predicted attribute (or predicted attribute value) of each point. That is, N predictors may be generated for N points. The predictor according to the embodiments may calculate a weight (=1/distance) based on the LOD value of each point, indexing information about neighboring points present within a set distance for each LOD, and a distance to the neighboring points.

The predicted attribute (or attribute value) according to the embodiments is set to the average of values obtained by multiplying the attributes (or attribute values) (e.g., color, reflectance, etc.) of neighbor points set in the predictor of each point by a weight (or weight value) calculated based on the distance to each neighbor point. The point cloud encoder according to the embodiments (e.g., the coefficient quantizer 30011) may quantize and inversely quantize the residuals (which may be called residual attributes, residual attribute values, attribute prediction residuals, or the like) obtained by subtracting a predicted attribute (or attribute value) of each point from the attribute (attribute value) of each point. The quantization process is shown in Tables 2 and 3 below.

[Table 2]

| int PCCQuantization(int value, int quantStep) { |
| --- |
| if( value >=0) { |
| return floor(value / quantStep + 1.0 / 3.0); |
| } else { |
| return -floor(-value / quantStep + 1.0 / 3.0); |
| } |
| } |

[Table 3]

| int PCCInverseQuantization(int value, int quantStep) { |
| --- |
| if( quantStep ==0) { |
| return value; |
| } else { |
| return value * quantStep; |
| } |
| } |

When the predictor of each point has neighbor points, the point cloud encoder (e.g., the arithmetic encoder 30012) according to the embodiments may perform entropy coding on the quantized and inversely quantized residual values as described above. When the predictor of each point has no neighbor point, the point cloud encoder according to the embodiments (e.g., the arithmetic encoder 30012) may perform entropy coding on the attributes of the corresponding point without performing the above-described operation.

The point cloud encoder according to the embodiments (e.g., the lifting transformer 30010) may generate a predictor of each point, set the calculated LOD and register neighbor points in the predictor, and set weights according to the distances to neighbor points to perform lifting transform coding. The lifting transform coding according to the embodiments is similar to the above-described prediction transform coding, but differs therefrom in that weights are cumulatively applied to attribute values. The process of cumulatively applying weights to the attribute values according to embodiments is configured as follows.

1) Create an array Quantization Weight (QW) for storing the weight value of each point. The initial value of all elements of QW is 1.0. Multiply the QW values of the predictor indexes of the neighbor nodes registered in the predictor by the weight of the predictor of the current point, and add the values obtained by the multiplication.

2) Lift prediction process: Subtract the value obtained by multiplying the attribute value of the point by the weight from the existing attribute value to calculate a predicted attribute value.

3) Create temporary arrays called updateweight and update and initialize the temporary arrays to zero.

4) Cumulatively add the weights calculated by multiplying the weights calculated for all predictors by a weight stored in the QW corresponding to a predictor index to the updateweight array as indexes of neighbor nodes. Cumulatively add, to the update array, a value obtained by multiplying the attribute value of the index of a neighbor node by the calculated weight.

5) Lift update process: Divide the attribute values of the update array for all predictors by the weight value of the updateweight array of the predictor index, and add the existing attribute value to the values obtained by the division.

6) Calculate predicted attributes by multiplying the attribute values updated through the lift update process by the weight updated through the lift prediction process (stored in the QW) for all predictors. The point cloud encoder (e.g., coefficient quantizer 30011) according to the embodiments quantizes the predicted attribute values. In addition, the point cloud encoder (e.g., the arithmetic encoder 30012) performs entropy coding on the quantized attribute values.

The point cloud encoder (for example, the RAHT transformer 30008) according to the embodiments may perform RAHT transform coding in which attributes of nodes of a higher level are predicted using the attributes associated with nodes of a lower level in the octree. RAHT transform coding is an example of attribute intra coding through an octree backward scan. The point cloud encoder according to the embodiments scans the entire region from the voxel and repeats the merging process of merging the voxels into a larger block at each step until the root node is reached. The merging process according to the embodiments is performed only on the occupied nodes. The merging process is not performed on the empty node. The merging process is performed on an upper node immediately above the empty node.

The equation below represents a RAHT transformation matrix. In the equation, $g_{1\ x,y,z}$ denotes the average attribute value of voxels at level l. $g_{l\ x,y,z}$ may be calculated based on $g_{l+1\ 2x,y,z}$ and $g_{l+1\ 2x+1,y,z}$. The weights for $g_{l\ 2x,y,z}$ and $g_{l\ 2x+1,y,z}$ are $w1 = w_{l\ 2x,y,z}$ and $w2 = w_{l\ 2x+1,y,z}$.

$$\begin{bmatrix} g_{l-1\ x,y,z} \\ h_{l-1\ x,y,z} \end{bmatrix} = T_{w1\ w2} \begin{bmatrix} g_{l\ 2x,y,z} \\ g_{l\ 2x+1,y,z} \end{bmatrix}, \quad T_{w1\ w2} = \frac{1}{\sqrt{w1+w2}} \begin{bmatrix} \sqrt{w1} & \sqrt{w2} \\ -\sqrt{w2} & \sqrt{w1} \end{bmatrix}$$

Here, $g_{l-1\ x,y,z}$ is a low-pass value and is used in the merging process at the next higher level. $h_{l-1\ x,y,z}$ denotes high-pass coefficients. The high.0000000000-pass coefficients at each step are quantized and subjected to entropy coding (e.g., encoding by the arithmetic encoder 40012). The weights are calculated as $w_{l-1x,y,z} = w_{l\ 2x,y,z} + w_{i2x+1,y,z}$. The root node is created through the $g_{1\ 0,0,0}$ and $g_{1\ 0,0,1}$ as follows.

$$\begin{bmatrix} gDC \\ h_{0_{0,0,0}} \end{bmatrix} = T_{w1000\ w1001} \begin{bmatrix} g_{1\ 0,0,0z} \\ g_{1_{0,0,1}} \end{bmatrix}$$

The value of gDC is also quantized and subjected to entropy coding like the high-pass coefficients.

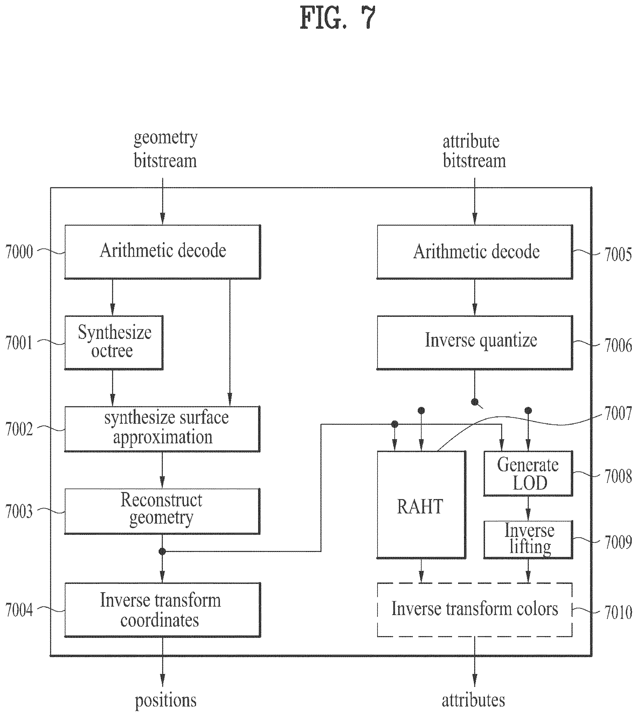

FIG. 7 illustrates a point cloud decoder according to embodiments.

The point cloud decoder illustrated in FIG. 7 is an example of the point cloud decoder and may perform a decoding operation, which is a reverse process to the encoding operation of the point cloud encoder illustrated in FIGS. 1 to 6.

As described with reference to FIGS. 1 and 6, the point cloud decoder may perform geometry decoding and attribute decoding. The geometry decoding is performed before the attribute decoding.

The point cloud decoder according to the embodiments includes an arithmetic decoder (Arithmetic decode) 7000, an octree synthesizer (Synthesize octree) 7001, a surface approximation synthesizer (Synthesize surface approximation) 7002, and a geometry reconstructor (Reconstruct geometry) 7003, a coordinate inverse transformer (Inverse transform coordinates) 7004, an arithmetic decoder (Arithmetic decode) 7005, an inverse quantizer (Inverse quantize) 7006, a RAHT transformer 7007, an LOD generator (Generate LOD) 7008, an inverse lifter (inverse lifting) 7009, and/or a color inverse transformer (Inverse transform colors) 7010.

The arithmetic decoder 7000, the octree synthesizer 7001, the surface approximation synthesizer 7002, and the geometry reconstructor 7003, and the coordinate inverse transformer 7004 may perform geometry decoding. The geometry decoding according to the embodiments may include direct decoding and trisoup geometry decoding. The direct coding and trisoup geometry decoding are selectively applied. The geometry decoding is not limited to the above-described example, and is performed as a reverse process to the geometry encoding described with reference to FIGS. 1 to 6.

The arithmetic decoder 7000 according to the embodiments decodes the received geometry bitstream based on the arithmetic coding. The operation of the arithmetic decoder 7000 corresponds to the reverse process to the arithmetic encoder 30004.

The octree synthesizer 7001 according to the embodiments may generate an octree by acquiring an occupancy code from the decoded geometry bitstream (or information on the geometry secured as a result of decoding). The occupancy code is configured as described in detail with reference to FIGS. 1 to 6.

When the trisoup geometry encoding is applied, the surface approximation synthesizer 7002 according to the embodiments may synthesize a surface based on the decoded geometry and/or the generated octree.

The geometry reconstructor 7003 according to the embodiments may regenerate geometry based on the surface and/or the decoded geometry. As described with reference to FIGS. 1 to 9, direct coding and trisoup geometry encoding are selectively applied. Accordingly, the geometry reconstructor 7003 directly imports and adds position information about the points to which direct coding is applied. When the trisoup geometry encoding is applied, the geometry reconstructor 7003 may reconstruct the geometry by performing the reconstruction operations of the geometry reconstructor 30005, for example, triangle reconstruction, up-sampling, and voxelization. Details are the same as those described with reference to FIG. 6, and thus description thereof is omitted. The reconstructed geometry may include a point cloud picture or frame that does not contain attributes.

The coordinate inverse transformer 7004 according to the embodiments may acquire positions of the points by transforming the coordinates based on the reconstructed geometry.

The arithmetic decoder 7005, the inverse quantizer 7006, the RAHT transformer 7007, the LOD generator 7008, the inverse lifter 7009, and/or the color inverse transformer 7010 may perform the attribute decoding. The attribute decoding according to the embodiments includes region adaptive hierarchical transform (RAHT) decoding, interpolation-based hierarchical nearest-neighbor prediction (prediction transform) decoding, and interpolation-based hierarchical nearest-neighbor prediction with an update/lifting step (lifting transform) decoding. The three decoding schemes described above may be used selectively, or a combination of one or more decoding schemes may be used. The attribute decoding according to the embodiments is not limited to the above-described example.

The arithmetic decoder 7005 according to the embodiments decodes the attribute bitstream by arithmetic coding.

The inverse quantizer 7006 according to the embodiments inversely quantizes the information about the decoded attribute bitstream or attributes secured as a result of the decoding, and outputs the inversely quantized attributes (or attribute values). The inverse quantization may be selectively applied based on the attribute encoding of the point cloud encoder.

According to embodiments, the RAHT transformer 7007, the LOD generator 7008, and/or the inverse lifter 7009 may process the reconstructed geometry and the inversely quantized attributes. As described above, the RAHT transformer 7007, the LOD generator 7008, and/or the inverse lifter 7009 may selectively perform a decoding operation corresponding to the encoding of the point cloud encoder.

The color inverse transformer 7010 according to the embodiments performs inverse transform coding to inversely transform a color value (or texture) included in the decoded attributes. The operation of the color inverse transformer 7010 may be selectively performed based on the operation of the color transformer 30006 of the point cloud encoder.

Although not shown in the figure, the elements of the point cloud decoder of FIG. 7 may be implemented by hardware including one or more processors or integrated circuits configured to communicate with one or more memories included in the point cloud providing device, software, firmware, or a combination thereof. The one or more processors may perform at least one or more of the operations and/or functions of the elements of the point cloud decoder of FIG. 7 described above. Additionally, the one or more processors may operate or execute a set of software programs and/or instructions for performing the operations and/or functions of the elements of the point cloud decoder of FIG. 7.

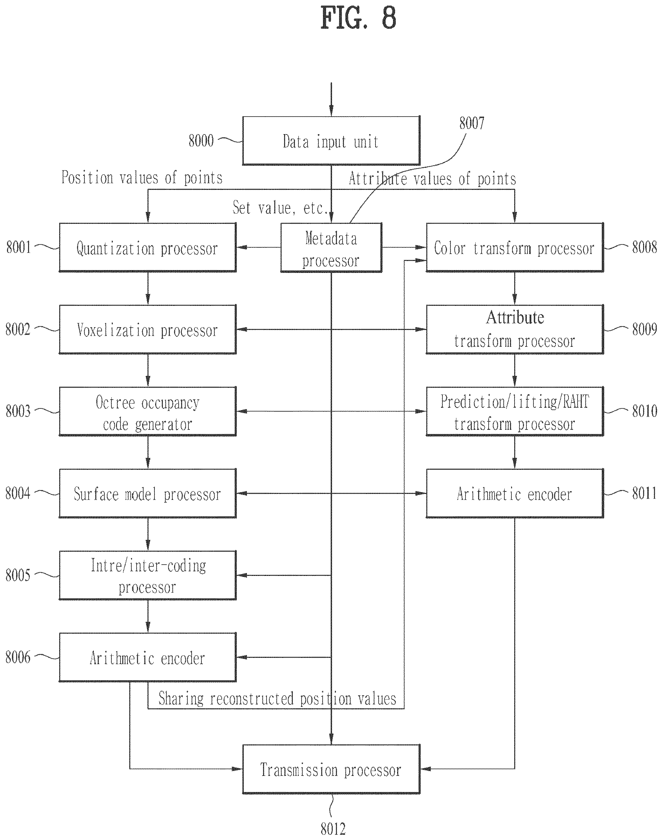

FIG. 8 illustrates a transmission device according to embodiments.

The transmission device shown in FIG. 8 is an example of the transmission device 10000 of FIG. 1 (or the point cloud encoder of FIG. 3). The transmission device illustrated in FIG. 8 may perform one or more of the operations and methods the same as or similar to those of the point cloud encoder described with reference to FIGS. 1 to 6. The transmission device according to the embodiments may include a data input unit 8000, a quantization processor 8001, a voxelization processor 8002, an octree occupancy code generator 8003, a surface model processor 8004, an intra/inter-coding processor 8005, an arithmetic coder 8006, a metadata processor 8007, a color transform processor 8008, an attribute transform processor 8009, a prediction/lifting/RAHT transform processor 8010, an arithmetic coder 8011 and/or a transmission processor 8012.

The data input unit 8000 according to the embodiments receives or acquires point cloud data. The data input unit 8000 may perform an operation and/or acquisition method the same as or similar to the operation and/or acquisition method of the point cloud video acquisition unit 10001 (or the acquisition process 20000 described with reference to FIG. 2).

The data input unit 8000, the quantization processor 8001, the voxelization processor 8002, the octree occupancy code generator 8003, the surface model processor 8004, the intra/inter-coding processor 8005, and the arithmetic coder 8006 perform geometry encoding. The geometry encoding according to the embodiments is the same as or similar to the geometry encoding described with reference to FIGS. 1 to 9, and thus a detailed description thereof is omitted.

The quantization processor 8001 according to the embodiments quantizes geometry (e.g., position values of points). The operation and/or quantization of the quantization processor 8001 is the same as or similar to the operation and/or quantization of the quantizer 30001 described with reference to FIG. 3. Details are the same as those described with reference to FIGS. 1 to 9.

The voxelization processor 8002 according to the embodiments voxelizes the quantized position values of the points. The voxelization processor 8002 may perform an operation and/or process the same or similar to the operation and/or the voxelization process of the quantizer 30001 described with reference to FIG. 3. Details are the same as those described with reference to FIGS. 1 to 6.

The octree occupancy code generator 8003 according to the embodiments performs octree coding on the voxelized positions of the points based on an octree structure. The octree occupancy code generator 8003 may generate an occupancy code. The octree occupancy code generator 8003 may perform an operation and/or method the same as or similar to the operation and/or method of the point cloud encoder (or the octree analyzer 30002) described with reference to FIGS. 3 and 4. Details are the same as those described with reference to FIGS. 1 to 6.

The surface model processor 8004 according to the embodiments may perform trisoup geometry encoding based on a surface model to reconstruct the positions of points in a specific region (or node) on a voxel basis. The surface model processor 8004 may perform an operation and/or method the same as or similar to the operation and/or method of the point cloud encoder (e.g., the surface approximation analyzer 30003) described with reference to FIG. 3. Details are the same as those described with reference to FIGS. 1 to 6.

The intra/inter-coding processor 8005 according to the embodiments may perform intra/inter-coding on point cloud data. The intra/inter-coding processor 8005 may perform coding the same as or similar to the intra/inter-coding. According to embodiments, the intra/inter-coding processor 8005 may be included in the arithmetic coder 8006.

The arithmetic coder 8006 according to the embodiments performs entropy encoding on an octree of the point cloud data and/or an approximated octree. For example, the encoding scheme includes arithmetic encoding. The arithmetic coder 8006 performs an operation and/or method the same as or similar to the operation and/or method of the arithmetic encoder 30004.

The metadata processor 8007 according to the embodiments processes metadata about the point cloud data, for example, a set value, and provides the same to a necessary processing process such as geometry encoding and/or attribute encoding. Also, the metadata processor 8007 according to the embodiments may generate and/or process signaling information related to the geometry encoding and/or the attribute encoding. The signaling information according to the embodiments may be encoded separately from the geometry encoding and/or the attribute encoding. The signaling information according to the embodiments may be interleaved.

The color transform processor 8008, the attribute transform processor 8009, the prediction/lifting/RAHT transform processor 8010, and the arithmetic coder 8011 perform the attribute encoding. The attribute encoding according to the embodiments is the same as or similar to the attribute encoding described with reference to FIGS. 1 to 6, and thus a detailed description thereof is omitted.

The color transform processor 8008 according to the embodiments performs color transform coding to transform color values included in attributes. The color transform processor 8008 may perform color transform coding based on the reconstructed geometry. The reconstructed geometry is the same as described with reference to FIGS. 1 to 9. Also, it performs an operation and/or method the same as or similar to the operation and/or method of the color transformer 30006 described with reference to FIG. 3 is performed. A detailed description thereof is omitted.

The attribute transform processor 8009 according to the embodiments performs attribute transformation to transform the attributes based on the reconstructed geometry and/or the positions on which geometry encoding is not performed. The attribute transform processor 8009 performs an operation and/or method the same as or similar to the operation and/or method of the attribute transformer 30007 described with reference to FIG. 3. A detailed description thereof is omitted. The prediction/lifting/RAHT transform processor 8010 according to the embodiments may code the transformed attributes by any one or a combination of RAHT coding, prediction transform coding, and lifting transform coding. The prediction/lifting/RAHT transform processor 8010 performs at least one of the operations the same as or similar to the operations of the RAHT transformer 30008, the LOD generator 30009, and the lifting transformer 30010 described with reference to FIG. 3. In addition, the prediction transform coding, the lifting transform coding, and the RAHT transform coding are the same as those described with reference to FIGS. 1 to 9, and thus a detailed description thereof is omitted.

The arithmetic coder 8011 according to the embodiments may encode the coded attributes based on the arithmetic coding. The arithmetic coder 8011 performs an operation and/or method the same as or similar to the operation and/or method of the arithmetic encoder 300012.

The transmission processor 8012 according to the embodiments may transmit each bitstream containing encoded geometry and/or encoded attributes or metadata information, or transmit one bitstream containing the encoded geometry and/or the encoded attributes and the metadata information. When the encoded geometry and/or the encoded attributes and the metadata information according to the embodiments are configured into one bitstream, the bitstream may include one or more sub-bitstreams. The bitstream according to the embodiments may contain signaling information including a sequence parameter set (SPS) for signaling of a sequence level, a geometry parameter set (GPS) for signaling of geometry information coding, an attribute parameter set (APS) for signaling of attribute information coding, and a tile parameter set (TPS) for signaling of a tile level, and slice data. The slice data may include information about one or more slices. One slice according to embodiments may include one geometry bitstream Geom00 and one or more attribute bitstreams Attr00 and Attr10.

A slice refers to a series of syntax elements representing the entirety or part of a coded point cloud frame.

The TPS according to the embodiments may include information about each tile (e.g., coordinate information and height/size information about a bounding box) for one or more tiles. The geometry bitstream may contain a header and a payload. The header of the geometry bitstream according to the embodiments may contain a parameter set identifier (geom_parameter_set_id), a tile identifier (geom_tile_id) and a slice identifier (geom _slice_id) included in the GPS, and information about the data contained in the payload. As described above, the metadata processor 8007 according to the embodiments may generate and/or process the signaling information and transmit the same to the transmission processor 8012. According to embodiments, the elements to perform geometry encoding and the elements to perform attribute encoding may share data/information with each other as indicated by dotted lines. The transmission processor 8012 according to the embodiments may perform an operation and/or transmission method the same as or similar to the operation and/or transmission method of the transmitter 10003. Details are the same as those described with reference to FIGS. 1 and 2, and thus a description thereof is omitted.

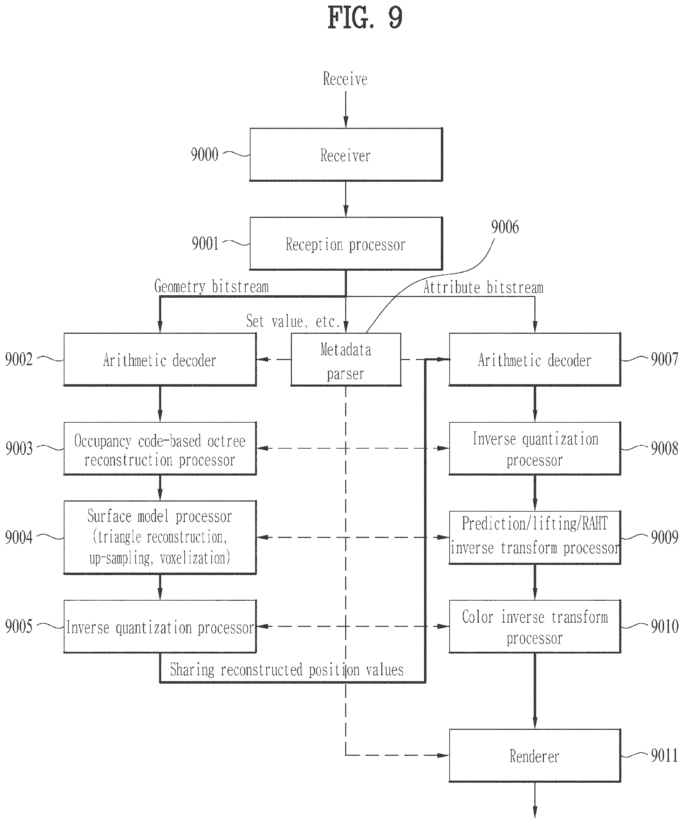

FIG. 9 illustrates a reception device according to embodiments.

The reception device illustrated in FIG. 9 is an example of the reception device 10004 of FIG. 1. The reception device illustrated in FIG. 9 may perform one or more of the operations and methods the same as or similar to those of the point cloud decoder described with reference to FIGS. 1 to 8.

The reception device according to the embodiment may include a receiver 9000, a reception processor 9001, an arithmetic decoder 9002, an occupancy code-based octree reconstruction processor 9003, a surface model processor (triangle reconstruction, up-sampling, voxelization) 9004, an inverse quantization processor 9005, a metadata parser 9006, an arithmetic decoder 9007, an inverse quantization processor 9008, a prediction/lifting/RAHT inverse transform processor 9009, a color inverse transform processor 9010, and/or a renderer 9011. Each element for decoding according to the embodiments may perform a reverse process to the operation of a corresponding element for encoding according to the embodiments.

The receiver 9000 according to the embodiments receives point cloud data. The receiver 9000 may perform an operation and/or reception method the same as or similar to the operation and/or reception method of the receiver 10005 of FIG. 1. The detailed description thereof is omitted.

The reception processor 9001 according to the embodiments may acquire a geometry bitstream and/or an attribute bitstream from the received data. The reception processor 9001 may be included in the receiver 9000.

The arithmetic decoder 9002, the occupancy code-based octree reconstruction processor 9003, the surface model processor 9004, and the inverse quantization processor 905 may perform geometry decoding. The geometry decoding according to embodiments is the same as or similar to the geometry decoding described with reference to FIGS. 1 to 8, and thus a detailed description thereof is omitted.

The arithmetic decoder 9002 according to the embodiments may decode the geometry bitstream based on arithmetic coding. The arithmetic decoder 9002 performs an operation and/or coding the same as or similar to the operation and/or coding of the arithmetic decoder 7000.

The occupancy code-based octree reconstruction processor 9003 according to the embodiments may reconstruct an octree by acquiring an occupancy code from the decoded geometry bitstream (or information about the geometry secured as a result of decoding). The occupancy code-based octree reconstruction processor 9003 performs an operation and/or method the same as or similar to the operation and/or octree generation method of the octree synthesizer 7001. When the trisoup geometry encoding is applied, the surface model processor 9004 according to the embodiments may perform trisoup geometry decoding and related geometry reconstruction (e.g., triangle reconstruction, up-sampling, voxelization) based on the surface model method. The surface model processor 9004 performs an operation the same as or similar to that of the surface approximation synthesizer 7002 and/or the geometry reconstructor 7003.

The inverse quantization processor 9005 according to the embodiments may inversely quantize the decoded geometry.

The metadata parser 9006 according to the embodiments may parse metadata contained in the received point cloud data, for example, a set value. The metadata parser 9006 may pass the metadata to geometry decoding and/or attribute decoding. The metadata is the same as that described with reference to FIG. 8, and thus a detailed description thereof is omitted.

The arithmetic decoder 9007, the inverse quantization processor 9008, the prediction/lifting/RAHT inverse transform processor 9009 and the color inverse transform processor 9010 perform attribute decoding. The attribute decoding is the same as or similar to the attribute decoding described with reference to at least one of FIGS. 1 to 8, and thus a detailed description thereof is omitted.

The arithmetic decoder 9007 according to the embodiments may decode the attribute bitstream by arithmetic coding. The arithmetic decoder 9007 may decode the attribute bitstream based on the reconstructed geometry. The arithmetic decoder 9007 performs an operation and/or coding the same as or similar to the operation and/or coding of the arithmetic decoder 7005.

The inverse quantization processor 9008 according to the embodiments may inversely quantize the decoded attribute bitstream. The inverse quantization processor 9008 performs an operation and/or method the same as or similar to the operation and/or inverse quantization method of the inverse quantizer 7006.

The prediction/lifting/RAHT inverse transform processor 9009 according to the embodiments may process the reconstructed geometry and the inversely quantized attributes. The prediction/lifting/RAHT inverse transform processor 9009 performs one or more of operations and/or decoding the same as or similar to the operations and/or decoding of the RAHT transformer 7007, the LOD generator 7008, and/or the inverse lifter 7009 of FIG. 7. The color inverse transform processor 9010 according to the embodiments performs inverse transform coding to inversely transform color values (or textures) included in the decoded attributes. The color inverse transform processor 9010 performs an operation and/or inverse transform coding the same as or similar to the operation and/or inverse transform coding of the color inverse transformer 7010 of FIG. 7. The renderer 9011 according to the embodiments may render the point cloud data.

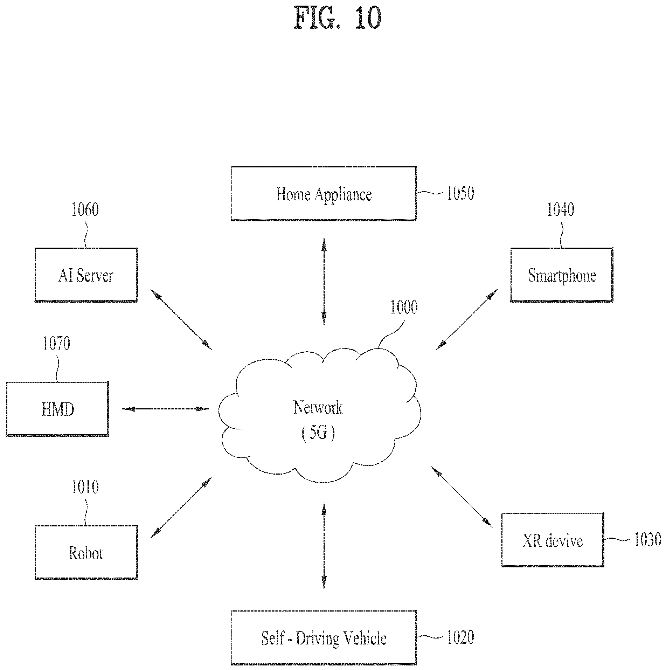

FIG. 10 illustrates an exemplary structure operable in connection with point cloud data transmission/reception methods/devices according to embodiments.

The structure of FIG. 10 represents a configuration in which at least one of a server 1060, a robot 1010, a self-driving vehicle 1020, an XR device 1030, a smartphone 1040, a home appliance 1050, and/or a head-mount display (HMD) 1070 is connected to the cloud network 1000. The robot 1010, the self-driving vehicle 1020, the XR device 1030, the smartphone 1040, or the home appliance 1050 is called a device. Further, the XR device 1030 may correspond to a point cloud data (PCC) device according to embodiments or may be operatively connected to the PCC device.

The cloud network 1000 may represent a network that constitutes part of the cloud computing infrastructure or is present in the cloud computing infrastructure. Here, the cloud network 1000 may be configured using a 3G network, 4G or Long Term Evolution (LTE) network, or a 5G network.

The server 1060 may be connected to at least one of the robot 1010, the self-driving vehicle 1020, the XR device 1030, the smartphone 1040, the home appliance 1050, and/or the HMD 1070 over the cloud network 1000 and may assist in at least a part of the processing of the connected devices 1010 to 1070.

The HMD 1070 represents one of the implementation types of the XR device and/or the PCC device according to the embodiments. The HMD type device according to the embodiments includes a communication unit, a control unit, a memory, an I/O unit, a sensor unit, and a power supply unit.

Hereinafter, various embodiments of the devices 1010 to 1050 to which the above-described technology is applied will be described. The devices 1010 to 1050 illustrated in FIG. 10 may be operatively connected/coupled to a point cloud data transmission device and reception device according to the above-described embodiments.

<PCC+XR>

The XR/PCC device 1030 may employ PCC technology and/or XR (AR+VR) technology, and may be implemented as an HMD, a head-up display (HUD) provided in a vehicle, a television, a mobile phone, a smartphone, a computer, a wearable device, a home appliance, a digital signage, a vehicle, a stationary robot, or a mobile robot.

The XR/PCC device 1030 may analyze 3D point cloud data or image data acquired through various sensors or from an external device and generate position data and attribute data about 3D points. Thereby, the XR/PCC device 1030 may acquire information about the surrounding space or a real object, and render and output an XR object. For example, the XR/PCC device 1030 may match an XR object including auxiliary information about a recognized object with the recognized object and output the matched XR object.

<PCC+XR+Mobile phone>

The XR/PCC device 1030 may be implemented as a mobile phone 1040 by applying PCC technology.

The mobile phone 1040 may decode and display point cloud content based on the PCC technology.

<PCC+Self-driving+XR>

The self-driving vehicle 1020 may be implemented as a mobile robot, a vehicle, an unmanned aerial vehicle, or the like by applying the PCC technology and the XR technology.

The self-driving vehicle 1020 to which the XR/PCC technology is applied may represent a self-driving vehicle provided with means for providing an XR image, or a self-driving vehicle that is a target of control/interaction in the XR image. In particular, the self-driving vehicle 1020 which is a target of control/interaction in the XR image may be distinguished from the XR device 1030 and may be operatively connected thereto.

The self-driving vehicle 1020 having means for providing an XR/PCC image may acquire sensor information from sensors including a camera, and output the generated XR/PCC image based on the acquired sensor information. For example, the self-driving vehicle 1020 may have an HUD and output an XR/PCC image thereto, thereby providing an occupant with an XR/PCC object corresponding to a real object or an object present on the screen.

When the XR/PCC object is output to the HUD, at least a part of the XR/PCC object may be output to overlap the real object to which the occupant's eyes are directed. On the other hand, when the XR/PCC object is output on a display provided inside the self-driving vehicle, at least a part of the XR/PCC object may be output to overlap an object on the screen. For example, the self-driving vehicle 1220 may output XR/PCC objects corresponding to objects such as a road, another vehicle, a traffic light, a traffic sign, a two-wheeled vehicle, a pedestrian, and a building.

The virtual reality (VR) technology, the augmented reality (AR) technology, the mixed reality (MR) technology and/or the point cloud compression (PCC) technology according to the embodiments are applicable to various devices.

In other words, the VR technology is a display technology that provides only CG images of real-world objects, backgrounds, and the like. On the other hand, the AR technology refers to a technology that shows a virtually created CG image on the image of a real object. The MR technology is similar to the AR technology described above in that virtual objects to be shown are mixed and combined with the real world. However, the MR technology differs from the AR technology in that the AR technology makes a clear distinction between a real object and a virtual object created as a CG image and uses virtual objects as complementary objects for real objects, whereas the MR technology treats virtual objects as objects having equivalent characteristics as real objects. More specifically, an example of MR technology applications is a hologram service.

Recently, the VR, AR, and MR technologies are sometimes referred to as extended reality (XR) technology rather than being clearly distinguished from each other. Accordingly, embodiments of the present disclosure are applicable to any of the VR, AR, MR, and XR technologies. The encoding/decoding based on PCC, V-PCC, and G-PCC techniques is applicable to such technologies.

The PCC method/device according to the embodiments may be applied to a vehicle that provides a self-driving service.

A vehicle that provides the self-driving service is connected to a PCC device for wired/wireless communication.

When the point cloud data (PCC) transmission/reception device according to the embodiments is connected to a vehicle for wired/wireless communication, the device may receive/process content data related to an AR/VR/PCC service, which may be provided together with the self-driving service, and transmit the same to the vehicle. In the case where the PCC transmission/reception device is mounted on a vehicle, the PCC transmission/reception device may receive/process content data related to the AR/VR/PCC service according to a user input signal input through a user interface device and provide the same to the user. The vehicle or the user interface device according to the embodiments may receive a user input signal. The user input signal according to the embodiments may include a signal indicating the self-driving service.

As described above, the point cloud content providing system may use one or more cameras (e.g., an infrared camera capable of securing depth information, an RGB camera capable of extracting color information corresponding to the depth information, etc.), a projector (e.g., an infrared pattern projector configured to secure depth information, etc.), LiDAR, and the like to generate point cloud content (or point cloud data).

LiDAR refers to equipment configured to measure the distance by measuring the time it takes for the irradiated light to reflect off a subject and return. It provides precise three-dimensional information about the real world as point cloud data over a wide area and long distance. Such large-volume point cloud data may be widely used in various fields where computer vision technology is employed, such as autonomous vehicles, robots, and 3D map production. That is, the LiDAR equipment uses a radar system configured to measure the coordinates of a position of a reflector by emitting a laser pulse and measuring the time it takes for the laser pulse to reflect on a subject (i.e., a reflector) in order to generate point cloud content. According to embodiments, the depth information may be extracted through the LiDAR equipment. The point cloud content generated through the LiDAR equipment may be composed of multiple frames, and the multiple frames may be integrated into one piece of content.

The LiDAR may consist of N lasers (or laser sensors) (where N=16, 32, 64, etc.) at different elevations $0(i)_{i=1,...,N}$, and the lasers may capture point cloud data while spinning along an azimuth $\varphi$ with respect to the Y axis. This type of LiDAR model is referred to as a spinning LiDAR model, and the point cloud content captured and generated by the spinning LiDAR model has angular characteristics.

The acquired (or captured) point cloud (or point cloud data) may be composed of a set of points, each of which may have geometry information and attribute information. As described above, the geometry information is 3D position (XYZ) information, and the attribute information is a color (RGB, YUV, etc.) and/or reflectance value.

According to embodiments, for data captured by spinning LiDAR equipment, compression efficiency may be increased by applying an angular mode in the geometry encoding/decoding process. The angular mode is a compression method based on $(r, \varphi, i)$ instead of $(x, y, z)$, where r denotes the radius, $\varphi$ denotes the azimuth or azimuthal angle, and i denotes the i-th laser (e.g., laser index) of the LiDAR. In other words, since the frames of the point cloud content generated using the LiDAR equipment are not stitched together, but are individual frames, each of which may have an origin of 0, 0, 0, the angular mode may be used by changing to the coordinate system to a spherical coordinate system.

During G-PCC encoding according to embodiments, the point cloud data may be split into tiles according to regions, and each tile may be split into slices for parallel processing. The G-PCC encoding may include compressing the geometry on a slice-by-slice basis, and compressing the attribute information based on the reconstructed geometry (decoded geometry) obtained based on the position information changed by the compression. An octree-based, predictive tree-based, or trisoup-based compression method may be used to compress the geometry information.

G-PCC decoding according to embodiments may include decoding the slice-wise geometry encoded and transmitted by the transmission device, and decoding the attribute information based on the geometry reconstructed through the decoding operation.

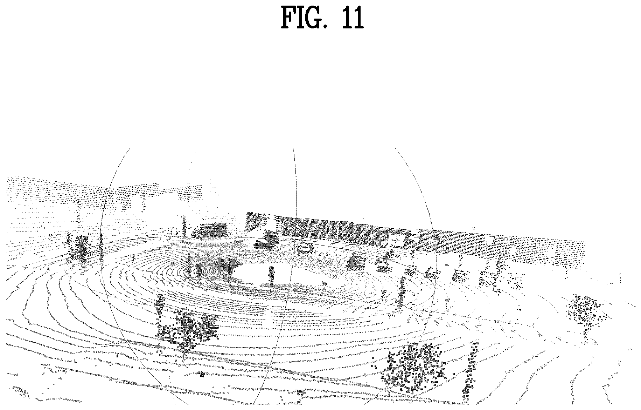

FIG. 11 is a diagram illustrating an example of point cloud data acquired using LiDAR equipment according to embodiments.

As shown in FIG. 11, point cloud content captured by LiDAR equipment on a moving vehicle may include both roads and objects. In other words, a street may include not only roads, but also many objects, such as trees, buildings, cars, and people. In the present disclosure, point cloud content may be referred to as point cloud data or a point cloud. There may be one or more objects. A plurality of objects may be referred to simply as objects or as an object group or an object block.

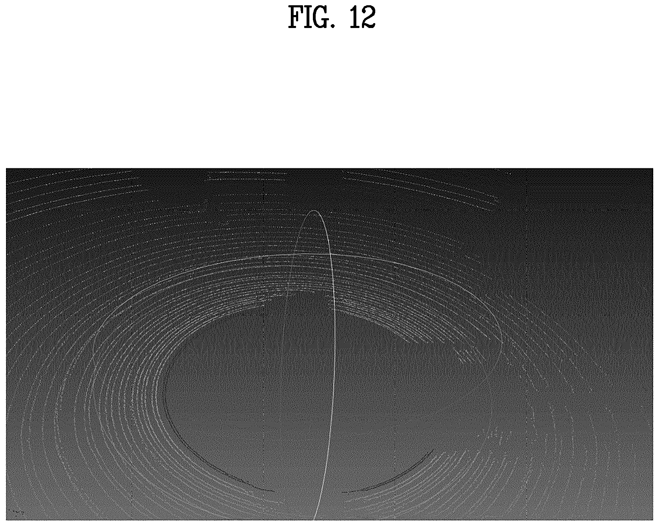

When a point cloud is configured by capturing consecutive frames, the characteristics of motion presented in the consecutive frames of points constituting a road may differ from the characteristics of motion presented in the consecutive frames of points constituting an object (or objects). In particular, in the case of a road captured by LiDAR capture equipment (or LiDAR equipment), the relative height from the LiDAR capture equipment may be constant. In this case, points may be generated in a shape of a circle around a center point, which is the location of the sensor, as shown in FIG. 12.

FIG. 12 is a diagram illustrating an example of points constituting a road captured by LiDAR equipment according to embodiments.

According to embodiments, when there are no objects except the road in point cloud frames captured by LiDAR equipment on a moving vehicle or when the relative height between the road and the center position of the sensor is constant, frames are always captured in a shape as shown in FIG. 12. For this reason, it is difficult to recognize the motion represented by the road points across consecutive frames. Furthermore, applying the motion generated by an object to the road may be meaningless, and may have an adverse effect, increasing bitstream size and thus lowering compression efficiency. Conversely, applying a motion predicted from the road to an object may lead to inaccurate motion prediction because the predicted motion is unlikely to be accurate.

Therefore, there may be a need for a method of separating (or distinguishing or classifying) the road and the object(s) from the point cloud content continuously captured by LiDAR equipment on a moving vehicle.

The present disclosure provides embodiments related to a method of separating a road and object from point cloud content to efficiently support compression of point cloud content captured by LiDAR equipment on a moving vehicle. The object may include one or more objects.

In particular, the present disclosure describes embodiments of methods for separating a road and an object from point cloud content to efficiently support intra-/inter-prediction of point cloud content captured by LiDAR equipment on a moving vehicle.

The present disclosure provides embodiments of a method of separating a road and an object from point cloud content based on the characteristics of the LiDAR equipment. For LiDAR equipment such as spinning LiDAR, the number of laser sensors in the LiDAR equipment, the angle of each laser sensor, the height, and the like are provided as input information. Roads and objects are separated from the point cloud content based on the input information described above.

The present disclosure provides embodiments of a method of applying the geometry information (also referred to as geometry or geometry data) related to the separated road and object to a predictive tree.

According to embodiments, a method such as octree-based geometry compression, a predictive tree-based geometry compression, or trisoup-based geometry compression may be used to compress the geometry information.

In other words, the most efficient method to compress point cloud content captured by spinning LiDAR equipment on a moving vehicle is to apply the geometry information to a predictive tree.

According to embodiments, the predictive tree-based geometry compression (or coding) includes generating a predictive tree, performing tree-based prediction, selecting the best mode, and performing encoding.

In particular, for point cloud content captured by the spinning LiDAR equipment, the angular mode may be enabled, which may provide better compression.

The prediction-based geometry information compression according to the embodiments is performed by defining a prediction structure for the point cloud data. This structure is represented by a predictive tree with vertices associated with each point in the point cloud data. The predictive tree may include a root vertex (referred to as a root point) and leaf vertices (referred to as leaf points), where points below the root point may have at least one child, and the depth increases towards the leaf points.

According to embodiments, the predictive tree may be generated as follows.

For each node, a recent node with the same laser index may be set as a parent node. If the parent node cannot be set in the predictive tree with the same laser index, the node with the minimum prediction residual among the nodes with a previous radar index may be set as the parent node.

FIG. 13(a) is a diagram illustrating an exemplary predictive tree when there are no objects in the point cloud data acquired using four lasers according to embodiments. That is, when there are no objects but a road in the point cloud frames captured by LiDAR equipment on a moving vehicle, a predictive tree may be generated in the form shown in FIG. 13-(a). This is because all lasers can reach the road.

As an example, in a predictive tree for frames acquired using a laser with a laser index of 3, node 50011 (or point) is a child of node 50012. That is, node 50012 is a parent of node 50011. Node 50013 is a grandparent of node 50011, and is a parent of node 50012. When a parent node cannot be set in the predictive tree with the same laser index (i.e., the laser index of 3), as in the case of node 50014, the node with the minimum prediction residual among the nodes with a different laser index (e.g., the previous laser index) may be set as the parent node. In FIG. 13-(a), node 50015 is one of the nodes in the predictive tree obtained using the laser whose laser index is 2, and is the node having the minimum prediction residual with respect to node 50014.

FIG. 13-(b) is a diagram illustrating an exemplary predictive tree when there are objects in the point cloud data acquired using four lasers according to embodiments.

In other words, there are many objects on the street, such as roads, trees, buildings, cars, and people. Accordingly, when the laser meets an object before reaching the road, the laser hit the object, and thus a predictive tree may be generated in the form shown in FIG. 13-(b).

That is, FIG. 13-(a) and 13-(b) show examples of predictive tree structures that may be generated when the angular mode is enabled. In FIG. 13-(a) and 13-(b), each node has as parent the latest node associated with the same laser index i. If a parent node is not available, the current node is not able to generate a prediction. If a parent node is not available, the current node would use a node with a previous laser index j with a minimum prediction residual as parent.

FIG. 14 is a diagram illustrating an example of points for each laser sensor according to embodiments. That is, FIG. 14 shows the shape of points with the same laser.

According to embodiments, the geometry predictive tree coding may include the following prediction mode-specific prediction computation method based on the generated predictive tree. For the current vertex in the predictive tree, P0 represents the position of the parent, p1 represents the position of the grandparent, and p2 represents the position of the grand-grandparent.

In other words, each point (or node) may be predicted by applying one of the various prediction modes based on the point positions of the parent, grandparent, grand-grandparent, and the like of a point.

For example, a prediction mode corresponding to 0 may be defined as no prediction, a prediction mode corresponding to 1 may be defined as delta prediction (p0), a prediction mode corresponding to 2 may be defined as linear prediction (2p0-p1), and a prediction mode corresponding to 3 may be defined as parallelogram prediction (2p+p1-p2).

This prediction method may be configured such that prediction is performed well if the relative distance difference between the parent/grandparent (parent's parent)/grand-grandparent (parent of the parent's parent) is regular based on the generated predictive tree. That is, the residual between the predicted position and the current position may be reduced.

However, as shown in FIG. 13-(b), the laser sensor may generate a zigzagging predictive tree by back and forth movement between the road and the object. In this case, the relative distance difference between the parent/grandparent/grand-grandparent may not be regular, which may increase the size of the compressed geometry bitstream to be transmitted.

Therefore, the present disclosure proposes a method of separating a road and an object to efficiently support compression of point cloud content captured by LiDAR equipment on a moving vehicle, and a method of efficiently performing geometry predictive tree coding based on the separated road and object. In other words, to reduce the zigzag shape of the predictive tree structure, the present disclosure proposes a method of separating a road and objects for geometry predictive tree coding.

According to embodiments, the separation of a road and an object in the point cloud content (i.e., point cloud data) may be performed by an encoder on the transmitting side or by a decoder on the receiving side. For example, in the case where the separation of the road and objects in the point cloud data is performed by the encoder on the transmitting side, this separation may be skipped on the receiving side. On the other hand, in the case where the separation of the road and the object in the point cloud data is performed by the decoder on the receiving side, the separation may be skipped on the transmitting side. According to embodiments, whether the separation of the road and the object from the point cloud data is to be performed by the encoder on the transmitting side or by the decoder on the receiving side may be indicated using signaling information, or may be determined based on the signaling information.

According to embodiments, the segmentation of a road and an object may be performed by the encoder on the transmitting side and the reconstruction operation may be performed differently for each of the road and objects by the decoder on the receiving side in the decoding process.

According to embodiments, it is assumed that the LiDAR equipment has multiple laser sensors, and that the laser ID of the laser sensor closest to the road has the greatest value, and that the laser ID and the radius of a captured road may decrease as the distance from the road (i.e., the elevation) increases. In other words, for content captured by the LiDAR equipment on a moving vehicle, as the value of laser ID increases (i.e., the laser sensor position is lowered), the radius of the captured road may increase (or decrease).

According to embodiments, the method of separating the road and the object may include estimating (or predicting) the height of the LiDAR sensors from the road (i.e., the distance from the road to the center of the sensors) and performing the separation based on the estimated (or predicted) height. According to embodiments, the present disclosure may classify the point(s) captured at the current laser ID as a road when they are present at a position at or below the estimated height value, and as an object when they are present at a higher position. Here, the object may include one or more objects, and may be referred to as an object group.

According to embodiments, when the road and object are separated from the point cloud data, a prediction unit may be constructed with the points separated as the road, and a prediction unit may be constructed with the points separated as the object (or object group). Then, inter- or intra-prediction may be performed on each prediction unit. Here, the prediction unit may be a largest prediction unit (LPU) and/or a prediction unit (PU). For simplicity, the LPU may be referred to as a first prediction unit and the PU as a second prediction unit.

According to embodiments, when the road and object are separated from the point cloud data, a first prediction unit may be constructed with the points separated as the road, and a first prediction unit may be constructed with the points separated as the object (or object group). Then, inter- or intra-prediction may be performed on each of the first prediction units.

According to embodiments, the first prediction unit constructed with the points of the object(s) may be further split into second prediction units. In other words, the first prediction unit composed of multiple objects may be split into second prediction units when the objects have different characteristics.

According to embodiments, global motion may be applied to the first prediction unit for inter-prediction, and local motion may be applied to the second prediction units for inter-prediction..

According to embodiments, global motion may be applied to the first prediction unit composed of the object(s) and may not be applied to the first prediction unit composed of the road.

Regarding intra-/inter-prediction according to embodiments, definitions of the following terms are described in the present disclosure.

1) I (Intra) frame; P (Predicted) frame; B (Bidirectional) frame.

A frame to be encoded/decoded may be divided into an I frame, a P frame, and a B frame. The frame may be referred to as a picture or the like.

For example, the frames may be transmitted in order of I frame → P frame → (B frame) → (I frame | P frame) →.... The B frame may be omitted.

2) Reference frame

A reference frame may be a frame involved in encoding/decoding a current frame.

The immediately preceding I frame or P frame referenced to encode/decode the current P frame may be referred to as a reference frame. An immediately preceding I frame or P frame and an immediately following I frame or P frame referenced to encode/decode the current B frame may be referred to as reference frames.

3) Frame and intra-prediction coding/inter-prediction coding

Intra-prediction coding may be performed on the I frame, and inter-prediction coding may be performed on the P frame and the B frame.

When the rate of change of a P frame with respect to the previous reference frame is greater than a specific threshold, intra-prediction coding may be performed on the P frame as in the case of the I frame.

4) Criteria for determining the I (intra) frame

Among multiple frames, every k-th frame may be designated as an I frame. Alternatively, scores related to a correlation between frames may be set and a frame having a higher score may be configured as an I frame.

5) Encoding/decoding of I frame

In encoding/decoding point cloud data having multiple frames, the geometry of the I frame may be encoded/-decoded based on an octree or a predictive tree. Then, the attribute information about the I frame may be encoded/decoded based on the predictive/lifting transform scheme or RAHT scheme based on the reconstructed geometry information. In the present disclosure, the geometry of the I frame may be encoded/decoded based on the predictive tree.

6) Encoding/decoding of P frames

In encoding/decoding point cloud data having multiple frames according to embodiments, the P frame may be encoded/decoded based on a reference frame.
In this case, the coding unit for inter-prediction of the P frame may be a frame, a tile, a slice, an LPU (also referred to as a first prediction unit), or a PU (also referred to as a second prediction unit).
Herein, a road and object may be separated from the point cloud data (or point cloud content) captured (or acquired) by LiDAR equipment, an LPU may be constructed with the points of the separated road, and a PU may be constructed with the points of the separated object(s). The point cloud data (or point cloud content) may be configured in frames, tiles or slices. In other words, point cloud content, frames, tiles, slices, and the like may be referred to as point cloud data. For example, the road and object may be separated from slice-level point cloud data, an LPU may be constructed with the points of the road, and an LPU may be constructed with the points of the object.
Hereinafter, embodiments related to separating a road and an object from frame-, tile-, or slice-level point cloud data will be described in detail.

Removing noise based on minimum radius

According to embodiments, noise may be removed before separating a road and an object from point cloud data.
For example, in the case of point cloud content captured by LiDAR equipment on a moving vehicle, a portion of the vehicle may be captured by sensors depending on the installation location.
FIG. 15 is a diagram illustrating an example of point cloud data captured by LiDAR equipment according to embodiments.
As shown in FIG. 15, the center of the LiDAR equipment is captured as the origin (0,0,0), and there are points 50020 within a specific radius. These points may be an object, or mainly a portion of a vehicle carrying the LiDAR equipment.
In one embodiment, the points 50020 within the specific radius may be considered as noise and removed.
In another embodiment, the points 50020 within the specific radius may be considered as a road. The points 50020 may be separated as a road in separating the road and objects. This is because, similar to the road, motion may always appear uniform across consecutive frames.
To identify the points 50020 that are within the specific radius, a minimum radius may be input and set or may be calculated and set. Then, points within the set radius may be considered as noise or a road. For example, when considered as noise, the points are removed before separating the road and the object from the point cloud data.
According to embodiments, the method of separating a road and an object may be based on predicting the location of a laser sensor with a specific laser ID (laserID). Here, the laserID is identification information for identifying each laser (or laser sensor), and may represent a laser index. The laser sensor may be referred to as a capture sensor.
In other words, for point cloud content captured by LiDAR equipment on a moving vehicle, when the height of the capture sensor (i.e., the laser sensor) from a road and the laserID of the selected sensor are given, the road and the object may be separated from the point cloud data based on the given information. When the information is not given, the height of the sensor from the road may be predicted using the following method, and the road and the object may be separated based on the predicted information.
According to embodiments, the LiDAR equipment may include multiple sensors (referred to as laser sensors or capture sensors), and angle ($\theta$) information and height (z) information about each sensor may be provided. Here, the angle $\theta$ may be the angle at which the corresponding laser sensor faces downward (e.g., toward the ground).
According to embodiments, for point cloud content captured by LiDAR equipment on a moving vehicle, as the laserID increases (i.e., the laser sensor position is lowered as shown in FIG. 16), the radius of the road captured by the corresponding laser sensor may increase.
In this case, the sensor having the smallest angle $\theta$ (i.e., the sensor with the greatest negative angle) may be selected, as shown in FIG. 16 (Select the sensor has the smallest $\theta$). This is because the closest road will be captured at the smallest angle $\theta$, and may be highly likely to be free of objects.
Then, the radius of points captured with the selected sensor may be found (Find the radius of points captured with the sensor). In this operation, at least one of a maximum radius, a minimum radius, or an average radius may be used. In some embodiments, the radius may be calculated or acquired by removing noise based on the minimum radius.

Once the radius is found, the height from the road to the center of the sensors may be estimated based on the radius, the angle of the selected sensor, and the height from the center of the sensors to the selected sensor.

FIG. 16 is a diagram illustrating an example of laser sensors and angle θ according to embodiments.

In FIG. 16, laser sensor 50031 with laser index equal 0 is an example of a sensor with the greatest negative angle.

FIG. 17 is a diagram illustrating an exemplary position estimation method according to embodiments.

In FIG. 17, θ denotes an angle of a sensor in the LiDAR equipment, and z denotes a height of a sensor in the LiDAR equipment. For example, θ[i] denotes an angle of an i-th laser sensor in the LiDAR equipment, and z[i] denotes a height from the center of sensors in the LiDAR equipment to the i-th laser sensor.

For example, referring to FIGS. 16 and 17, z denotes the height from the center (0,0,0) 50033 of sensors to a laser sensor 50031 in the LiDAR equipment. In other words, in FIG. 17, 50031 represents the laser sensor with the greatest negative angle among the laser sensors, and 50033 represents the center of the laser sensors. Also, θ denotes the angle of the laser sensor 50031 in angular theta degrees, and z denotes the height of the laser sensor 50031 as angular z.

In FIG. 17, height may be referred to as a base height.

In some embodiments, the relative distance of the center position of the LiDAR equipment from the road may be input as the base height. Alternatively, the relative distance (height) may be calculated based on the sensor with the smallest angle θ (i.e., the sensor with the greatest negative angle) 50031.

In the present disclosure, the base height may be predicted using Equation 1 given below (estimated_height).

[Equation 1]

$$estimated\_height = -(radius * tan(sensor.\theta) - sensor.z) + \alpha$$

In the equation above, α may be a constant for error correction.

In the present disclosure, estimated_height may be referred to as a predicted height, an estimated height, or a base height. In other words, in the present disclosure, the LiDAR sensor height from the road may be estimated using Equation 1 above to separate the road from the object. In the present disclosure, estimated_height refers to the base height, which is the distance from the road to the center (0,0,0) of the laser sensors.

According to embodiments, when the position of a point is at or lower than the estimated_height, the point may be considered (or separated) as a road. Also, when the position of the point is higher than the estimated_height, the point may be considered (or separated) as an object. That is, if the z-position of the point is below the estimated height, the point may be classified as a road. Otherwise, it may be classified as an object (or object region).

Next, a method of generating a predictive tree based on a separated road and object will be described. The predictive tree may be used for intra- or inter-prediction of geometry information (i.e., points).

According to embodiments, the point cloud encoder of the transmission device may generate a predictive tree for predictive tree coding of geometry information. The predictive tree may be configured as a single tree based on a maximum number of points. However, in the case where a road and an object are connected as a parent/child, they may be connected in a zigzag manner, which may result in a loss of consistency.

Therefore, in the present disclosure, a predictive tree may be constructed by dividing the single tree into a road portion and an object portion. In other words, a first predictive tree may be constructed with points separately classified as a road in the single predictive tree, and a second predictive tree may be constructed with points separately classified as an objects.

FIG. 18-(a) is a diagram illustrating an exemplary predictive tree using point cloud data that is not separated into a road and an object.

FIG. 18-(b) is a diagram illustrating an exemplary case where the points in the point cloud data are separated into a road and an object, and then predictive trees are constructed with the points belonging to the road and the points belonging to the object, respectively.

FIG. 19-(a) is a diagram illustrating an exemplary predictive tree using point cloud data that is not separated into a road and an object. In other words, FIG. 18-(a) and FIG. 19-(a) illustrate the same tree.

FIG. 19-(b) is a diagram illustrating an exemplary case where the points in the point cloud data are separated into a road and an object, and then predictive trees are constructed with the points belonging to the road and the points belonging to the object, respectively, and are then connected to each other.

That is, the predictive tree 50041 for the road portion and the predictive tree 50042 for the object portion may not be connected, as shown in FIG. 18-(b), or may be connected, as shown in FIG. 19-(b).

In embodiments, the predictive tree 50041 for the road portion and the predictive tree 50042 for the object portion may be connected by finding and connecting a point 50043 in the predictive tree 50041 for the road portion that is closest to the first point in the predictive tree 50042 for the object portion.

Next, a method of searching for inter-prediction reference points based on the separated road and object in performing inter-prediction, i.e., a method of searching for reference points for inter-prediction.

In a geometry predictive tree coding method, points having a similar azimuth may be selected from among the points having the same laser ID as the current point in the reference frame as reference points for inter-prediction and used as predicted values.

According to embodiments, when the points in the point cloud data are separated into a road and an object, the reference frame may also be separated into a road and an object in searching for reference points for inter-prediction.

For example, when the current point is a road, points having similar azimuth values may be selected from among the points having the same laserID among the points in a road reference point region in the reference frame as reference points and used as predicted values. In other words, when a point in the current frame is positioned in the road region, reference points may be searched for in the road region in the reference frame.

For example, when the current point belongs to an object (or an object region), points having similar azimuth values may be selected from among the points having the same laserID among the points in the object reference point region in the reference frame as reference points and used as predicted values. In other words, when a point in the current frame is classified as an object, the points in the object region in the reference frame may be searched for reference points.

FIG. 20 is a diagram illustrating another exemplary point cloud transmission device according to embodiments.

The point cloud transmission device according to the embodiments may include a data input unit 51001, a coordinate transformer 51002, a quantization processor 51003, a spatial partitioner 51004, a signaling processor 51005, a geometry encoder 51006, an attribute encoder 51007, and a transmission processor 51008. According to embodiments, the coordinate transformer 51002, the quantization processor 51003, the spatial partitioner 51004, the geometry encoder 51006, and the attribute encoder 51007 may be referred to as a point cloud video encoder.

The point cloud data transmission device of FIG. 20 may correspond to the transmission device 10000 of FIG. 1, the point cloud video encoder 10002 of FIG. 1, the transmitter 10003 of FIG. 1, the acquisition 20000/encoding 20001/transmission 20002 of FIG. 2, the point cloud video encoder of FIG. 3, the transmission device of FIG. 8, the device of FIG. 10, and the like. Each of the components in FIG. 20 and the corresponding figures may correspond to software, hardware, a processor connected to a memory, and/or a combination thereof.

The data input unit 51001 may perform some or all of the operations of the point cloud video acquisition unit 10001 of FIG. 1, or may perform some or all of the operations of the data input unit 8000 of FIG. 8. The coordinate transformer 51002 may perform some or all of the operations of the coordinate transformer 30000 of FIG. 3. Further, the quantization processor 51003 may perform some or all of the operations of the quantizer 30001 of FIG. 3, or may perform some or all of the operations of the quantization processor 8001 of FIG. 8. That is, the data input unit 51001 may receive data to encode the point cloud data. The data may include geometry data (which may be referred to as geometry, geometry information, etc.), attribute data (which may be referred to as an attribute, attribute information, etc.), and parameter information indicating coding-related settings.

The coordinate transformer 51002 may support coordinate transformation of the point cloud data, such as changing the xyz axes or transforming a Cartesian coordinate system $(x, y, z)$ to a spherical coordinate system $(r, \varphi, i)$.

The quantization processor 51003 may quantize the point cloud data. For example, it may adjust the compression rate of the point cloud data by multiplying the x, y, and z position values of the point cloud data by a scale according to a scale setting (scale=geometry quantization value). The scale may conform to a set value or may be included in the bitstream as parameter information and delivered to the receiving side.

The spatial partitioner 51004 may spatially partition the point cloud data quantized and output by the quantization processor 51003 into one or more 3D blocks based on a bounding box and/or a sub-bounding box. For example, the spatial partitioner 51004 may partition the quantized point cloud data into tiles or slices for region-by-region access to content or parallel processing. In one embodiment, the signaling information for spatial partitioning is entropy-encoded by the signaling processor 51005 and then transmitted through the transmission processor 51008 in the form of a bitstream.

In one embodiment, the point cloud content may be one person such as an actor, multiple people, one object, or multiple objects. In a broader sense, it may be a map for self-driving or a map for indoor navigation of a robot. In this case, the point cloud content may be a vast amount of locally connected data. In this case, the point cloud content cannot be encoded/decoded at once, and accordingly tile partitioning may be performed before the point cloud content is compressed. For example, room #101 in a building may be partitioned into one tile and room #102 in the building may be partitioned into another tile. In order to apply parallelization to the partitioned tiles to support fast encoding/decoding, the tiles may be partitioned (or split) into slices again. This operation may be referred to as slice partitioning (or splitting).

That is, a tile may represent a partial region (e.g., a rectangular cube) of a 3D space occupied by point cloud data according to embodiments. According to embodiments, a tile may include one or more slices. The tile according to the embodiments may be partitioned into one or more slices, and thus the point cloud video encoder may encode point cloud data in parallel.

A slice may represent a unit of data (or bitstream) that may be independently encoded by the point cloud video encoder according to the embodiments and/or a unit of data (or bitstream) that may be independently decoded by the point cloud video decoder. A slice may be a set of data in a 3D space occupied by the point cloud data, or a set of some data among the point cloud data. A slice according to the embodiments may represent a region or set of points included in a tile according to the embodiments. According to embodiments, a tile may be partitioned into one or more slices based on the number of points included in one tile. For example, one tile may be a set of points partitioned according to the number of points. According to embodiments, a tile may be partitioned into one or more slices based on the number of points, and some data may be split or merged in the partitioning process. That is, a slice may be a unit that may be independently coded in the tile. A tile obtained by spatial partitioning in this way may be partitioned into one or more slices for fast and efficient processing.

The point cloud video encoder according to the embodiments may encode the point cloud data on a slice-by-slice basis, or a tile-by-tile basis, or a frame-by-frame basis, wherein a tile includes one or more slices, and a frame includes one or more tiles. Further, the point cloud video encoder according to the embodiments may perform different quantization and/or transformation on a tile-by-tile or slice-by-slice basis.

The positions of the one or more 3D blocks (e.g., slices) spatially partitioned by the spatial partitioner 51004 are output to the geometry encoder 51006, and the attribute information (or attributes) is output to the attribute encoder 51007. The positions may be position information about the points contained in a partitioned unit (box, block, tile, tile group, or slice), and may be referred to as geometry information.

The geometry encoder 51006 performs inter- or intra-prediction-based encoding on the positions output from the spatial partitioner 51004 to output a geometry bitstream. In this case, for prediction-based encoding of a P frame, the geometry encoder 51006 may separate a road and an object from frame-level, tile-level or slice-level point cloud data by applying the road and object separation method described above to the frame-level, tile-level or slice-level point cloud data. Then, after constructing a predictive tree for each of the road portion and object portion, the encoder may compress the geometry information using intra-prediction or inter-prediction. When the inter-prediction is used, the geometry encoder 51006 may further perform the following operation before constructing the predictive trees: constructing LPUs with the points of the separated road and the points of the object(s), respectively. In some embodiments, a predicted motion may be applied to the LPU including the points classified as the road. The predicted motion (e.g., global motion) may be applied only to the LPU including the points classified as the object(s). In other embodiments, whether to apply the predicted motion to the LPU including the points of the road and/or the LPU including the points of the object(s) may be determined through rate distortion optimization (RDO), and the motion may be applied to the reference frame based on the determination. In other words, it may be predicted through RDO whether it is beneficial to apply a motion vector within the LPU including the points of the road and/or the LPU including the points of the object(s), and the result of the prediction may be signaled. In one embodiment, the motion vector may be a global motion vector. The motion vector may be a local motion vector. Further, the motion vector may be both a global motion vector and a local motion vector. Also, whether it is beneficial to apply the motion vector may be determined by comparing a bitstream size or the like given when the motion vector is applied. Furthermore, the global motion vector may be obtained by estimating the overall motion across frames. According to embodiments, based on the LPU including the points of the objects, PUs may be configured for the respective objects. The local motion vector may then be applied to the PUs. The geometry encoder 51006 may reconstruct the encoded geometry information and output the reconstructed information to the attribute encoder 51007.

The attribute encoder 51007 encodes (i.e., compresses) the attributes output from the spatial partitioner 51004 (e.g., partitioned attribute source data) based on the reconstructed geometry output from the geometry encoder 51006 and outputs an attribute bitstream.

FIG. 21 is a diagram illustrating exemplary operations of the geometry encoder 51006 and the attribute encoder 51007 according to embodiments.

In one embodiment, a quantization processor may be further provided between the spatial partitioner 51004 and the voxelization processor 53001. The quantization processor quantizes positions of one or more 3D blocks (e.g., slices) spatially partitioned by the spatial partitioner 51004. In this case, the quantization processor may perform some or all of the operations of the quantizer 30001 of FIG. 3, or perform some or all of the operations of the quantization processor 8001 of FIG. 8. When the quantization processor is further provided between the spatial partitioner 51004 and the voxelization processor 53001, the quantization processor 51003 of FIG. 20 may or may not be omitted.

The voxelization processor 53001 according to the embodiments performs voxelization based on the positions of the one or more spatially partitioned 3D blocks (e.g., slices) or the quantized positions thereof. Voxelization refers to the minimum unit expressing position information in a 3D space. That is, the voxelization processor 53001 may support the process of rounding the geometry position values of the scaled points to integers. Points of point cloud content (or 3D point cloud video) according to embodiments may be included in one or more voxels. According to embodiments, one voxel may include one or more points. In one embodiment, in the case where quantization is performed before the voxelization, multiple points may belong to one voxel.

In the present disclosure, when two or more points are included in one voxel, the two or more points are referred to as duplicated points. That is, in the geometry encoding process, duplicated points may be generated through geometry quantization and voxelization.

The voxelization processor 53001 may output duplicated points belonging to one voxel without merging the points, or may merge the duplicated points into one point to be output.

According to embodiments, the points partitioned into tiles, slices or frames by the spatial partitioner 51004 are voxelized by the voxelization processor 53001, and the voxelized points are separated into a road or an object by a road/object splitter 53002.

For example, as shown in FIG. 16, it is assumed that the LiDAR equipment has multiple laser sensors, and that the laser ID of the laser sensor closest to the road has the greatest value, and that the laser ID and the radius of a captured road may decrease as the distance from the road (i.e., the elevation) increases. In this case, for content captured by the LiDAR equipment on a moving vehicle, the radius of the captured road may increase as the value of the laser ID increases (namely, the laser sensor position is lowered).

According to embodiments, the road/object splitter 53002 may estimate (or predict) the height of a LiDAR sensor from the road based on Equation 1 and classify each of the voxelized points as a road or an object based on the estimated (or predicted) height (estimated_height). According to embodiments, the road/object splitter 53002 may classify the point(s) as a road when the position of the voxelized point(s) captured at the current laserID is lower than or equal to estimated_height, and classify the point(s) as an object when the position is higher than estimated_height. In order to find estimated_height for road/object separation by applying Equation 1, the road/object splitter 53002 may be provided with information indicating whether a road/object is separated, a height error value, the angle θ of the sensors, the z value of the sensors, the radius of the sensors, and the like. Then, the estimated_height for road/object separation found by applying Equation 1 may be transmitted to the receiving side. Here, the object may include one or more objects, which may be referred to as an object group. The z value denotes the height from the center of the sensors in the LiDAR equipment to the corresponding laser sensor. In another embodiment of the present disclosure, the height of a LiDAR sensor from the road may be directly input.

According to embodiments, in order to separate the road and the object as described above, the road/object segmentation section 53002 may receive as input road/object splitting and prediction-related option information. According to embodiments, the road/object splitting and prediction-related option information may include information indicating whether to split the road/object (road_object_split_flag), estimated height information for road/object separation (estimated_height), or information for estimating base height information (e.g., the angle θ of the sensors, the z value of the sensors, the radius of the sensors). According to embodiments, the road/object splitting and prediction-related option information may further include information for identifying each object (object_id). The road/object splitting and prediction-related option information may be included in at least one of a geometry parameter set, a tile parameter set (also referred to as a tile inventory), or a geometry slice header and transmitted to the point cloud decoder on the receiving side. Further, the road/object splitting and prediction-related option information may be included in at least one of a geometry LPU header or a geometry PU header and transmitted to the point cloud decoder on the receiving side.

For example, when the value of the information indicating whether to split the road/object is TRUE, the road/object splitter 53002 may split the points in the frame-level, tile-level, or slice-level point cloud data into a road and objects by applying the capture sensor position prediction method described above.

When the frame of the input point cloud data (i.e., the frame to which the input points belong) is an I frame, a geometry information intra-predictor 53004 according to embodiments may apply geometry intra-prediction coding to the geometry information about the I frame. According to embodiments, when the points have been classified into a road and an object by the road/object splitter 53002, the geometry information intra-predictor 53004 may divide a single predictive tree into a road portion and an object portion to construct predictive trees for the portions. For example, it may first construct a first predictive tree with the points classified as the road, and then construct a second predictive tree with the points classified as the object. In this case, the predictive tree for the road portion and the predictive tree for the object portion may not be connected, as shown in FIG. 18-(b), or may be connected, as shown in FIG. 19-(b). According to embodiments, to connect the predictive tree for the road portion and the predictive tree for the object portion, a point closest to the first point in the predictive tree for the object portion may be found in the predictive tree for the road portion and connected to the first point.

According to embodiments, once a predictive tree as shown in FIG. 18-(b) or 19-(b) is generated by the geometry information intra-predictor 53004, each point may be predicted based on the positions of the parent, grand-parent, grand-grandparent, and the like of the point by applying one of the four intra-prediction modes (e.g., intra-prediction mode 0 to intra-prediction mode 3).

According to embodiments, intra-prediction mode 0 is a mode in which no prediction is performed and is referred to as no prediction. In other words, when intra-prediction mode 0 is selected, the position value (i.e., coordinate value) of the current point is transmitted uncompressed.

Intra-prediction mode 1 is a mode in which the position value (i.e., coordinate value) of the parent node (or parent point) p0 of the current point is set as a predicted value. This mode is called delta prediction. The residual (or residual position value) of intra-prediction mode 1 is obtained by subtracting the predicted value of intra-prediction mode 1 from the position value of the current point.

Intra-prediction mode 2 is a mode in which the position value of the parent node (or parent point) p0 of the current point multiplied by 2 minus the position value of the grandparent node (or grandparent point) p1 of the current point (=2p0-p1) is set as the predicted value. This mode is called linear prediction. Then, the residual (or residual position value) of intra-prediction mode 2 is obtained by subtracting the predicted value of intra-prediction mode 2 from the position value of the current point.

Intra-prediction mode 3 is a mode in which the position value of the parent node (or parent point) p0 plus the position value of the grandparent node (or grandparent point) p1 minus the position value of the grand-grandparent node (or grand-grandparent point) p2 (=p0+p1-p2) is set as the predicted value. This mode is called parallelogram prediction. Then, the residual (or residual position value) of intra-prediction mode 3 is obtained by subtracting the predicted value of intra-prediction mode 3 from the position value of the current point.

In other words, each point may be predicted based on the point positions of the parent, grandparent, grand-grandparent, and the like of the point by applying one of various intra-prediction modes (e.g., intra-prediction mode 0 to intra-prediction mode 3).

To this end, the element indicated by 53003 (also referred to as a determination part) checks whether the points output from the voxelization processor 53001 or the points separated into a road and an object by the road/object splitter 53002 belong to an I frame or a P frame.

When the frame identified by the determination part 53003 is a P frame, and the points in the frame-level, tile-level or slice-level point cloud data have been separated into a road and objects by the road/object splitter 53002, the LPU splitter 53005 constructs an LPU with the points belonging to the road and an LPU with the points belonging to the object(s) to support inter-prediction. Then, for each LPU, information indicating whether the LPU is a road or an object (or an object group) may be signaled in road/object splitting and prediction-related option information to be transmitted to the decoder on the receiving side. In other words, when the receiving side can identify whether the LPU transmitted from the transmitting side is composed of the points of the road or the points of the object(s), the road/object splitting operation may be skipped on the receiving side. Further, since the points in the point cloud data are split into LPUs based on whether they are the road or the object(s), the bitstream to be transmitted may be split into the road and the objects.

That is, once the points in the point cloud data are separated into a road and objects by the road/object splitter 53002, the LPU splitter 53005 constructs an LPU with the points separately classified as the road and constructs an LPU with the points separately classified as the object (or object group). Inter-prediction may then be performed by applying a global motion vector for each LPU or by using the previous frame. Here, using the previous frame means that no motion vector is used.

According to embodiments, a motion predictor 53006 may predict global motion for each LPU, and regions (i.e., LPUs) that need to be split may be split into PUs by a PU splitter 53007 to predict local motion. This process may be performed until no further PU splitting is needed or only up to a specified level. The LPU/PU splitting status and the predicted motion for each LPU/PU may be included in the road/object splitting and prediction-related option information and transmitted to the decoder on the receiving side.

Then, a motion compensation application part 53008 may determine through RDO whether to apply the predicted motion to the generated LPUs/PUs, and may apply the motion to a reference frame according to the determination. For example, when it determines through RDO that the gain of inter-prediction is large, it may perform motion compensation by applying the global motion vector and/or local motion vector obtained through motion prediction to the previous frame (i.e., the reference frame). In this case, whether to apply the motion to each LPU/PU may be included in the road/object splitting and prediction-related option information and transmitted to the decoder on the receiving side. Once motion compensation is performed, the geometry information may be compressed and signaled by a geometry information inter-predictor 53009 based on the motion compensated points. That is, the geometry information inter-predictor 53009 performs inter-prediction based on the current LPU/PU and the previous frame that is motion compensated or the previous frame that is not motion compensated.

In other embodiments, the motion predictor 53006 may use global motion estimation to obtain a global motion vector for the LPU composed of the points of the object(s), and skip global motion estimation for the LPU composed of the points of the road. Further, the PU splitter 53007 may split the LPU composed of the points of the objects into as many PUs as the objects, and may not split the LPU composed of the points of the road into PUs. For example, when the objects included in the LPU composed of the points of the objects (or object group) have different characteristics from each other, the LPU may be split into as many PUs as the objects, and each PU may be assigned an object ID (e.g., object_id). Furthermore, for each PU, a local motion vector may be obtained by motion prediction. Then, the object ID information assigned to each PU and the PU information may be included in the road/object splitting and prediction-related option information and transmitted to the decoder on the receiving side. In this case, the motion compensation application part 53008 applies motion compensation to the LPU and/or PUs composed of the points of the object(s) and does not apply motion compensation to the LPU composed of the points of the road. The geometry information inter-predictor 53009 performs inter-prediction based on the current LPU/PU and the previous frame that is motion compensated or the previous frame that is not motion compensated.

In other embodiments, when the frame identified by the determination part 53003 is a P frame and the road/object splitter 53002 has not split the road and objects, the LPU splitter 53005 may split the points of the frame-level, tile-level or slice-level point cloud data voxelized by the voxelization processor 53001 into LPUs based on one or a combination of two or more of elevation, radius, and/or azimuth. Further, the LPUs may be further split into PUs based on one or a combination of two or more of elevation, radius, and/or azimuth. The motion compensation application part 53008 may then determine through RDO whether to apply the predicted motion to the split LPUs/PUs, and may apply the motion to the reference frame based on the determination. For example, when it determines through RDO that the gain of inter-prediction is large, it may perform motion compensation by applying the global motion vector and/or local motion vector obtained through motion prediction to the previous frame (i.e., the reference frame). In this case, whether to apply the motion to each LPU/PU may be included in the road/object splitting and prediction-related option information and transmitted to the decoder on the receiving side. Once motion compensation is performed, the geometry information may be compressed and signaled by a geometry information inter-predictor 53009 based on the motion compensated points. That is, the geometry information inter-predictor 53009 performs inter-prediction based on the current LPU/PU and the previous frame that is motion compensated or the previous frame that is not motion compensated.

According to embodiments, in order for the geometry information inter-predictor 53009 to perform inter-prediction, the reference frame is stored in a reference frame buffer 53011 and provided to the geometry information inter-predictor 53009 when needed.

As such, the LPU/PU splitter 53005 may construct (or generate) an LPU from the points of the object(s), another LPU from the points of the road, and the PU splitter 53007 may split the LPU composed of the points of the object(s) into PUs. Then, the motion predictor 53006 and the motion compensation application part 53008 apply predicted motion to the LPU and/or PUs composed of the points of the object(s) and do not apply motion to the LPU composed of the points of the road.

The geometry information inter-predictor 53009 according to the embodiments may perform predictive-tree-based inter-coding based on a difference in geometry predicted value between the current frame and the reference frame that is motion compensated or a previous frame that is not motion compensated.

According to embodiments, when the frame of the input point cloud data (i.e., the frame to which the input points belong) is a P frame, the geometry information inter-predictor 53009 may apply geometry inter-prediction coding to the geometry information about the P frame. According to embodiments, when the points have been classified into a road and objects by the road/object splitter 53002, the geometry information inter-predictor 53009 may divide a single predictive tree into a road portion and an object portion to construct predictive trees for the portions. For example, it may first construct a first predictive tree with the points classified as the road, and then construct a second predictive tree with the points classified as the object. In this case, the predictive tree for the road portion and the predictive tree for the object portion may not be connected, as shown in FIG. 18-(b), or may be connected, as shown in FIG. 19-(b). According to embodiments, to connect the predictive tree for the road portion and the predictive tree for the object portion, a point closest to the first point in the predictive tree for the object portion may be found in the predictive tree for the road portion and connected to the first point.

According to embodiments, once a predictive tree as shown in FIG. 18-(b) or 19-(b) is generated by the geometry information inter-predictor 53009, inter-prediction may be performed based on the positions of reference points found in one or more reference frames.

In this case, the geometry information inter-predictor 53009 may select points having a similar azimuth from among the points having the same laser ID as the current point in the reference frame as reference points for inter-prediction and use the same as predicted values.

According to embodiments, when the points in the point cloud data are separated into a road and an object, the reference frame may also be separated into a road and an object when searching for reference points for inter-prediction.

For example, when the current point is a road, a point having the same laserID and similar azimuth as the current point may be selected as a reference point from among the points in a region in the reference frame that is separated as the road and used as a predicted value. In other words, when a point in the current frame is positioned in the road region, the reference point may be searched for in the road region in the reference frame. According to embodiments, the residual (or residual position value) is obtained by subtracting the predicted value found through the search in the road region in the reference frame from the position value of the current point. The prediction mode in this case may be referred to herein as an inter-prediction mode.

For example, when the current point belongs to an object (or an object region), a point having the same laserID and similar azimuth as the current point may be selected as a reference point from among the points in the object reference point region in the reference frame and used as a predicted value. In other words, when the point in the current frame is classified as an object, the reference point may be searched for among the points in the object region in the reference frame. According to embodiments, a residual (or residual position value) is obtained by subtracting the predicted value found through the search in the object region in the reference frame from the position value of the current point. The prediction mode in this case may be referred to herein as an inter-prediction mode.

The geometry information inter-predictor 53009 may perform the prediction by applying one of various inter-prediction modes in the predictive tree as shown in FIG. 18-(b) or 19-(b). The inter-prediction mode may vary depending on the number of reference frames, the positions of the points used for prediction, and the like.

Here, the predicted value may be referred to as a predicted value or predicted position value of the current point position. Further, the reference frame may be a motion compensated frame or a non-motion compensated frame.

A geometry information entropy encoder 53010 according to embodiments performs entropy encoding on the geometry information coded based on the intra-prediction by the geometry information intra-predictor 53004 or based on the inter-prediction by the geometry information inter-predictor 53009, and outputs a geometry bitstream (also referred to as a geometry information bitstream). In this case, if the points in the point cloud data have been separated into the road and the objects and processed, the geometry bitstream may be split into the road and the objects to be output.

A geometry reconstructor according to embodiments reconstructs (or restores) the geometry information based on the positions changed through intra-prediction-based coding or inter-prediction-based coding, and outputs the reconstructed geometry information (referred to as reconstructed geometry) to the attribute encoder 51007. This is because the reconstructed (or restored) geometry information is needed to compress the attribute information as the attribute information is dependent on the geometry information (positions). Further, the reconstructed geometry information is stored in the reference frame buffer 53011 so as to be provided as a reference frame for inter-prediction coding of the P frame. The reference frame buffer 53011 also stores the attribute information reconstructed by the attribute encoder 51007. That is, the reconstructed geometry information and reconstructed attribute information stored in the reference frame buffer 53011 may be used as a previous reference frame for geometry information inter-prediction coding by the geometry information inter-predictor 53009 of the geometry encoder 51006 and attribute information inter-prediction coding by the attribute information inter- predictor 55005 of the attribute encoder 51007.

The color transformation processor 55001 of the attribute encoder 51007 corresponds to the color transformer 30006 of FIG. 3 or the color transformation processor 8008 of FIG. 8. The color transformation processor 55001 according to the embodiments performs color transformation coding of transforming color values (or textures) included in the attributes provided from the data input unit 51001 and/or the spatial partitioner 51004. For example, the color transformation processor 55001 may transform the format of color information (e.g., from RGB to YCbCr). The operation of the color transformation processor 55001 according to the embodiments may be optionally applied according to color values included in the attributes. In another embodiment, the color transformation processor 55001 may perform color transformation coding based on the reconstructed geometry.

According to embodiments, the attribute encoder 51007 may perform recoloring according to whether lossy coding is applied to the geometry information. To this end, the element assigned reference numeral 55002 (or referred to as a determination part) checks whether the geometry encoder 51006 has applied lossy coding to the geometry information.

For example, when it is determined by the determination part 55002 that lossy coding has been applied to the geometry information, the recolorer 55003 performs color re-adjustment (or recoloring) to reconfigure the attribute (color) due to the lost points. That is, the recolorer 55003 may find and set an attribute value suitable for the position of the lost point in the source point cloud data. In other words, the recolorer 55003 may predict an attribute value suitable for the changed position when the position information value is changed due to a scale applied to the geometry information.

According to embodiments, the operation of the recolorer 53003 may be optionally applied depending on whether duplicated points are merged. According to an embodiment, the duplicated points may be merged by the voxelization processor 53001 of the geometry encoder 51006.

In an embodiment of the present disclosure, when points belonging to a voxel are merged into one point by the voxelization processor 53001, the recolorer 55003 may perform color re-adjustment (i.e., recoloring).

The recolorer 55003 performs an operation and/or method that is the same as or similar to the operation and/or method of the attribute transformer 30007 of FIG. 3 or the attribute transformation processor 8009 of FIG. 8.

When it is determined by the determination part 55002 that lossy coding has not been applied to the geometry information, it is checked by the element assigned reference numeral 55004 (or referred to as a determination part) whether inter-prediction-based encoding has been applied to the geometry information.

When it is determined by the determination part 55004 that inter-prediction-based encoding has not been applied to the geometry information, the attribute information intra predictor 55006 performs intra-prediction coding on the input attribute information. According to embodiments, the intra-prediction coding methods carried out by the attribute information intra-predictor 55006 may include predicting transform coding, lift transform coding, and RAHT coding.

When it is determined by the determination part 55004 that inter-prediction-based encoding has been applied to the geometry information, the attribute information inter-predictor 55005 performs inter-prediction coding on the input attribute information. According to embodiments, the attribute information inter-predictor 55005 may code a residual based on a difference in attribute predicted value between the current frame and a motion-compensated reference frame.

The attribute information entropy encoder 55008 according to the embodiments performs entropy encoding on the attribute information encoded by the attribute information intra-predictor 55006 based on intra-prediction or on the attribute information encoded by the attribute information inter-predictor 55005 based on inter-prediction, and outputs an attribute bitstream (or referred to as an attribute information bitstream).

The attribute reconstructor according to the embodiments restores (or reconstructs) attribute information based on attributes changed through intra-prediction coding or inter-prediction coding, and stores the reconstructed attribute information (or referred to as the reconstructed attribute) in the reference frame buffer 53009. That is, the reconstructed geometry information and the reconstructed attribute information stored in the reference frame buffer 53009 are may be used as a previous reference frame for inter-prediction coding of geometry information by the geometry information inter-predictor 53007 and inter-prediction coding of the attribute information by the attribute information inter-predictor 55005 of the attribute encoder 51007.

The geometry bitstream compressed and output by the geometry encoder 51006 on an intra-prediction basis or an inter-prediction basis and the attribute bitstream compressed and output by the attribute encoder 51007 on an intra-prediction basis or an inter-prediction basis are output to the transmission processor 51008.

According to embodiments, the transmission processor 51008 may perform the same or similar operation and/or transmission method as the operation and/or transmission method of the transmission processor 8012 of FIG. 8, or may perform the same or similar operation and/or transmission method as the operations and/or transmission method of the transmitter 10003 of FIG. 1. For further details, which will not be described below, refer to the description of FIG. 1 or 8.

The transmission processor 51008 may transmit the geometry bitstream output from the geometry encoder 51006, the attribute bitstream output from the attribute encoder 51007, and the signaling bitstream output from the signaling processor 51005, respectively, or may multiplex the bitstreams into a single bitstream to be transmitted.

According to embodiments, the transmission processor 51008 may encapsulate the bitstreams into files or segments (e.g., streaming segments) and transmit the same over various networks, such as a broadcast network and/or a broadband network.

The signaling processor 51005 may generate and/or process signaling information and output the same to the transmission processor 51008 in the form of a bitstream. The signaling information generated and/or processed by the signaling processor 51005 may be provided to the geometry encoder 51006, the attribute encoder 51007, and/or the transmission processor 51008 for geometry encoding, attribute encoding, and transmission processing. Alternatively, the signaling processor 51005 may be provided with signaling information generated by the geometry encoder 51006, the attribute encoder 51007, and/or the transmission processor 51008.

As used herein, the signaling information may be signaled and transmitted in a parameter set, such as a sequence parameter set (SPS), geometry parameter set (GPS), attribute parameter set (APS), or tile parameter set (TPS) (also referred to as tile inventory). It may be signaled and transmitted per coding unit of each video, such as slice or tile. According to the present disclosure, the signaling information may include metadata related to the point cloud data (e.g., set values, etc.) and may be provided to the geometry encoder 51006, the attribute encoder 51007, and/or the transmission processor 51008 for geometry encoding, attribute encoding, and transmission processing. Depending on the application, signaling information may also be defined at the system level, such as a file format, dynamic adaptive streaming over HTTP (DASH), or MPEG media transport (MMT), or at the wired interface level, such as High Definition Multimedia Interface (HDMI), Display Port, Video Electronics Standards Association (VESA), or CTA.

A method/device according to embodiments may signal related information to add/perform operations of the embodiments. The signaling information may be used by a transmission device and/or a reception device.

In one embodiment, road/object splitting and prediction-related option information to be used for road/object splitting of the points and prediction of geometry information may be signaled in at least one of a geometry parameter set, a tile parameter set, or a geometry slice header. Alternatively, it may be signaled in a separate LPU header (referred to as geom_lpu_header) and/or a PU header (referred to as geom_pu_header).

According to embodiments, the road/object separation and the LPU/PU generation based thereon may be performed by either the geometry encoder on the transmitting side or the geometry decoder on the receiving side. For example, when the road/object separation and the LPU/PU generation based thereon are performed by the geometry encoder on the transmitting side, they may be skipped on the receiving side. When skipped on the transmitting side, the road/object separation and the LPU/PU generation based thereon may be performed by the geometry decoder on the receiving side. According to embodiments of the present disclosure, whether to split a road/object may be determined based on the value of information indicating whether to split the road/object. For example, when the value of the information indicating whether to split the road/object input to the geometry encoder on the transmitting side is TRUE, the geometry encoder on the transmitting side may perform the road/object separation and the LPU/PU generation (or splitting) based thereon. When the value of the information indicating whether to split the road/object input to the geometry decoder on the receiving side is TRUE, the geometry decoder on the receiving side may perform the road/object separation and the LPU/PU generation based thereon. In the former case, the value of the information indicating whether to split the road/object may be signaled as FALSE in the road/object splitting and prediction-related option information and transmitted to the geometry decoder on the receiving side. In this case, the geometry decoder on the receiving side skips the road/object separation and LPU/PU generation based thereon.

In other words, all signaling information may be transmitted to the decoder on the receiving side. In this case, the road/object separation may only be performed by the geometry encoder on the transmitting side, and information indicating whether to separate the road/object and object ID information may be transmitted to the geometry decoder on the receiving side through an LPU/PU such that the geometry decoder may reconstruct the configuration of the bitstream. Thus, when only the geometry encoder separates the road/object, and the road/object separation is transmitted through the configuration of the bitstream, the value of the information indicating whether to separate the road/object may be signaled as FALSE when transmitted to the geometry decoder.

FIG. 22 is a diagram illustrating another exemplary point cloud reception device according to embodiments.

The point cloud reception device according to the embodiments may include a reception processor 61001, a signaling processor 61002, a geometry decoder 61003, an attribute decoder 61004, and a post-processor 61005. According to embodiments, the geometry decoder 61003 and the attribute decoder 61004 may be referred to as a point cloud video decoder. According to embodiments, the point cloud video decoder may be referred to as a PCC decoder, a PCC decoding unit, a point cloud decoder, a point cloud decoding unit, or the like.

The point cloud reception device of FIG. 22 may correspond to the reception device 10004, the receiver 10005, the point cloud video decoder 10006 of FIG. 1, the transmission 20002/decoding 20003/rendering 20004 of FIG. 2, the point cloud video decoder of FIG. 7, the reception device of FIG. 9, the device of FIG. 10, and the like. Each of the components in FIG. 22 and the corresponding figures may correspond to software, hardware, a processor connected to a memory, and/or a combination thereof.

The reception processor 61001 according to the embodiments may receive a single bitstream, or may receive a geometry bitstream (also called geometry information bitstream), an attribute bitstream (also called attribute information bitstream), and a signaling bitstream, respectively. In this case, the bitstreams (or geometry bitstream) may be split into a road and objects and received. When a file and/or segment is received, the reception processor 61001 may decapsulate the received file and/or segment and output a bitstream.

When a single bitstream is received (or decapsulated), the reception processor 61001 may demultiplex the geometry bitstream, the attribute bitstream, and/or the signaling bitstream from the single bitstream. The reception processor 61001 may output the demultiplexed signaling bitstream to the signaling processor 61002, the demultiplexed geometry bitstream to the geometry decoder 61003, and the demultiplexed attribute bitstream to the attribute decoder 61004.

In the case where the geometry bitstream, the attribute bitstream, and/or the signaling bitstream are received (or decapsulated), respectively, the reception processor 61001 may deliver the signaling bitstream to the signaling processor 61002, the geometry bitstream to the geometry decoder 61003, and the attribute bitstream to the attribute decoder 61004.

The signaling processor 61002 may parse and process signaling information, for example, information contained in the SPS, GPS, APS, TPS, metadata, or the like, from the input signaling bitstream, and provide the processed information to the geometry decoder 61003, the attribute decoder 61004, and the post-processor 61005. In another embodiment, signaling information contained in the geometry slice header and/or the attribute slice header may also be parsed by the signaling processor 61002 before the corresponding slice data is decoded. That is, when the point cloud data is partitioned into tiles and/or slices on the transmitting side, the TPS includes the number of slices included in each tile, and accordingly the point cloud video decoder according to the embodiments may check the number of slices and quickly parse the information for parallel decoding.

Accordingly, the point cloud video decoder according to the present disclosure may receive an SPS having a reduced amount of data, and thus quickly parse a bitstream containing the point cloud data. The reception device may decode tiles upon receiving the tiles, and may decode each slice based on the GPS and APS included in each tile, thereby maximizing the decoding efficiency. Alternatively, the reception device may perform intra- or inter-prediction decoding on the point cloud data for each PU based on the road/object splitting and prediction-related option information signaled in the GPS, TPS, geometry slice header, LPU header, and/or PU header, thereby maximizing the decoding efficiency. In this case, the points are assumed to have been separated into a road and an object on the transmitting side.

That is, the geometry decoder 61003 may reconstruct the geometry by performing the reverse process to the operation of the geometry encoder 51006 of FIG. 20 on the compressed geometry bitstream based on the signaling information (e.g., geometry related parameters). The geometry restored (or reconstructed) by the geometry decoder 61003 is provided to the attribute decoder 61004. Here, the geometry-related parameters may include road/object splitting and prediction-related option information to be used for intra-prediction reconstruction or inter-prediction reconstruction of the geometry information.

Further, the geometry decoder 61003 may perform the road/object splitting described above according to the road/object splitting and prediction-related option information and perform intra-prediction and/or inter-prediction of the geometry information based on the splitting. For example, when the value of the information indicating whether to split the road/object (e.g., road_object_split_flag) included in the road/object splitting and prediction-related option information is FALSE, the process of road/object splitting, LPU/PU splitting, and prediction may be performed based on the road/object splitting and prediction-related option information. When the road/object splitting and LPU/PU splitting are performed, motion compensation may be applied on the transmitting side for inter-prediction reconstruction of the geometry information, as described above. On the other hand, when the value of the information indicating whether to split the road/object included in the road/object splitting and prediction-related option information is TRUE, the process of road/object splitting and LPU/PU splitting (or generation) may be skipped.

The attribute decoder 61004 may perform the reverse process to the operation of the attribute encoder 51007 of FIG. 20 on the compressed attribute bitstream based on the signaling information (e.g., attribute-related parameters) and the reconstructed geometry to reconstruct the attributes. According to embodiments, in the case where the point cloud data has been split into tiles and/or slices on the transmitting side, the geometry decoder 61003 and attribute decoder 61004 may perform geometry decoding and attribute decoding on a per-tile and/or per-slice basis.

FIG. 23 is a diagram illustrating exemplary operations of the geometry decoder 61003 and the attribute decoder 61004 according to embodiments.

The geometry information entropy encoder 63001, the inverse quantization processor 63008, and the coordinate inverse transformer 63009 included in the geometry decoder 61003 of FIG. 23 may perform some or all of the operations of the arithmetic decoder 7000 and the coordinate inverse transformer 7004 of FIG. 7, or perform some or all of the operations of the arithmetic decoder 9002 and the inverse quantization processor 9005 of FIG. 9. The positions reconstructed by the geometry decoder 61003 are output to the post-processor 61005.

According to embodiments, when the road/object splitting and prediction-related option information for prediction reconstruction of the geometry information is signaled through at least one of a geometry parameter set (GPS), a tile parameter set (TPS) (or referred to as a tile inventory), a geometry slice header, a geometry LPU header, or a geometry PU header, it may be acquired by the signaling processor 61002 and provided to the geometry decoder 61003, or may be acquired directly by the geometry decoder 61003.

According to embodiments, the road/object splitting and prediction-related option information may include information (road_object_split_flag) indicating whether to split the road/object, estimated height information (estimated_height) for road/object separation, or information (e.g., the angle θ of the sensors, the z value of the sensors, the radius of the sensors) for estimating base height information. According to embodiments, the road/object splitting and prediction-related option information may further include information for identifying each object (object_id). The road/object splitting and prediction-related option information may be included in at least one of a geometry parameter set, a tile parameter set (also referred to as a tile inventory), or a geometry slice header and transmitted to the point cloud decoder on the receiving side. Also, the road/object splitting and prediction-related option information may be included in at least one of a geometry LPU header or a geometry PU header and transmitted to the point cloud decoder on the receiving side. According to embodiments, the road/object splitting and prediction-related option information may further include information (object_id) for identifying each object. The road/object splitting and prediction-related option information may be received in at least one of a geometry parameter set, a tile parameter set (also referred to as a tile inventory), or a geometry slice header. Also, the road/object splitting and prediction-related option information may be received in at least one of a geometry LPU header or a geometry PU header. In the present disclosure, information to be included in the road/object splitting and prediction-related option information may be added, deleted, or modified by a person skilled in the art, and thus the embodiments are not limited to the above-described example.

In other words, the geometry information entropy decoder 63001 entropy-decodes the input geometry bitstream and outputs the decoded bitstream to the road/object splitter 63002.

When the value of the information indicating whether to split the road/object included in the road/object splitting and prediction-related option information is TRUE, the road/object splitter 63002 may split the road and objects from the entropy decoded geometry data based on the road/object splitting and prediction-related option information.

According to embodiments, the road and the objects may be separated based on the estimated height information (estimated_height) for road/object separation as described above.

According to embodiments, the road/object splitter 63002 may classify a current point in the current frame as a road when it is at a position that is equal to or lower than the estimated height for road/object separation (estimated_height), and as an object when it is at a higher position.

According to embodiments, in order to separate the road and objects described above, the road/object splitter 63002 may be provided with road/object splitting and prediction-related option information. According to embodiments, the road/object splitting and prediction-related option information may include information indicating whether to split the road/object and predicted height information for road/object separation. According to embodiments, the road/object splitting and prediction-related option information may further include object ID information assigned to each PU.

When the value of the information indicating whether to split the road/object included in the road/object splitting and prediction-related option information is FALSE, the road/object splitter 63002 skips the road/object splitting. Alternatively, in the case where the bitstream is received split into the objects and road, and the LPU can be identified as an LPU composed of the points of the road or an LPU composed of the points of the object(s) through the inter-prediction-related information, the road/object splitting may be skipped.

According to embodiments, when intra-prediction-based encoding is applied to the geometry information on the transmitting side, the geometry decoder 61003 performs intra-prediction-based reconstruction on the geometry information. On the other hand, when inter-prediction-based encoding is applied to the geometry information on the transmitting side, the geometry decoder 61003 performs inter-prediction-based reconstruction on the geometry information. In the case where the bitstream is received split into a road and objects, the geometry information may be reconstructed by performing decoding for each of the road and objects.

To this end, the element assigned reference numeral 63002 (or referred to as a determination part) checks whether intra-prediction-based coding has been applied or inter-prediction-based coding has been applied to the geometry information.

When it is determined by the determination part 63003 that intra-prediction-based coding has been applied to the geometry information, the entropy-decoded geometry information is provided to a geometry information intra-prediction reconstructor 63004. On the other hand, when it is determined by the determination part 63003 that inter-prediction-based coding has been applied to the geometry information, the entropy-decoded geometry information or the geometry information split into the road and objects by the road/object splitter 63002 is output to the LPU/PU splitter 63002.

The geometry information intra-prediction reconstructor 63004 decodes and reconstructs geometry information based on an intra-prediction method. That is, the geometry information intra-prediction reconstructor 63004 may separate the road and object portions delivered through road/object identification information in the predictive tree. The separated points may be applied when searching for reference points in inter-prediction reconstruction, recognizing whether the current point is a portion of a road or a portion of an object.

When the frame of the geometry information to be decoded is a P frame, the LPU/PU splitter 63005 splits a reference frame into LPUs/PUs based on the road/object splitting and prediction-related option information signaled to support inter-prediction-based reconstruction and indicate LPU/PU split.

In other words, the LPU/PU splitter 63005 generates LPUs using the points classified by the road/object splitter 63002. In this case, each LPU may be configured as a road and an object (or object group) based on the road/object splitting and prediction-related option information. To this end, information for identifying whether each LPU is a road or an object (or object group) (i.e., whether it is a road/object) may be included in the road/object splitting and prediction-related option information.

Further, an LPU split as an object group may be composed of multiple objects. Accordingly, the LPU/PU splitter 63005 may split the LPU composed of multiple objects into PUs when the objects have different characteristics, and the road/object splitting and prediction-related option information including object ID information assigned to each PU may be utilized for reconstruction.

A motion compensation application part 63006 according to embodiments may apply motion vectors (e.g., a global motion vector and/or a local motion vector) to the LPUs/PUs split from a reference frame to generate predicted geometry information. Here, the motion vectors may be received through signaling information. In one embodiment, the motion compensation application part 63006 may determine whether to apply the motion vectors to the LPUs/PUs by referencing the road/object splitting and prediction-related option information. In another embodiment, the motion compensation application part 63006 may perform motion compensation by applying the global motion vector to an LPU split as an object (or object group) and the local motion vectors to PUs. Further, the motion compensation application part 63006 may skip the motion compensation for an LPU split as a road.

A geometry information inter-prediction reconstructor 63007 according to embodiments decodes and reconstructs geometry information based on an inter-prediction method. That is, the geometry information coded by the geometry inter-prediction may be reconstructed based on the geometry information about a motion-compensated reference frame (or. a non-motion-compensated reference frame).

In this case, the geometry information inter-prediction reconstructor 63007 may be provided with a predicted height value for road/object separation, and may thus separate the reference frame into a road and an object. It may search for reference points of the current point. In this operation, when the current point belongs to the road, points with the same laser ID and similar azimuth in a region separated as the road in the reference frame may be searched for as reference points. Also, when the current point belongs to the object, points with the same laser ID and similar azimuth in a region separated as the object in the reference frame may be searched for as reference points. This process may be the same for both the encoder on the transmitting side and the decoder on the receiving side.

The geometry information reconstructed by the geometry information intra-prediction reconstructor 63004 or the geometry information reconstructed by the geometry information inter-prediction reconstructor 63007 is input to the geometry information inverse transform/inverse quantization processor 63008.

The geometry information inverse transform/inverse quantization processor 63008 performs, on the reconstructed geometry information, the inverse operation of the transformation performed by the geometry information transformation/quantization processor 51003 of the transmission device, and generate reconstructed geometry information by performing inverse quantization by multiplying the result of the inverse operation by a scale (= geometry quantization value). In other words, the geometry information inverse transform/inverse quantization processor 63008 may inversely quantize the geometry information by applying the scale (scale=geometry quantization value) included in the signaling information to the x, y, and z values of the geometry position of the reconstructed point.

The coordinate inverse transformer 63009 may perform, on the inversely-quantized geometry information, an inverse operation of the coordinate transformation performed by the coordinate transformer 51002 of the transmission device. For example, the coordinate inverse transformer 63009 may reconstruct the xyz axes changed on the transmitting side or inversely transform the transformed coordinates into xyz Cartesian coordinates.

According to embodiments, the geometry information inversely-quantized by the geometry information inverse transform/inverse quantization processor 63008 is processed in the geometry reconstruction process and stored in a reference frame buffer 63010, and is also output to the attribute decoder 61004 for attribute decoding.

According to embodiments, an attribute residual information entropy decoder 65001 of the attribute decoder 61004 may entropy-decode an input attribute bitstream.

According to embodiments, in the case where intra-prediction-based encoding has been applied to the attribute information on the transmitting side, the attribute decoder 61004 performs intra-prediction-based reconstruction on the attribute information. On the other hand, in the case where inter-prediction-based encoding has been applied to the attribute information on the transmitting side, the attribute decoder 61004 performs inter-prediction-based reconstruction on the attribute information.

To this end, the element assigned reference numeral 65002 (or referred to as a determination part) checks whether intra-prediction-based coding or inter-prediction-based coding has been applied to the attribute information.

When the determination part 65002 determines that intra-prediction-based coding has been applied to the attribute information, the entropy-decoded attribute information is provided to the attribute information intra-prediction reconstructor 65003. On the other hand, when the determination part 65002 determines that inter-prediction-based coding has been applied to the attribute information, the entropy-decoded attribute information is provided to the attribute information inter-prediction reconstructor 65004.

The attribute information inter-prediction reconstructor 65004 decodes and reconstructs the attribute information based on the inter-prediction method. That is, the attribute information predicted by inter-prediction coding is reconstructed.

The attribute information intra-prediction reconstructor 65003 decodes and reconstructs the attribute information based on the intra-prediction method. That is, the attribute information predicted by intra-prediction coding is reconstructed. The intra coding method may include predicting transform coding, lift transform coding, and RAHT coding.

According to embodiments, the reconstructed attribute information may be stored in the reference frame buffer 63010. The geometry information and attribute information stored in the reference frame buffer 63010 may be provided to the geometry information inter-prediction reconstructor 63007 and the attribute information inter-prediction reconstructor 65004 as a previous reference frame.

According to embodiments, the reconstructed attribute information may be provided to the color inverse transform processor 65005 to reconstruct RGB colors. In other words, the color inverse transform processor 65005 performs inverse transform coding to inversely transform the color values (or textures) included in the reconstructed attribute information, and then outputs the attributes to the post-processor 61005. The color inverse transform processor 65005 performs an operation and/or inverse transform coding same as or similar to the operation and/or inverse transform coding of the color inverse transformer 7010 of FIG. 7 or the color inverse transform processor 9010 of FIG. 9.

The post-processor 61005 may reconstruct point cloud data by matching the geometry information (i.e., positions) reconstructed and output by the geometry decoder 61003 with the attribute information reconstructed and output by the attribute decoder 61004. In addition, when the reconstructed point cloud data is in a tile and/or slice unit, the post-processor 61005 may perform a reverse process to the spatial partitioning on the transmitting side based on the signaling information.

FIG. 24 illustrates another exemplary bitstream structure of point cloud data for transmission/reception according to embodiments.

According to embodiments, the bitstream output from the point cloud video encoder of any one of FIGS. 1, 2, 3, 8, 20, and 22 may be in the form shown in FIG. 24.

According to embodiments, the term "slice" in FIG. 24 may be referred to as "data unit."

In addition, in FIG. 24, each abbreviation has the following meaning. Each abbreviation may be referred to by another term within the scope of the equivalent meaning. SPS: Sequence Parameter Set; GPS: Geometry Parameter Set; APS: Attribute Parameter Set; TPS: Tile Parameter Set; Geom: Geometry bitstream = geometry slice header+ [geometry PU header + Geometry PU data] | geometry slice data); Attr: Attribute bitstream = attribute data unit header + [attribute PU header + attribute PU data] | attribute data unit data; LPU: Large Prediction Unit; PU: Prediction Unit.

In the present disclosure, related information may be signaled in order to add/perform the embodiments described so far. Signaling information according to embodiments may be used by a point cloud video encoder on the transmitting side or a point cloud video decoder on the receiving side.

The point cloud video encoder according to the embodiments may generate a bitstream as shown in FIG. 24 by encoding geometry information and attribute information as described above. In addition, signaling information related to the point cloud data may be generated and processed by at least one of the geometry encoder, the attribute encoder, or the signaling processor of the point cloud video encoder, and may be included in the bitstream.

As an example, the point cloud video encoder configured to perform geometry encoding and/or attribute encoding may generate an encoded point cloud (or a bitstream including the point cloud) as shown in FIG. 24. In addition, signaling information related to the point cloud data may be generated and processed by the metadata processor of the point cloud data transmission device, and be included in the point cloud as shown in FIG. 24.

The signaling information may be received/acquired by at least one of the geometry decoder, the attribute decoder, or the signaling processor of the point cloud video decoder.

A bitstream according to embodiments may be divided into a geometry bitstream, an attribute bitstream, and a signaling bitstream and transmitted/received, or one combined bitstream may be transmitted/received.

When a geometry bitstream, an attribute bitstream, and a signaling bitstream according to embodiments are configured in one bitstream, the bitstream may include one or more sub-bitstreams. The bitstream according to the embodiments may include a sequence parameter set (SPS) for sequence level signaling, a geometry parameter set (GPS) for signaling of geometry information coding, one or more attribute parameter sets (APSs) ($APS_0$, $APS_1$) for signaling of attribute information coding, a tile parameter set (TPS) (also referred to as a tile inventory) for signaling at the tile level, and one or more slices (slice 0 to slice n). That is, a bitstream of point cloud data according to embodiments may include one or more tiles, and each of the tiles may be a slice group including one or more slices (slice 0 to slice n). The TPS according to the embodiments may contain information about each of the one or more tiles (e.g., coordinate value information and height/size information about the bounding box). Each slice may include one geometry bitstream (Geom0) and one or more attribute bitstreams (Attr0 and Attr1).

The geometry bitstream (or called geometry slice) in each slice may include a geometry slice header and one or more geometry PUs (Geom PU0, Geom PU1). Each geometry LPU may include a geom LPU header and geom LPU data. Each geometry PU may include a geom PU header and geom PU data.

Each attribute bitstream (or attribute slice) in each slice may include an attribute slice header and one or more attribute PUs (Attr PU0, Attr PU1). Each attribute LPU may include an Attr LPU header and Attr LPU data. Each attribute PU may include an attr PU header and attr PU data.

A portion of the road/object splitting and prediction-related option information according to the embodiments may be added to and signaled in the GPS and/or TPS (also referred to as tile inventory).

A portion of the road/object splitting and prediction-related option information may be added to and signaled in the geometry slice header for each slice.

A portion of the road/object splitting and prediction-related option information may be signaled in the geom LPU header.

A portion of the road/object splitting and prediction-related option information may be signaled in the geom PU header.

As used herein, the road/object splitting and prediction-related option information is used interchangeably with motion option information for road/object splitting and geometry predictive tree coding.

According to embodiments, parameters required for encoding and/or decoding of point cloud data may be newly defined in parameter sets (e.g., SPS, GPS, APS, and TPS (or referred to as a tile inventory), etc.) of the point cloud data and/or the header of the corresponding slice. For example, they may be added to the GPS in encoding and/or decoding geometry information, and may be added to the tile (TPS) and/or slice header in performing tile-based encoding and/or decoding. The parameters may be added to the Geom LPU header and/or the Attr LPU header in performing LPU-based encoding and/or decoding. Also, when PU-based encoding and/or decoding is performed, the parameters may be added to the geometry PU header and/or attribute PU header.

As shown in FIG. 24, the bitstream of the point cloud data is divided into tiles, slices, LPUs, and/or PUs such that the point cloud data may be divided into regions to be processed. The regions of the bitstream may have different importance levels. Accordingly, when the point cloud data is divided into tiles, different filters (encoding methods) or different filter units may be applied to the tiles, respectively. When the point cloud data is divided into slices, different filters or different filter units may be applied to the slices, respectively. When the point cloud data is divided into LPUs, different filters or different filter units may be applied to the LPUs, respectively. Also, when the point cloud data is divided into PUs, different filters or different filter units may be applied to the PUs, respectively.

By transmitting the point cloud data according to the bitstream structure as shown in FIG. 24, the transmission device according to the embodiments may allow the encoding operation to be applied differently according to the importance level, and allow a good-quality encoding method to be used in an important region. In addition, it may support efficient encoding and transmission according to the characteristics of the point cloud data and provide attribute values according to user requirements.

As the reception device according to the embodiments receives the point cloud data according to the bitstream structure as shown in FIG. 24, it may apply different filtering (decoding methods) to the respective regions (regions divided into tiles or slices) according to the processing capacity of the reception device, rather than using a complex decoding (filtering) method to the entire point cloud data. Thereby, a better image quality may be provided for regions important to the user and appropriate latency may be ensured in the system.

As described above, tiles or slices are provided to process the point cloud data by dividing the point cloud data into regions. In dividing the point cloud data into regions, an option to generate a different set of neighbor points for each region may be set. Thereby, a selection method having low complexity and low reliability, or a selection method having high complexity and high reliability may be provided.

According to embodiments, at least one of the GPS, TPS, geometry slice header, geometry LPU header, or geometry PU header may include road/object splitting and prediction-related option information.

According to embodiments, the road/object splitting and prediction-related option information may include information (road_object_split_flag) indicating whether to split the road/object, estimated height information (estimated_height) for road/object separation, or information (e.g., the angle θ of the sensors, the z value of the sensors, the radius of the sensors) for estimating base height information. According to embodiments, the road/object splitting and prediction-related option information may further include identification information for identifying an LPU, information for identifying whether the LPU is an LPU composed of points classified into a road or points classified into an object (or objects), information indicating whether global motion is applied to the LPU, information for identifying the PU, and information (object_id) for identifying each object. A portion of the information contained in the road/object splitting and prediction-related option information may be signaled in the GPS, and another portion thereof (or duplicate information) may be signaled in the TPS or geometry slice header. Additionally, a portion of the information contained in the road/object splitting and prediction-related option information may be signaled in the geometry LPU header and another portion thereof (or duplicate information) may be signaled in the geometry PU header.

A field, which is a term used in syntaxes that will be described later in the present disclosure, may have the same meaning as a parameter or a syntax element.

FIG. 25 is a diagram illustrating an embodiment of a syntax structure of a sequence parameter set (SPS) (seq_parameter_set_rbsp()) according to the present disclosure. The SPS may include sequence information about a point cloud data bitstream.

The SPS according to the embodiments may include a main_profile_compatibility_flag field, a unique_point_positions_constraint_flag field, a level_idc field, an sps_seq_parameter_set_id field, an sps_bounding_box_present_flag field, an sps_source_scale_factor_numerator_minus1 field, an sps_source_scale_factor_denominator_minus1 field, an sps_num_attribute_sets field, log2_max_frame_idx field, an axis_coding_order field, an sps_bypass_stream_enabled_flag field, and an sps_extension_flag field.

The main_profile_compatibility_flag field may indicate whether the bitstream conforms to the main profile. For example, main_profile_compatibility_flag equal to 1 may indicate that the bitstream conforms to the main profile. For example, main_profile_compatibility_flag equal to 0 may indicate that the bitstream conforms to a profile other than the main profile.

When unique_point_positions_constraint_flag is equal to 1, in each point cloud frame that is referenced by the current SPS, all output points may have unique positions. When unique_point_positions_constraint_flag is equal to 0, in any point cloud frame that is referenced by the current SPS, two or more output points may have the same position. For example, even when all points are unique in the respective slices, slices in a frame and other points may overlap. In this case, unique_point_positions_constraint_flag is set to 0.

level_idc indicates a level to which the bitstream conforms.

sps_seq_parameter_set_id provides an identifier for the SPS for reference by other syntax elements.

The sps_bounding_box_present_flag field indicates whether a bounding box is present in the SPS. For example, sps_bounding_box_present_flag equal to 1 indicates that the bounding box is present in the SPS, and sps_bounding_box_present_flag equal to 0 indicates that the size of the bounding box is undefined.

According to embodiments, when sps_bounding_box_present_flag is equal to 1, the SPS may further include an sps_bounding_box_offset_x field, an sps_bounding_box_offset_y field, an sps_bounding_box_offset_z field, an sps_bounding_box_offset_log2_scale field, an sps_bounding_box_size_width field, an sps_bounding_box_size_height field, and an sps_bounding_box_size_depth field.

sps_bounding_box_offset_x indicates the x offset of the source bounding box in Cartesian coordinates. When the x offset of the source bounding box is not present, the value of sps_bounding_box_offset_x is 0.

sps_bounding_box_offset_y indicates the y offset of the source bounding box in Cartesian coordinates. When the y offset of the source bounding box is not present, the value of sps_bounding_box_offset_y is 0.

sps_bounding_box_offset_z indicates the z offset of the source bounding box in Cartesian coordinates. When the z offset of the source bounding box is not present, the value of sps_bounding_box_offset_z is 0.

sps_bounding_box_offset_log2_scale indicates a scale factor for scaling quantized x, y, and z source bounding box offsets.

sps_bounding_box_size_width indicates the width of the source bounding box in Cartesian coordinates. When the width of the source bounding box is not present, the value of sps_bounding_box_size_width may be 1.

sps_bounding_box_size_height indicates the height of the source bounding box in Cartesian coordinates. When the height of the source bounding box is not present, the value of sps_bounding_box_size_height may be 1.

sps_bounding_box_size_depth indicates the depth of the source bounding box in Cartesian coordinates. When the depth of the source bounding box is not present, the value of sps_bounding_box_size_depth may be 1.

sps_source_scale_factor_numerator_minus1 plus 1 indicates the scale factor numerator of the source point cloud.

sps_source_scale_factor_denominator_minus1 plus 1 indicates the scale factor denominator of the source point cloud.

sps_num_attribute_sets indicates the number of coded attributes in the bitstream.

The SPS according to the embodiments includes an iteration statement repeated as many times as the value of the sps_num_attribute_sets field. In an embodiment, i is initialized to 0, and is incremented by 1 each time the iteration statement is executed. The iteration statement is repeated until the value of i becomes equal to the value of the sps_num_attribute_sets field. The iteration statement may include an attribute_dimension_minus1[i] field and an attribute_instance_id[i] field. attribute_dimension_minus1[i] plus 1 indicates the number of components of the i-th attribute.

attribute_instance_id[i] specifies the instance ID of the i-th attribute.

According to embodiments, when the value of the attribute_dimension_minus1[i] field is greater than 1, the iteration statement may further include an attribute_secondary_bitdepth_minus1[i] field, an attribute_cicp_colour_primaries[i] field, an attribute_cicp_transfer_characteristics[i] field, an attribute_cicp_matrix_coeffs[i] field, and an attribute_cicp_video _full_range_flag[i] field.

attribute_minus1 [i] plus 1 specifies the bitdepth for the secondary component of the i-th attribute signal(s).

attribute_cicp_colour_primaries[i] indicates the chromaticity coordinates of the color attribute source primaries of the i-th attribute.

attribute_cicp_transfer_characteristics[i] either indicates the reference optoelectronic transfer characteristic function of the color attribute as a function of a source input linear optical intensity with a nominal real-valued range of 0 to 1 or indicates the inverse of the reference electro-optical transfer characteristic function as a function of an output linear optical intensity

attribute_cicp_matrix_coeffs[i] describes the matrix coefficients used in deriving luma and chroma signals from the green, blue, and red, or Y, Z, and X primaries of the i-th attibute.

attribute_cicp_full_range_flag[i] specifies the black level and range of the luma and chroma signals as derived from E'Y, E'PB, and E'PR or E'R, E'G, and E'B real-valued component signals of the i-th attibute.

The known_attribute_label_flag[i] field indicates whether a known_attribute_label[i] field or an attribute_label_four_bytes[i] field is signaled for the i-th attribute. For example, when known_attribute_label_flag[i] equal to 0 indicates the known_attribute_label[i] field is signaled for the i-th attribute. known_attribute_label_flag[i] equal to 1 indicates that the attribute_label_four_bytes[i] field is signaled for the i-th attribute.

known_attribute_label[i] specifies the type of the i-th attribute. For example, known_attribute_label[i] equal to 0 may specify that the i-th attribute is color. known_attribute_label[i] equal to 1 may specify that the i-th attribute is reflectance. known_attribute_label[i] equal to 2 may specify that the i-th attribute is frame index. Also, known_attribute_label[i] equal to 4 specifies that the i-th attribute is transparency. known_attribute_label[i] equal to 5 specifies that the i-th attribute is normals.

attribute_label_four_bytes[i] indicates the known attribute type with a 4-byte code.

According to embodiments, attribute_label_four_bytes[i] equal to 0 may indicate that the i-th attribute is color. attribute_label_four_bytes[i] equal to 1 may indicate that the i-th attribute is reflectance. attribute_label_four_bytes[i] equal to 2 may indicate that the i-th attribute is a frame index. attribute_label_four_bytes[i] equal to 4 may indicate that the i-th attribute is transparency. attribute_label_four_bytes[i] equal to 5 may indicate that the i-th attribute is normals.

log2_max_frame_idx indicates the number of bits used to signal a syntax variable frame_idx.

axis_coding_order specifies the correspondence between the X, Y, and Z output axis labels and the three position components in the reconstructed point cloud RecPic [pointidx] [axis] with and axis=0..2.

sps_bypass_stream_enabled_flag equal to 1 specifies that the bypass coding mode may be used in reading the bitstream. As another example, sps_bypass_stream_enabled_flag equal to 0 specifies that the bypass coding mode is not used in reading the bitstream.

sps_extension_flag indicates whether the sps_extension_data syntax structure is present in the SPS syntax structure. For example, sps_extension_present_flag equal to 1 indicates that the sps_extension_data syntax structure is present in the SPS syntax structure. sps_extension_present _flag equal to 0 indicates that this syntax structure is not present.

When the value of the sps_extension_flag field is 1, the SPS according to the embodiments may further include an sps_extension_data_flag field.

sps_extension_data_flag may have any value.

FIG. 26 illustrates an exemplary syntax structure of a geometry parameter set (geometry_parameter_set())

# EP 4 518 320 A1

(GPS) including road/object splitting and prediction-related option information according to embodiments. The GPS may include information about a method of encoding geometry information related to the point cloud data contained in the one or more slices.

According to embodiments, the road/object splitting and prediction-related option information (i.e., motion option information for road/object splitting and geometry predictive tree coding) may be added to the geometry parameter set (GPS) and signaled for encoding/decoding of the geometry information on a frame-by-frame basis. In other words, by combining one or more pieces of road/object splitting and prediction-related option information included in the GPS, inter-prediction of the geometry may be efficiently supported. As used herein, the names of signaling information may be understood within the scope of the meaning and functionality of the signaling information.

The GPS according to embodiments may include at least a gps_geom_parameter_set_id field, a gps_seq_parameter_set_id field, a geom_tree_type field, and a road_object_split_flag field.

gps_geom_parameter_set_id provides an identifier for the GPS for reference by other syntax elements.

gps_seq_parameter_set_id specifies the value of sps_seq_parameter_set_id for the active SPS.

geom_tree_type indicates the coding type of geometry information. For example, geom_tree_type equal to 0 may indicate that geometry information (i.e., position information) is coded using an octree, and geom_tree_type equal to 1 may indicate that the information is coded using a predictive tree.

road_object_split_flag specifies whether road/object splitting has been applied to the frame. For example, when the value of road_object_split_flag is TRUE, it may indicate that road/object splitting has been applied to the frame.

When the value of road_object_split_flag is TRUE, the GPS according to the embodiments may further include an estimated _height field and a road_object_connection_flag field.

estimated_height indicates a base height to a sensor applied to the frame. In other words, estimated _height specifies a road/object separation height for identifying whether the point belongs to a road or an object. For example, when the point is positioned at or below the road/object separation height, the point may be classified as the road. In the opposite case, the point may be classified as an object. In another embodiment, the base height may be obtained by calculation.

road_object_conneciton_flag specifies whether to connect the separated road applied to the frame with the separated object.

FIG. 27 illustrates an exemplary syntax structure of a tile parameter set (tile_parameter_set()) (TPS) that includes road/object splitting and prediction-related option information according to embodiments. In some embodiments, the TPS may also be referred to as a tile inventory. The TPS includes information related to each tile on a per-tile basis.

According to embodiments, the road/object splitting and prediction-related option information (i.e., motion option information for road/object splitting and geometry predictive tree coding) may be added to the TPS and signaled for encoding/decoding of the geometry information on a tile-by-tile basis. In other words, by combining one or more pieces of road/object splitting and prediction-related option information included in the TPS, inter-prediction of the geometry may be efficiently supported. As used herein, the names of signaling information may be understood within the scope of the meaning and functionality of the signaling information.

The TPS according to the embodiments includes a num_tiles field.

num_tiles indicates the number of tiles signaled for the bitstream. When not present, num_tiles is inferred to be 0.

The TPS according to the embodiments includes an iteration statement iterating as many times as the value of the num_tiles field. In an embodiment, i is initialized to 0, and is incremented by 1 each time the iteration statement is executed. The iteration statement iterates until the value of i reaches the value of num_tiles. The iteration statement may include a tile_bounding_box_offset_x[i] field, a tile_bounding_box_offset_y[i] field, a tile_bounding_box_offset_z[i] field, a tile_bounding_box_size_width[i] field, a tile_bounding_box_size_height[i] field, a tile_bounding_box_size_depth[i] field, and a road_object_split_flag[i] field. When the value of road_object_split_flag[i] is TRUE, the iteration statement may further include an estimated_height[i] field and a road_object_connection_flag[i] field.

tile_bounding_box_offset_x[i] indicates the x offset of the i-th tile in the Cartesian coordinates.

tile_bounding_box_offset_y[i] indicates the y offset of the i-th tile in the Cartesian coordinates.

tile_bounding_box_offset_z[i] indicates the z offset of the i-th tile in the Cartesian coordinates.

tile_bounding_box_size_width[i] indicates the width of the i-th tile in the Cartesian coordinates.

The tile_bounding_box_sizeheight[i] field indicates the height of the i-th tile in the Cartesian coordinates.

tile_bounding_box_size_depth[i] indicates the depth of the i-th tile in the Cartesian coordinates.

road_object_split_flag[i] specifies whether road/object splitting has been applied to the frame. For example, when the value of road_object_split_flag[i] is TRUE, it may indicate that road/object splitting has been applied to the i-th tile.

estimated_height[i] indicates a base height to the sensor applied to the i-th tile. In other words, estimated_height[i] specifies a road/object split height for identifying whether a point belongs to a road or an object. For example, when the point is positioned at or below the road/object separation height, the point may be classified as a road. In the opposite case, the point may be classified as an object. In another embodiment, the base height may be acquired by calculation.

road_object_conneciton_flag[i] specifies whether to connect the separated road applied to the i-th tile with the separated object.

According to embodiments, a geometry data unit (i.e., the geometry slice bitstream (geometry_slice_bitstream())) may include a geometry data unit header (i.e., the geometry slice header (geometry_slice_header())) and geometry data unit data.

FIG. 28 illustrates an exemplary syntax structure of a geometry data unit according to embodiments.

According to embodiments, the geometry data unit data includes occupancy_tree() when the value of the geom_tree_type field is 0, and includes predictive_tree() when the value of the geom_tree_type field is 1.

geom_tree_type indicates the coding type of the geometry information. For example, geom_tree_type equal to 0 may indicate that the geometry information (i.e., position information) has been coded using an octree, and geom_tree_type equal to 1 may indicate that the geometry information has been coded using a predictive tree.

FIG. 29 illustrates an exemplary syntax structure of a geometry data unit header (i.e., geometry slice header (geometry_slice_header())) according to embodiments of the present disclosure.

According to embodiments, the road/object splitting and prediction-related option information (i.e., motion option information for road/object splitting and geometry predictive tree coding) may be added to the geometry data unit header (i.e., geometry slice header) and signaled for encoding/decoding of the geometry information on a slice-by-slice basis. In other words, by combining one or more pieces of road/object splitting and prediction-related option information included in the geometry data unit header, road/object splitting and intra-/inter-prediction of the geometry may be efficiently supported. As used herein, the names of signaling information may be understood within the scope of the meaning and functionality of the signaling information.

The geometry data unit header according to the embodiments may include at least a gsh_geometry_parameter_set_id field, a gsh_tile_id field, a gsh_slice_id field, or a road_object_split_flag field.

gsh_geometry_parameter_set_id specifies the value of the gps_geom_parameter_set_id of the active GPS.

gsh_tile_id specifies the identifier of the tile referenced by the geometry data unit header (i.e., the geometry slice header (GSH)).

gsh_slice_id specifies the identifier of the slice for reference by other syntax elements.

road_object_split_flag specifies whether road/object splitting has been applied to the geometry slice. For example, when the value of the road_object_split_flag field is TRUE, it may indicate that road/object splitting has been applied to the geometry slice.

When the value of road_object_split_flag is TRUE, the geometry data unit header according to the embodiments may further include an estimated _height field and a road_object_connection_flag field. The geometry data unit header according to the embodiments may further include an is_road_flag field.

estimated_height indicates a base height to a sensor applied to the slice. In other words, estimated _height specifies a road/object separation height for identifying whether the point belongs to a road or an object. For example, when the point is positioned at or below the road/object separation height, the point may be classified as the road. In the opposite case, the point may be classified as an object. In another embodiment, the base height may be obtained by calculation.

road_object_conneciton _flag specifies whether to connect the separated road applied to the slice with the separated object.

is_road_flag may indicate whether a point included in the slice belongs to a road or an object.

FIG. 30 illustrates an exemplary syntax structure of predictive_tree() according to embodiments. That is, predictive_tree() is included in a geometry data unit when the value of the geom_tree_type field is 1.

According to embodiments, the road/object splitting and prediction-related option information (i.e., motion option information for road/object splitting and geometry predictive tree coding) may be added to the Predictive Tree Node and signaled for encoding/decoding of the geometry information. As used herein, the names of signaling information may be understood within the scope of the meaning and functionality of the signaling information.

According to embodiments, predictive_tree() may include a roadPtnCnt field and an objPtnCnt field.

roadPtnCnt specifies the number of points belonging to a road.

objPtnCnt specifies the number of points belonging to an object.

According to embodiments, predictive_tree() includes an iteration statement that iterates until the value of ptree_end_of_slice is FALSE, wherein the iteration statement may include predictive_tree_node(0, roadPtnCnt), ptree_end_of_road, predictive_tree_node(0, objPtnCnt), and ptree_end_of_slice.

ptree_end_of_road indicates a separator (or indicator information) that specifies the end of the predictive tree composed of points belonging to the road.

ptree_end_of_slice indicates a separator (or indicator information) that specifies the end of the predictive tree composed of points belonging to the slice.

predictive_tree_node(0, roadPtnCnt) and predictive_tree_node(0, objPtnCnt) are configured to carry the points belonging to the road and the points belonging to the object.

According to embodiments, the frame, tile, or slice may be divided into one or more LPUs based on the road/object separation method. For example, a geometry slice may include a geometry slice header and one or more geometry LPUs. The one or more geometry LPUs may include an LPU composed of points of a road and an LPU composed of points of an object (or objects). Each LPU may include a geometry LPU header and geometry LPU data.

According to embodiments, an LPU composed of points of an object group may be split into as many PUs as the objects in the object group. Each PU may include a geometry PU header and geometry PU data.

FIG. 31 illustrates an exemplary syntax structure of a geometry PU header according to embodiments (geom_pu_header()) including road/object splitting and prediction-related option information according to embodiments. In other words, the road/object splitting and prediction-related option information (also referred to as object splitting and geometry predictive tree coding information about an intra/inter-prediction-related LPU/PU) may be signaled by generating the geometry PU header.

In other words, by combining one or more pieces of road/object splitting and prediction-related option information contained in the geometry PU header, intra/inter-prediction of the geometry may be efficiently supported. As used herein, the names of signaling information may be understood within the scope of the meaning and functionality of the signaling information..

The geometry PU header according to the embodiments may include may include a pu_tile_id field, a pu_slice_id field, a pu_cnt field, and an is_road_flag field.

pu_tile_id specifies the ID of the tile to which the PU belongs.

pu_slice_id specifies the ID of the slice to which the PU belongs.

pu_cnt specifies the number of PUs in the slice.

is_road_flag may indicate whether a point contained in the LPU block belongs to a road or an object.

The geometry PU header includes the following fields according to the number of PUs

pu_id[puidx] specifies the ID of the PU.

pu_split _flag specifies whether the PU block has been further split.

When the value of is_road_flag is FALSE, namely, the points included in the PU are points separated as an object (or object group), the geometry PU header may further include an object_id field.

object_id specifies the object ID assigned to the PU. In other words, object_id indicates object identification information for identifying the object to which the points included in the PU block belong.

pu_has_motion_vector_flag specifies whether the PU block has a motion vector. For example, pu_has_motion_vector_flag equal to 1 may indicate that the PU has a motion vector, and pu_has_motion_vector_flag equal to 0 may indicate that the PU does not have a motion vector.

When pu_has_motion_vector_flag is equal to 1, the geometry PU header may further include motion vector related information according to the value of motion_desc_type.

When motion_desc_type is equal to 0, the geometry PU header may further include a pu_motion_mat[pu_id][k][l] field.

pu_motion_mat[pu_id][k][l] specifies a motion matrix applied to the PU block identified by pu_id.

When motion_desc_type is equal to 1, the geometry PU header may further include a pu_motion_rot_vector [pu_id][k] field and a pu_motion_trans[pu_id][k] field.

pu_motion_rot_vector[pu_id][k] specifies a motion rotation vector applied to the PU block identified by pu_id.

pu_motion_trans[pu_id][k] specifies the motion translation vector applied to the PU block identified by pu_id.

When motion_desc_type is equal to 2, the geometry PU header may further include a pu_motion_rot_type[pu_id] field, a pu_motion_rot[pu_id] field, and a pu_motion_trans[pu_id][k] field.

pu_motion_rot_type[pu_id] specifies the type of motion rotation applied to the PU block identified by pu_id. For example, pu_motion_rot_type[pu_id] may indicate a radius when equal to 0, and indicate an angle (in degrees) when equal to 1.

pu_motion_rot[pu_id] specifies a motion rotation value applied to the PU block identified by pu_id. According to embodiments, the rotation axis rotates about a road normal vector.

FIG. 32 is a flowchart illustrating a method of transmitting point cloud data according to embodiments.

The method of transmitting point cloud data according to the embodiments may include operation 71001 of acquiring point cloud data, operation 71002 of encoding the point cloud data, and operation 71003 of transmitting the encoded point cloud data and signaling information. In this case, a bitstream containing the encoded point cloud data and the signaling information may be encapsulated in a file and transmitted.

In operation 71001 of acquiring the point cloud data, some or all of the operations of the point cloud video acquisition part 10001 of FIG. 1 may be performed, or some or all of the operations of the data input unit 8000 of FIG. 8 may be performed.

In operation 71002 of encoding the point cloud data, some or all of the operations of the point cloud video encoder 10002 of FIG. 1, the encoding 20001 of FIG. 2, the point cloud video encoder of FIG. 3, the point cloud video encoder of FIG. 8, the geometry encoder and attribute encoder of FIG. 20, and the geometry encoder and attribute encoder of FIG. 21 may be performed to encode the geometry information and attribute information.

Operation 71002 of encoding the point cloud data according to the embodiments may include compressing geometry information related to the input point cloud data and compressing attribute information related to the data.

According to embodiments, in the operation of compressing the geometry information, inter-prediction or intra-prediction-based encoding is performed on the positions (i.e., geometry information) of the point cloud data to output a geometry bitstream. In this case, when the frame of the point cloud data is a P-frame, a road and an object may be separated from frame-level, tile-level or slice-level point cloud data by applying the road and object separation method described above to the frame-level, tile-level or slice-level point cloud data for prediction-based encoding of the P frame. Then, a predictive tree may be constructed for each of the road portion and object portion, and the geometry information may be compressed using intra-prediction or inter-prediction.

For the details of separating the points of the point cloud data into a road and an object and constructing respective prediction trees to perform compression, which will not be described below, refer the description of FIGS. 10 to 21 given above.

The geometry information about each compressed point is entropy-encoded and output in the form of a geometry bitstream.

According to embodiments, the operation of compressing the attribute information includes compressing the attribute information based on positions for which the geometry encoding has not been performed and/or reconstructed geometry information. In one embodiment, the attribute information may be coded using any one or a combination of one or more of RAHT coding, LOD-based predictive transform coding, and lifting transform coding.

The compressed attribute information is entropy-encoded and output in the form of an attribute bitstream.

In the present disclosure, the signaling information may include road/object splitting and prediction-related option information for road/object splitting and coding of a geometry predictive tree.

The road/object splitting and prediction-related option information may include information indicating whether a road/object is separated, predicted height information for the road/object separation, LPU/PU-related information, motion vector-related information, and information for identifying each object. The road/object splitting and prediction-related option information may be included in at least one of a geometry parameter set, a tile parameter set (also referred to as a tile inventory), or a geometry slice header and transmitted to the receiving side. Further, the road/object splitting and prediction-related option information may be included in at least one of a geometry LPU header or a geometry PU header and transmitted to the receiving side.

FIG. 33 is a flowchart illustrating an exemplary method of receiving point cloud data according to embodiments.

The method of receiving point cloud data according to the embodiments may include operation 81001 of receiving encoded point cloud data and signaling information, operation 81002 of decoding the point cloud data based on the signaling information, and operation 81003 of rendering the decoded point cloud data.

Operation 81001 of receiving the point cloud data and signaling information according to embodiments may be performed by the receiver 10005 of FIG. 1, the transmission 20002 or decoding 20003 of FIG. 2, or the receiver 9000 or reception processor 9001 of FIG. 9.

In operation 81002 of decoding the point cloud data according to the embodiments, some or all of the operations of the point cloud video decoder 10006 of FIG. 1, the decoding 20003 of FIG. 2, the point cloud video decoder of FIG. 8, the point cloud video decoder of FIG. 9, the geometry decoder and attribute decoder of FIG. 22, or the geometry decoder and attribute decoder of FIG. 23 may be performed to decode geometry information and attribute information.

Operation 81002 of decoding the point cloud data according to the embodiments includes decoding geometry information and decoding attribute information.

The operation of decoding the geometry information may include decoding (i.e., reconstructing) the geometry information based on road/object splitting and prediction-related option information included in the signaling information. For further details, refer to the description of FIGS. 10 of 23.

The operation of decoding the attribute information may include decoding (i.e., decompressing) the attribute information based on the reconstructed geometry information. In one embodiment, the attribute information may be decoded using any one or a combination of one or more of RAHT coding, LOD-based predictive transform coding, and lifting transform coding.

Operation 81003 of the rendering according to the embodiments may include reconstructing the point cloud data based on the restored (or reconstructed) geometry information and attribute information and rendering the data according to various rendering schemes. For example, points in the point cloud content may be rendered as a vertex having a specific thickness, as a cube having a specific minimum size centered on the corresponding vertex position, as a circle centered on the vertex position, etc. All or a portion of the rendered point cloud content may be presented to a user through a display (e.g., a VR/AR display, a general display, etc.). Operation 81003 of rendering the point cloud data according to the embodiments may be performed by the renderer 10007 of FIG. 1, the rendering 20004 of FIG. 2, or the renderer 9011 of FIG. 9.

As described above, in a scenario where each frame is captured and stored by LiDAR equipment on a moving vehicle, there may be continuity between frames, and thus compression may be performed efficiently using an inter-prediction technique. In particular, since the captured road and object point clouds have different motion characteristics, the road and objects may be split to efficiently apply the inter-prediction technique. Thereby, the motion prediction may be performed quickly and accurately for each of the road and objects, reducing the compression time. Also, by increasing the efficiency of the inter-prediction technique through accurate prediction, the bitstream size may be reduced. Inaccurate motion prediction may significantly increase the bitstream size, thereby lowering the compression efficiency.

In these embodiments, a road/object splitting method is proposed to support efficient geometry compression of content captured by LiDAR equipment on a moving vehicle. Also, predictive trees for a road and objects may be constructed, respectively, and then compression is performed. Thus, a point cloud content stream may be provided with increased geometry compression efficiency in the G-PCC encoder/decoder.

As such, the transmission method/device may efficiently compress the point cloud data to transmit the data, and may deliver the signaling information for the data. Thus, the reception method/device may efficiently decode/reconstruct the point cloud data.

Each part, module, or unit described above may be a software, processor, or hardware part that executes successive procedures stored in a memory (or storage unit). Each of the steps described in the above embodiments may be performed by a processor, software, or hardware parts. Each module/block/unit described in the above embodiments may operate as a processor, software, or hardware. In addition, the methods presented by the embodiments may be executed as code. This code may be written on a processor readable storage medium and thus read by a processor provided by an apparatus.

In the specification, when a part "comprises" or "includes" an element, it means that the part further comprises or includes another element unless otherwise mentioned. Also, the term "...module(or unit)" disclosed in the specification means a unit for processing at least one function or operation, and may be implemented by hardware, software or combination of hardware and software.

Although embodiments have been explained with reference to each of the accompanying drawings for simplicity, it is possible to design new embodiments by merging the embodiments illustrated in the accompanying drawings. If a recording medium readable by a computer, in which programs for executing the embodiments mentioned in the foregoing description are recorded, is designed by those skilled in the art, it may fall within the scope of the appended claims and their equivalents.

The apparatuses and methods may not be limited by the configurations and methods of the embodiments described above. The embodiments described above may be configured by being selectively combined with one another entirely or in part to enable various modifications.

Although preferred embodiments of the embodiments have been shown and described, the embodiments are not limited to the specific embodiments described above, and various modifications may be made by one of ordinary skill in the art without departing from the spirit of the embodiments claimed in the claims, and such modifications should not be understood in isolation from the technical ideas or views of the embodiments.

Various elements of the apparatuses of the embodiments may be implemented by hardware, software, firmware, or a combination thereof. Various elements in the embodiments may be implemented by a single chip, for example, a single hardware circuit. According to embodiments, the components according to the embodiments may be implemented as separate chips, respectively. According to embodiments, at least one or more of the components of the apparatus according to the embodiments may include one or more processors capable of executing one or more programs. The one or more programs may perform any one or more of the operations/methods according to the embodiments or include instructions for performing the same. Executable instructions for performing the method/operations of the apparatus according to the embodiments may be stored in a non-transitory CRM or other computer program products configured to be executed by one or more processors, or may be stored in a transitory CRM or other computer program products configured to be executed by one or more processors. In addition, the memory according to the embodiments may be used as a concept covering not only volatile memories (e.g., RAM) but also nonvolatile memories, flash memories, and PROMs. In addition, it may also be implemented in the form of a carrier wave, such as transmission over the Internet. In addition, the processor-readable recording medium may be distributed to computer systems connected over a network such that the processor-readable code may be stored and executed in a distributed fashion.

In this document, the term "/" and "," should be interpreted to indicate "and/or." For instance, the expression "A/B" may mean "A and/or B." Further, "A, B" may mean "A and/or B." Further, "A/B/C" may mean "at least one of A, B, and/or C." Also, "A/B/C" may mean "at least one of A, B, and/or C." Further, in the document, the term "or" should be interpreted to indicate "and/or." For instance, the expression "A or B" may comprise 1) only A, 2) only B, and/or 3) both A and B. In other words, the term "or" in this document should be interpreted to indicate "additionally or alternatively."

Various elements of the embodiments may be implemented by hardware, software, firmware, or a combination thereof. Various elements in the embodiments may be executed by a single chip such as a single hardware circuit. According to embodiments, the element may be selectively executed by separate chips, respectively. According to embodiments, at least one of the elements of the embodiments may be executed in one or more processors including instructions for performing operations according to the embodiments.

Operations according to the embodiments described in this specification may be performed by a transmission/-reception device including one or more memories and/or one or more processors according to embodiments. The one or more memories may store programs for processing/controlling the operations according to the embodiments, and the one or more processors may control various operations described in this specification. The one or more processors may be referred to as a controller or the like. In embodiments, operations may be performed by firmware, software, and/or combinations thereof. The firmware, software, and/or combinations thereof may be stored in the processor or the memory.

Terms such as first and second may be used to describe various elements of the embodiments. However, various components according to the embodiments should not be limited by the above terms. These terms are only used to distinguish one element from another. For example, a first user input signal may be referred to as a second user input signal. Similarly, the second user input signal may be referred to as a first user input signal. Use of these terms should be construed as not departing from the scope of the various embodiments. The first user input signal and the second user input signal are both user input signals, but do not mean the same user input signal unless context clearly dictates otherwise. The terminology used to describe the embodiments is used for the purpose of describing particular embodiments only and is not intended to be limiting of the embodiments. As used in the description of the embodiments and in the claims, the singular forms "a", "an", and "the" include plural referents unless the context clearly dictates otherwise. The expression "and/or" is used to include all possible combinations of terms. The terms such as "includes" or "has" are intended to indicate existence of figures, numbers, steps, elements, and/or components and should be understood as not precluding possibility of existence of additional existence of figures, numbers, steps, elements, and/or components.

As used herein, conditional expressions such as "if" and "when" are not limited to an optional case and are intended to be interpreted, when a specific condition is satisfied, to perform the related operation or interpret the related definition according to the specific condition. Embodiments may include variations/modifications within the scope of the claims and their equivalents. It will be apparent to those skilled in the art that various modifications and variations can be made in the present disclosure without departing from the spirit and scope of the disclosure. Thus, it is intended that the present disclosure cover the modifications and variations of this disclosure provided they come within the scope of the appended claims and their equivalents.

[Mode for Disclosure]

As described above, related contents have been described in the best mode for carrying out the embodiments.

[Industrial Applicability]

As described above, the embodiments may be fully or partially applied to the point cloud data transmission/reception device and system. It will be apparent to those skilled in the art that various changes or modifications may be made to the embodiments within the scope of the embodiments. Thus, it is intended that the embodiments cover modifications and variations provided they come within the scope of the appended claims and their equivalents.

**Claims**

1. A method of transmitting point cloud data, the method comprising:

   acquiring point cloud data containing points by LiDAR equipment having laser sensors;
   encoding the point cloud data; and
   transmitting the encoded point cloud data and signaling data,
   wherein the encoding comprises:

   separating the points in the point cloud data into a road and an object;
   constructing a first predictive tree based on the points separated as the road and a second predictive tree based on the points separated as the object; and
   compressing the point cloud data based on prediction by applying the first predictive tree and the second predictive tree,
   wherein the signaling data comprises information related to separation of the road and the object.

2. The method of claim 1, wherein the separating the points into the road and the object comprises:
   separating the points in the point cloud data into the road and the object based on a base height corresponding to a distance from the road to a center of the laser sensors.

3. The method of claim 2, wherein the base height is estimated based on angle information, radius information, and height information related to a laser sensor having a greatest negative angle among the laser sensors.

4. The method of claim 2, wherein the separating the points into the road and the object comprises:

   separating points present at a position equal to the base height or lower than the base height among the points in the point cloud data as the road; and
   separating points present at a position higher than the base height among the points in the point cloud data as the object.

5. The method of claim 1, wherein the separating the points into the road and the object comprises:

   removing points present within a minimum radius among points acquired by a current laser sensor,
   wherein the separating is performed after the removing.

6. The method of claim 1, wherein the compressing comprises:
   compressing the point cloud data based on intra-prediction by applying the first predictive tree and the second predictive tree.

7. The method of claim 1, wherein the compressing comprises:
   compressing the point cloud data based on inter-prediction by applying the first predictive tree, the second predictive tree, and at least one reference frame.

8. The method of claim 7, wherein the compression comprises:

   based on a current point in a current frame belonging to the road, selecting, as a reference point, a point having a same laser ID and similar azimuth as the current point from among points in a region separated as the road in the at least one reference frame and setting the reference point as a predicted value of the current point; and
   based on the current point in the current frame belonging to the object, selecting, as a reference point, a point having the same laser ID and similar azimuth as the current point from among points in a region separated as the object in the at least one reference frame and setting the reference point as a predicted value of the current point.

9. A device for transmitting point cloud data, comprising:

   an acquirer configured to acquire point cloud data containing points by LiDAR equipment having laser sensors;
   an encoder configured to encode the point cloud data; and
   a transmitter configured to transmit the encoded point cloud data and signaling data,
   wherein the encoder is configured to:

   separate the points in the point cloud data into a road and an object;
   construct a first predictive tree based on the points separated as the road and a second predictive tree based on the points separated as the object; and
   compress the point cloud data based on prediction by applying the first predictive tree and the second predictive tree,
   wherein the signaling data comprises information related to separation of the road and the object.

10. The device of claim 9, wherein the encoder separates the points in the point cloud data into the road and the object based on a base height corresponding to a distance from the road to a center of the laser sensors.

11. The device of claim 10, wherein the base height is estimated based on angle information, radius information, and height information related to a laser sensor having a greatest negative angle among the laser sensors.

12. The device of claim 10, wherein the encoder separates points present at a position equal to the base height or lower than the base height among the points in the point cloud data as the road; and separates points present at a position higher than the base height among the points in the point cloud data as the object.

13. The device of claim 9, wherein the encoder separates the points into the road and the object after removing points present within a minimum radius among points acquired by a current laser sensor.

14. The device of claim 9, wherein the encoder compresses the point cloud data based on intra-prediction by applying the first predictive tree and the second predictive tree.

15. The device of claim 9, wherein the encoder compresses the point cloud data based on inter-prediction by applying the first predictive tree, the second predictive tree, and at least one reference frame.

16. The device of claim 15, wherein the encoder is configured to:

based on a current point in a current frame belonging to the road, select, as a reference point, a point having a same laser ID and similar azimuth as the current point from among points in a region separated as the road in the at least one reference frame and set the reference point as a predicted value of the current point; and
based on the current point in the current frame belonging to the object, select, as a reference point, a point having the same laser ID and similar azimuth as the current point from among points in a region separated as the object in the at least one reference frame and set the reference point as a predicted value of the current point.

# FIG. 1

# FIG. 2

20000    20001    20002    20003    20004

Acquisition → Ply file
-geometry
-attribute → Encoding → Encoded
-geometry
-attribute bitstream → Transmission → Decoding → Decoded
-geometry
-attribute → Rendering

Head orientation, Viewport information

Head orientation, Viewport information    Feedback

20005

# FIG. 3

positions          attributes

| | |
|---|---|
| 30000 — Transform coordinates | Transform colors — 30006 |
| 30001 — Quantize and remove points (voxelize) | Transfer attributes — 30007 |
| 30002 — Analyze octree | 30008 |
| 30003 — Analyze surface approximation | RAHT / Gnnerate LOD — 30009 |
| Reconstruct geometry | Lifting — 30010 |
| 30005 | Quantize coefficients — 30011 |
| 30004 — Arithmetic encode | Arithmetic encode — 30012 |

geometry bitstream      atribute bitstream

# FIG. 4

FIG. 5

# FIG. 6

P0  P1      P4      P3

P6    P7

P9

P5        P8  P2

| Original order | P0, P1, P2, P3, P4, P5, P6, P7, P8, P9 |
|---|---|

LOD-based order

P0, P5, P4, P2  P1, P6, P3  P9, P8, P7

LOD0

LOD1

LOD2

# FIG. 7

# FIG. 8

8000 — Data input unit

8007

Position values of points          Attribute values of points

Set value, etc.

8001 — Quantization processor ← Metadata processor → Color transform processor — 8008

8002 — Voxelization processor ← → Attribute transform processor — 8009

8003 — Octree occupancy code generator ← → Prediction/lifting/RAHT transform processor — 8010

8004 — Surface model processor ← → Arithmetic encoder — 8011

8005 — Intre/inter-coding processor ←

8006 — Arithmetic encoder ←

Sharing reconstructed position values

Transmission processor

8012

# FIG. 9

Receive

9000 — Receiver

9001 — Reception processor

9006

Geometry bitstream

Attribute bitstream

Set value, etc.

9002 — Arithmetic decoder

Metadata parser

Arithmetic decoder — 9007

9003 — Occupancy code-based octree reconstruction processor

Inverse quantization processor — 9008

9004 — Surface model processor (triangle reconstruction, up-sampling, voxelization)

Prediction/lifting/RAHT inverse transform processor — 9009

9005 — Inverse quantization processor

Color inverse transform processor — 9010

Sharing reconstructed position values

Renderer — 9011

# FIG. 10

FIG. 11

FIG. 12

# FIG. 13

○ Laser index=0
⊕ Laser index=1
○ Laser index=2
⊘ Laser index=3

50014
50015
50011
50012
50013

(a)

(b)

FIG. 14

FIG. 15

50020

# FIG. 16

# FIG. 17

# FIG. 18

# FIG. 19

⊘ Laser index=0
⊕ Laser index=1
⊘ Laser index=2
⊘ Laser index=3

50041

50042

50043

(a)                    (b)

# FIG. 20

# FIG. 21

Data input unit (geometry, attributes, parameters) — 51001

Coordinate transformer — 51002

Geometry information transform/ quantization processor — 51003

51004 — Spatial partitioner

Split attribute origin data

51007

Color transform processor — 55001 / 55002

Lossy-Geom? — 55003
- Yes → Recolorer

53001 — Voxelization processor

53002 — Road/object splitter

Road/object splitting status →
Height error value →
Angle θ of sensors →
Z values of the sensors →

Road/object splitting status
Road/object separation height

LPU splitter — 53005

Road/object identification →

Motion predictor — 53006

PU splitter — 53007

P-frame

53003 — Type of frame?

I-frame

Motion compensation application part — 53008

Geometry information inter-predictor — 53009

53004 — Geometry information intra-predictor

Attr intra-prediction? — 55004
- No → Attribute information inter-predictor — 55005
- Yes → Attribute information intra-predictor — 55006

Reference frame buffer — 53011

Reconstructed attribute information — 55007

53010 — Geometry information entropy encoder

Reconstructed geometry information

Geometry bitstream — 51006

Attribute information entropy encoder — 55008

Attribute bitstream

# FIG. 22

# FIG. 23

Geometry bitstream

63005

63001 — Geometry information entropy decoder

63002 — Road/object splitter

Road/object splitting status →
Road/object separation height →

63003 — Geom Intra coding? — No

Yes

63004 — Geometry information intra-prediction reconstructor

Road/object identification →

Within predictive tree →

61003 — Geometry information transform/ inverse quantization processor — 63008

Coordinate inverse transformer — 63009

Positions

LPU/PU splitter

Road/object identification →

Motion compensation application part

63006 —

Geometry information inter-prediction reconstructor

63007

63010 — Reference frame buffer

Reconstructed geometry information

Attribute bitstream

Attribute residual information entropy decoder — 65001

Attr Intra coding? — No

65002

Yes

Attribute information inter-prediction reconstructor — 65004

Attribute information intra-prediction reconstructor — 65003

Reconstructed attribute information

Color inverse transform processor — 65005

Attributes

61004

EP 4 518 320 A1

FIG. 24

| S P S | G P S | A P S 0 | A P S 1 | T P S | Slice 0 | | | | | | | | | |
|---|---|---|---|---|---|---|---|---|---|---|---|---|---|---|
| | | | | | Geom 0 | | | | | Attr 0 | | | Attr1 | |
| | | | | | Geom slice header | Geom PU0 | | Geom PU1 | ... | Attr slice header | Attr PU0 | | Attr PU1 | ... |
| | | | | | | Geom Pu header | Geom Pu data | | | | Attr PU header | Attr PU data | | |

# FIG. 25

| seq_parameter_set( ) { | Descriptor |
|---|---|
| main_profile_compatibility_flag | u(1) |
| unique_point_positions_constraint_flag | u(1) |
| level_idc | u(8) |
| sps_seq_parameter_set_id | ue(v) |
| sps_bounding_box_present_flag | u(1) |
| if( sps_bounding_box_present_flag ) { | |
| sps_bounding_box_offset_x | se(v) |
| sps_bounding_box_offset_y | se(v) |
| sps_bounding_box_offset_z | se(v) |
| sps_bounding_box_offset_log2_scale | ue(v) |
| sps_bounding_box_size_width | ue(v) |
| sps_bounding_box_size_height | ue(v) |
| sps_bounding_box_size_depth | ue(v) |
| } | |
| sps_source_scale_factor_numerator_minus1 | ue(v) |
| sps_source_scale_factor_denominator_minus1 | ue(v) |
| sps_num_attribute_sets | ue(v) |
| for( i = 0; i< sps_num_attribute_sets; i++ ) { | |
| attribute_dimension_minus1[ i ] | ue(v) |
| attribute_instance_id[ i ] | ue(v) |
| if(attribute_dimension_minus1[ i ] > 0 ) | |
| attribute_secondary_bitdepth_minus1[ i ] | ue(v) |
| attribute_cicp_colour_primaries[ i ] | ue(v) |
| attribute_cicp_transfer_characteristics[ i ] | ue(v) |
| attribute_cicp_matrix_coeffs[ i ] | ue(v) |
| attribute_cicp_video_full_range_flag[ i ] | u(1) |
| known_attribute_label_flag[ i ] | u(1) |
| if( known_attribute_label_flag[ i ] ) | |
| known_attribute_label[ i ] | ue(v) |
| else | |
| attribute_label_four_bytes[ i ] | u(32) |
| } | |
| log2_max_frame_idx | u(5) |
| axis_coding_order | u(3) |
| sps_bypass_stream_enabled_flag | u(1) |
| sps_extension _flag | u(1) |
| if( sps_extension _flag ) | |
| while( more_data_in_byte_stream( ) ) | |
| sps_extension_data_flag | u(1) |
| byte_alignment( ) | |
| } | |

# FIG. 26

| geometry_parameter_set_rbsp( ) { | Descriptor |
|---|---|
| gps_geom_parameter_set_id | ue(v) |
| gps_seq_parameter_set_id | ue(v) |
| geom_tree_type | u(2) |
| ... | |
| road_object_split_flag | u(1) |
| if (road_object_split_flag = = true) { | |
| estimated_height | ue(v) |
| road_object_connection_flag | u(1) |
| } | |
| | |
| ... | |
| byte_alignment( ) | |
| } | |

# FIG. 27

| tile_parameter_set() { | Descriptor |
|---|---|
| num tiles | ue(v) |
| for(i=0;i<num_tiles;i++){ | |
| tile_bounding_box_offset_x[i] | se(v) |
| tile_bounding_box_offset_y[i] | se(v) |
| ... | |
| road_object_split_flag[i] | u(1) |
| if(road_object_split_flag[i] == true) { | |
| estimated_height[i] | ue(v) |
| road_object_connection_flag[i] | u(1) |
| } | |
| ... | |
| } | |
| byte_alignment( ) | |
| } | |

# FIG. 28

| geometry_data_unit() { | Descriptor |
|---|---|
| geometry_data_unit_header() | |
| if(geom_tree_type == 0) | |
| occupancy_tree() | |
| else if(geom_tree_type == 1) | |
| predictive_tree() | |
| geometry_data_unit_footer() | |
| } | |

## FIG. 29

| geometry_data_unit_header() { | Descriptor |
|---|---|
| gsh_geometry_parameter_set_id | ue(v) |
| gsh_tile_id | ue(v) |
| gsh_slice_id | ue(v) |
| ... | |
| road_object_split_flag | u(1) |
| if(road_object_split_flag == true) { | |
| estimated_height | ue(v) |
| road_object_connection_flag | u(1) |
| } | |
| is_road_flag | u(1) |
| ... | |
| } | |
| byte_alignment( ) | |
| } | |

# FIG. 30

| predictive_tree() { | Descriptor |
|---|---|
| roadPtnCnt | |
| objPtnCnt | |
| do { | |
| predictive_tree_node(0, roadPtnCnt) | |
| ptee_end_of_road | u(1) |
| predictive_tree_node(0, objPtnCnt) | |
| ptree_end_of_slice | ae(v) |
| } while(ptree_end_of_slice) | |
| } | |

# FIG. 31

| geom_pu_header() { | Descriptor |
|---|---|
| pu_tile_id | ue(v) |
| pu_slice_id | ue(v) |
| pu_cnt | ue(v) |
| is_road_flag | |
| for( puIdx=0; puIdx<pu_cnt; puIdx++) { | u(1) |
| pu_id[puIdx] | |
| pu_split_flag | ue(v) |
| if(is_road_flag == flase) | u(1) |
| object_id | |
| pu_has_motion_vector_flag | u(1) |
| if(pu_has_motion_vector_flag == 1) { | |
| if(motion_desc_type == 0) { | |
| for(k=0; k<4; k++) | |
| for(l=0; l<4; l++) | |
| pu_motion_mat[pu_id][k][l] | |
| } else if (motion_desc_type == 1) { | |
| for (k=0; k<3; k++) { | |
| pu_motion_rot_vector[pu_id][k] | |
| pu_motion_trans[pu_id][k] | |
| } | |
| } else if (motion_desc_type == 2) { | |
| pu_motion_rot_type[pu_id] | |
| pu_motion_rot[pu_id] | |
| for (k=0; k<3; k++) | |
| pu_motion_trans[pu_id][k] | |
| } | |
| } | |
| } | |
| ... | |
| byte_alignment() | |
| } | |

# FIG. 32

71001 — | Acquire point cloud data |

71002 — | Encode point cloud data |

71003 — | Transmit encoded point cloud data and signaling information |

# FIG. 33

81001 — Receive encoded point cloud data and signaling information

81002 — Decode point cloud data based on signaling information

81003 — Render decoded point cloud data

## INTERNATIONAL SEARCH REPORT

International application No.

**PCT/KR2023/005561**

| A. | CLASSIFICATION OF SUBJECT MATTER |
|---|---|

**H04N 19/597**(2014.01)i; **H04N 19/70**(2014.01)i; **H04N 19/96**(2014.01)i; **H04N 19/20**(2014.01)i; **G06T 9/40**(2006.01)i

According to International Patent Classification (IPC) or to both national classification and IPC

| B. | FIELDS SEARCHED |
|---|---|

Minimum documentation searched (classification system followed by classification symbols)

H04N 19/597(2014.01); G01S 17/89(2006.01); G06T 7/00(2006.01); G06T 9/40(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 포인트 클라우드(point cloud), 분류(classification), 높이(height), 도로(road), 객체 (object), 예측 트리(prediction tree)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2022-025552 A1 (LG ELECTRONICS INC.) 03 February 2022 (2022-02-03) See paragraphs [0070]-[0291]; and claims 1 and 3. | 1,5-9,13-16 |
| Y |  | 2-4,10-12 |
| Y | KR 10-2017-0115778 A (THINKWARE CORPORATION) 18 October 2017 (2017-10-18) See claim 1. | 2-4,10-12 |
| A | WO 2022-076197 A1 (QUALCOMM INCORPORATED) 14 April 2022 (2022-04-14) See paragraphs [0131]-[0146]; and figures 14-15. | 1-16 |
| A | KR 10-2018-0036753 A (BAIDU ONLINE NETWORK TECHNOLOGY (BEIJING) CO., LTD.) 09 April 2018 (2018-04-09) See claims 1-3. | 1-16 |

| ✓ | Further documents are listed in the continuation of Box C. | ✓ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **03 August 2023** | **03 August 2023** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2023/005561** |

**C. DOCUMENTS CONSIDERED TO BE RELEVANT**

| Category* | Citation of document, with indication, where appropriate, of the relevant passages | Relevant to claim No. |
|---|---|---|
| A | KR 10-2020-0096726 A (BAIDU.COM TIMES TECHNOLOGY (BEIJING) CO., LTD.) 13 August 2020 (2020-08-13)<br>See claims 1-5. | 1-16 |

Form PCT/ISA/210 (second sheet) (July 2022)

# EP 4 518 320 A1

| | INTERNATIONAL SEARCH REPORT<br>Information on patent family members | | | International application No.<br>**PCT/KR2023/005561** | |

| Patent document<br>cited in search report | Publication date<br>(day/month/year) | Patent family member(s) | | Publication date<br>(day/month/year) |
|---|---|---|---|---|
| WO 2022-025552 A1 | 03 February 2022 | None | | |
| KR 10-2017-0115778 A | 18 October 2017 | CN 107270916 | A | 20 October 2017 |
| | | CN 107270916 | B | 08 December 2020 |
| | | US 10534091 | B2 | 14 January 2020 |
| | | US 2017-0294026 | A1 | 12 October 2017 |
| WO 2022-076197 A1 | 14 April 2022 | CN 116325749 | A | 23 June 2023 |
| | | CN 116325756 | A | 23 June 2023 |
| | | KR 10-2023-0081704 | A | 07 June 2023 |
| | | KR 10-2023-0081705 | A | 07 June 2023 |
| | | US 2022-0108484 | A1 | 07 April 2022 |
| | | US 2022-0108491 | A1 | 07 April 2022 |
| | | WO 2022-076198 | A1 | 14 April 2022 |
| KR 10-2018-0036753 A | 09 April 2018 | CN 105184852 | A | 23 December 2015 |
| | | CN 105184852 | B | 30 January 2018 |
| | | EP 3321887 | A1 | 16 May 2018 |
| | | EP 3321887 | A4 | 15 August 2018 |
| | | JP 2018-534647 | A | 22 November 2018 |
| | | JP 6561199 | B2 | 14 August 2019 |
| | | KR 10-2062680 | B1 | 06 January 2020 |
| | | US 10430659 | B2 | 01 October 2019 |
| | | US 2018-0225515 | A1 | 09 August 2018 |
| | | WO 2017-020466 | A1 | 09 February 2017 |
| KR 10-2020-0096726 A | 13 August 2020 | CN 111771206 | A | 13 October 2020 |
| | | EP 3710984 | A1 | 23 September 2020 |
| | | EP 3710984 | A4 | 23 September 2020 |
| | | JP 2021-516355 | A | 01 July 2021 |
| | | JP 7127071 | B2 | 29 August 2022 |
| | | KR 10-2334641 | B1 | 03 December 2021 |
| | | US 11468690 | B2 | 11 October 2022 |
| | | US 2021-0350147 | A1 | 11 November 2021 |
| | | WO 2020-154967 | A1 | 06 August 2020 |

Form PCT/ISA/210 (patent family annex) (July 2022)